(19) Europäisches Patentamt / European Patent Office / Office européen des brevets

(11) EP 3 086 549 B1

(12) # EUROPEAN PATENT SPECIFICATION

(45) Date of publication and mention of the grant of the patent:
**24.01.2018 Bulletin 2018/04**

(21) Application number: **16173438.9**

(22) Date of filing: **07.02.2011**

(51) Int Cl.:
***H04N 7/015*** *(2006.01)* ***H04B 7/04*** *(2017.01)*
***H04L 27/26*** *(2006.01)* ***H04L 1/00*** *(2006.01)*
***H04L 5/00*** *(2006.01)* ***H04L 25/03*** *(2006.01)*
***H03M 13/25*** *(2006.01)* ***H03M 13/29*** *(2006.01)*
***H03M 13/00*** *(2006.01)* *H04H 40/18 (2008.01)*
*H04H 60/07 (2008.01)* *H03M 13/11 (2006.01)*
*H03M 13/15 (2006.01)* *H03M 13/09 (2006.01)*

(54) **METHOD AND APPARATUS FOR TRANSMITTING A BROADCAST SIGNAL**

VERAHREN UND VORRICHTUNG ZUM SENDEN EINES RUNDFUNKSIGNALS

PROCÉDÉ ET APPAREIL DE TRANSMISSION D’UN SIGNAL DE DIFFUSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.02.2010 US 302522 P**

(43) Date of publication of application:
**26.10.2016 Bulletin 2016/43**

(62) Document number(s) of the earlier application(s) in accordance with Art. 76 EPC:
**14192293.0 / 2 835 967**
**11740064.8 / 2 536 133**

(73) Proprietor: **LG ELECTRONICS INC.**
**Yeongdeungpo-gu**
**Seoul 07336 (KR)**

(72) Inventors:
- **KO, Woo Suk**
  **137-724 Seoul (KR)**
- **MOON, Sang Chul**
  **137-724 Seoul (KR)**

(74) Representative: **Cabinet Plasseraud**
**66, rue de la Chaussée d’Antin**
**75440 Paris Cedex 09 (FR)**

(56) References cited:
**EP-A1- 2 071 791** **EP-A2- 2 487 901**
**EP-A2- 2 533 526** **US-A1- 2005 068 918**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### [Technical Field]

The present invention relates to a broadcast signal transmitting apparatus for transmitting a broadcast signal, a broadcast receiving apparatus for receiving a broadcast signal, and a method of transmitting and receiving a broadcast signal and, most particularly, to an apparatus and method for transmitting and receiving a mobile broadcast signal.

### [Background Art]

As the time has neared to end (or terminate) the transmission of analog broadcast signals, diverse technologies for transmitting and receiving digital broadcast signals are being researched and developed. Herein, a digital broadcast signal may include high capacity video/audio data as compared to an analog broadcast signal, and, in addition to the video/audio data, the digital broadcast signal may also include diverse additional data.

More specifically, a digital broadcasting system for digital broadcasting may provide HD (High Definition) level images, multiple-channel sound (or audio), and a wide range of additional services. However, a data transmission efficiency for transmitting high capacity data, a robustness of transmitting and receiving network, and flexibility in a network considering mobile receiving equipments are still required to be enhanced.

EP2487901 is prior art for the purposes of Art. 54(3) EPC and discloses methods for transmitting and receiving data using employing MIMO techniques. EP2533526 is prior art for the purposes of Art. 54(3) EPC and discloses methods for transmitting and receiving data using employing MIMO techniques. EP2071791 discloses methods for transmitting and receiving data using a time-frequency slicing technique. US2005/068918 discloses techniques for data transmission using SIMO, MISO and MIMO techniques.

### [Detailed Description of the Invention]

### [Technical Objects]

The invention relates to the embodiment presented with regard to figure 28, with reference to the structures presented in figures 9, 18, 42(a), 42(b), 44, 49, 50, 51 and 52. All other references to "embodiments" are to be understood as examples useful for understanding the invention.

Accordingly, an object of the present invention is to provide a broadcast signal transmitting apparatus that can transmit additional broadcast signals, a method for transmitting additional broadcast signals, by using an RF signal of a conventional broadcasting system without having to ensure any additional frequency.

Another object is to provide a broadcast signal transmitting apparatus that can transmit mobile broadcast signals, a method for transmitting, by using an RF signal of a conventional broadcasting system without having to ensure any additional frequency.

Yet another object of the present invention is to provide a broadcast signal transmitting apparatus and a method for transmitting mobile broadcast signals, that can minimize power consumption of a broadcast signal receiving apparatus, by allowing a PLP to be allocated only to a subband unit narrow frequency domain within a signal frame.

Yet another object of the present invention is to provide a broadcast signal transmitting apparatus and a method for transmitting mobile broadcast signals, that can enhance a channel estimate performance of the broadcast signal receiving apparatus, by inserting a pilot pattern, which is robust within a mobile communication environment in the broadcast signal and by transmitting the broadcast signal having the pilot signal inserted therein.

A further object of the present invention is to provide a broadcast signal transmitting apparatus and a method for transmitting mobile broadcast signals, that can become more robust against a burst fading effect within a mobile fading environment, by additionally allocating a preamble symbol to a signal frame and by transmitting and receiving the additionally allocated preamble symbol.

### [Technical Solutions]

In order to achieve the above-described technical objects of the present invention, according to an aspect of the present invention, a method for transmitting a broadcast signal according to claim 1 is provided. A further aspect is provided in the transmitter of claim 4.

According to an embodiment of the present invention, the signal frame includes at least one or more OFDM symbols, wherein a sum of two pilot signals being transmitted from the $1^{st}$ and $2^{nd}$ transmission antennae is detected from a subcarrier of at least one pilot position within each OFDM symbol, and wherein a difference between two pilot signals being transmitted from the $1^{st}$ and $2^{nd}$ transmission antennae is detected from a subcarrier of at least one other pilot position.

According to another embodiment of the present invention, the signal frame includes at least one or more OFDM symbols, wherein a sum of two pilot signals being transmitted from the 1st and 2nd transmission antennae is detected from a subcarrier of at least one pilot position within each OFDM symbol, and wherein a difference between two pilot signals being transmitted from the 1st and 2nd transmission antennae is detected from a subcarrier of at least one other pilot position.

**[Effects of the Invention]**

When mapping a PLP to a signal frame, power consumption of the receiver may be minimized, by mapping the PLP to a subband unit narrow frequency domain. It may be more effective to apply such embodiment of the present invention to a broadcast transceiver for mobile communication.

By inserting and transmitting a 9th pilot pattern (PP9), and by having the receiver use the received 9th pilot pattern (PP9) to perform channel estimation, the present invention may be capable of responding to fast and frequent channel changes with robustness. Most particularly, it may be more effective to apply the 9th pilot pattern (PP9) according to the present invention to a mobile communication environment. Additionally, the 9th pattern pilot (PP9) is advantageous in that the mobility may be enhanced, while using a network infra of a conventional terrestrial broadcasting system without any modification.

Moreover, by using 2 or more preamble symbols, the present invention is advantageous in that the present invention can be more robust against a burst fading effect in a mobile fading environment, and that the present invention can enhance a signal detection performance.

Furthermore, by using a MIMO system, the present invention may enhance data transmission efficiency, and the present invention may also increase robustness in a broadcast signal transmission and reception.

Accordingly, the present invention may provide a method and apparatus for transmitting and receiving a broadcast signal that can receive a digital broadcast signal without any error, even in a mobile receiving apparatus environment or an in-door environment.

**[Brief Description of the Drawings]**

Fig. 1 illustrates an exemplary super frame structure including an additional broadcast signal frame according to the present invention.

Fig. 2 illustrates an exemplary structure of a signal frame according to an embodiment of the present invention.

Fig. 3 illustrates a block diagram showing a structure of broadcast signal transmitting apparatus according to the present invention.

Fig. 4 illustrates a block diagram showing an exemplary structure of an input processor according to an embodiment of the present invention.

Fig. 5 illustrates a block diagram showing an exemplary structure of a mode adaptation module of an input processor according to another embodiment of the present invention.

Fig. 6 illustrates an exemplary structure of a stream adaptation module of an input processor according to another embodiment of the present invention.

Fig. 7 illustrates a block diagram showing an exemplary structure of a BICM module according to an embodiment of the present invention.

Fig. 8 illustrates a block diagram showing an exemplary structure of a BICM module according to another embodiment of the present invention.

Fig. 9 illustrates a block diagram showing an exemplary structure of a frame builder according to an embodiment of the present invention.

Fig. 10 illustrates a block diagram showing an exemplary structure of an OFDM generation according to an embodiment of the present invention.

Fig. 11 illustrates a block diagram showing an exemplary structure of a broadcast signal receiving apparatus according to an embodiment of the present invention.

Fig. 12 illustrates a block diagram showing an exemplary structure of an OFDM demodulator according to an embodiment of the present invention.

Fig. 13 illustrates a block diagram showing an exemplary structure of a frame demapper according to an embodiment of the present invention.

Fig. 14 illustrates a block diagram showing an exemplary structure of a BICM decoder according to an embodiment of the present invention.

Fig. 15 illustrates a block diagram showing an exemplary structure of an output processor according to an embodiment of the present invention.

Fig. 16 illustrates a block diagram showing an exemplary structure of an output processor according to another embodiment of the present invention.

Fig. 17 illustrates a block diagram showing an exemplary structure of a MIMO transmitting system according to an embodiment of the present invention.

Fig. 18 illustrates a block diagram showing an exemplary structure of a MIMO receiving system according to an embodiment of the present invention.

Fig. 19 illustrates a data transmitting and receiving respective to an SM type MIMO transmission in a channel environment according to an exemplary embodiment of the present invention.

Fig. 20 illustrates an input signal and a transmission or reception signal performing an MIMO encoding method according to an exemplary embodiment of the present invention.

Fig. 21 illustrates a constellation diagram respective to a case of using a subset of a GC as an MIMO encoding matrix and to a case according to a first embodiment of the present invention.

Fig. 22 illustrates a relationship between a Euclidean distance and a hamming distance in a constellation diagram respective to a case of using a subset of a GC as an MIMO encoding matrix and a constellation diagram respective to a case according to a first embodiment of the present invention.

Fig. 23 illustrates an input signal and a ransmission or reception signal performing an MIMO encoding method according to a second exemplary embodiment of the present invention.

Fig. 24 illustrates an MIMO encoding method according to a third exemplary embodiment of the present invention.

Fig. 25 illustrates an input signal and a transmission or reception signal performing an MIMO encoding method according to the third exemplary embodiment of the present invention.

Fig. 26 illustrates a block diagram showing an exemplary structure of a broadcast signal transmitting apparatus according to another embodiment of the present invention.

Fig. 27 illustrates a block diagram showing an exemplary structure of a broadcast signal receiving apparatus according to another embodiment of the present invention.

Fig. 28 illustrates a block diagram showing an exemplary structure of a broadcast signal transmitting apparatus according to yet another embodiment of the present invention.

Fig. 29 illustrates a block diagram showing an exemplary structure of a broadcast signal receiving apparatus according to yet another embodiment of the present invention.

Fig. 30 illustrates a MIMO transmission system using an SVC and a broadcast signal transmitting method according to an embodiment of the present invention.

Fig. 31 illustrates a MIMO transmission system using an SVC and a broadcast signal transmitting method according to another embodiment of the present invention.

Fig. 32 illustrates a MIMO transmission system using an SVC and a broadcast signal transmitting method according to yet another embodiment of the present invention.

Fig. 33 to Fig. 35 respectively illustrate exemplary signal frames for data transmission in a base layer and an enhancement layer according to the present invention.

Fig. 36 illustrates a block diagram showing an exemplary structure of a broadcast signal transmitting apparatus according to yet another embodiment of the present invention.

Fig. 37 illustrates a block diagram showing an exemplary structure of a broadcast signal receiving apparatus according to yet another embodiment of the present invention.

(a) to (d) of Fig. 38, Fig. 39, and Fig. 40 illustrate exemplary cell mapping methods according to embodiments of the present invention.

Fig. 41 illustrates a block diagram showing an exemplary structure of a broadcast signal receiving apparatus according to yet another embodiment of the present invention.

(a) of Fig. 42 illustrates an exemplary P1 symbol structure according to the present invention.

(b) of Fig. 42 illustrates a block diagram showing an exemplary structure of a P1 symbol generator according to the present invention.

Fig. 43 illustrates an exemplary super frame structure corresponding to when an additional preamble symbol is included in an additional broadcast signal according to the present invention.

Fig. 44 illustrates a block diagram showing an exemplary structure of an OFDM generator according to yet another embodiment of the present invention.

Fig. 45 illustrates a table showing an exemplary parameter of 9 scattered pilot patterns according to the present invention.

Fig. 46 illustrates examples of scattered pilot patterns that can be used in a corresponding signal frame in accordance with an FFT size and a GI size, among the 9 scattered pilot patterns according to the present invention.

Fig. 47 illustrates an exemplary $9^{th}$ pilot pattern according to an embodiment of the present invention.

Fig. 48 illustrates an exemplary $9^{th}$ pilot pattern according to another embodiment of the present invention.

Fig. 49 illustrates an exemplary structure of a P1 symbol and an exemplary structure of an AP1 symbol according to an embodiment of the present invention.

Fig. 50 illustrates a block diagram showing a structure of an OFDM demodulator according to yet embodiment of the present invention.

Fig. 51 illustrates a block diagram showing an exemplary structure of a P1 symbol detector according to an embodiment of the present invention.

Fig. 52 illustrates a block diagram showing an exemplary structure of an AP1 symbol detector according to an embodiment of the present invention.

Fig. 53 illustrates a flow chart showing the process steps of a method for receiving a broadcast signal according to an embodiment of the present invention.

**[Best Mode for Carrying Out the Present Invention]**

Reference will now be made in detail to the preferred embodiments of the present invention, examples of which are illustrated in the accompanying drawings. Wherever possible, the same reference numbers will be used throughout the drawings to refer to the same or like parts.

Although the terms used in the present invention are selected from generally known and used terms, the detailed meanings of which are described in relevant parts of the description herein. It should be noted that the terms used herein may vary depending upon the intentions or general practice of anyone skilled in the art and also depending upon the advent of a novel technology. Some of the terms mentioned in the description of the present invention have been selected by the applicant at his or her discretion, terms used herein. Furthermore, it is required that the present invention is understood, not simply by the actual terms used but by the meaning of each term lying within.

The present invention relates to an apparatus and method for transmitting and receiving an additional broadcast signal, while sharing an RF frequency band with related art broadcasting system, such as a conventional terrestrial broadcast system (or also referred to as a T2 system), *.g.*, DVB-T2. In the present invention, the additional broadcast signal may correspond to an extension (or enhanced) broadcast signal and/or a mobile broadcast signal.

In the description of the present invention, an additional broadcast signal refers to as signal that is processed and transmitted in accordance with a non-MIMO (Multi Input Multi Output) method or a MIMO method. Herein, a MISO (Multi Input Single Output) method, a SISO (Single Input Single Output) method, and so on, may correspond to the non-MIMO method.

The SISO method uses 1 transmission antenna and 1 reception antenna in order to transmit and receive a broadcast signal.

The MISO method refers to a method that can receive a broadcast signal by using multiple transmission antennae and a single reception antenna without any performance loss. For example, the MISO method uses an Alamouti method. In order to enhance the system performance, a receiving system may receive the same data through multiple reception antennae. However, in the description of the present invention, this case may also be included in the range of the MISO method. Conversely, the SIMO method corresponds to a method using a single transmission antenna and multiple reception antennae.

The MIMO method refers to a method of providing transmission/reception diversity and high transmission efficiency of a broadcast signal by using multiple transmission antennae and multiple reception antennae. More specifically, the MIMO method differently processes a signal with respect to a time dimension and a spatial dimension, so as to transmit multiple data streams through parallel paths operating simultaneously in the same frequency band. Thus, the MIMO method may achieve a diversity effect and a high transmission efficiency.

Hereinafter, 2 antennae may be given as an example of the multi antennae of the MISO method or the MIMO for simplicity of the description of the present invention. And, such description of the present invention may be applied to all types of systems using 2 or more antennae.

Fig. 1 illustrates an exemplary super frame structure including an additional broadcast signal (*.g.*, mobile broadcast signal) according to the present invention. A super frame may be configured of a plurality of frames, and the frames belonging to one super frame may be transmitted by using the same transmission method. The super frame according to the embodiment of the present invention may be configured of multiple T2 frames (also referred to as a terrestrial broadcast frame or a signal frame) and additional non-T2 frames for the additional broadcast signal. Herein, a non-T2 frame may include an FEF (Future Extension Frame) being provided by the related art T2 system. The FEF may not be contiguous and may be inserted in-between the T2 frames. The additional broadcast signal may be included in the T2 frame or FEF, so as to be transmitted.

For the simplicity of the description of the present invention, an FEF part transmitting a mobile broadcast signal will be referred to as an NGH (Next Generation Handheld) frame (or signal frame). At this point, 1 NGH frame may be transmitted for each N number of T2 frames (*i.e.*, NGH-T2 frame ratio = 1/N), and a T2 frame and an NGH frame may also be alternately transmitted (*i.e.*, NGH-T2 frame ratio = 1/2). According to the exemplary embodiment of the present invention, a signal frame (or transmission frame) may indicate any one of a T2 frame, an FEF, and NGH frame, a frame for an extension (or enhancement) broadcast signal.

The NGH frame according to the present invention may be configured of a P1 symbol, at least one or more P2 symbols, and multiple data symbols, as shown in Fig. 1. Herein, the P1 symbol may transmit P1 signaling information, and the P2 symbol may transmit L1 signaling information.

P1 signaling information, which is being carried by the P1 symbol, includes a transmission type and essential transmission parameters. For this, the P1 signaling information includes an S1 field and an S2 field. Herein, the S1 field signals a preamble format. For example, when the S1 field value is equal to 000, the preamble may correspond to a T2 preamble, and it may be indicated that the corresponding are transmitted in the SISO format (T2_SISO). And, when the S1 field value is equal to 001, this may indicate that the corresponding data are transmitted in the MISO format (T2_MISO). And, when the S1 field value is equal to 010, this may indicate that the frame corresponds to a non-T2 frame.

Referring to Fig. 1, each PLP (physical layer pipe) configuring the T2 frame or FEF part may correspond to at least one or more broadcast services, or each PLP may correspond to each component configuring the broadcast service, such as video, extended video, audio, and data stream. Attribute information respective to the FEF part, such as information on the type, length, and interval of the FEF part, may be signaled by using an S2 field of the P1 signaling information. According to the present invention, the PLP corresponds to a data transmission unit. More specifically, one service may be transmitted to one PLP, and multiple service components configuring a single service may be differentiated from one another so as to be respectively transmitted to different PLPs. When multiple service components configuring a single service are be differentiated from one another and respectively transmitted to different PLPs, the separately transmitted service components may then be integrated back to a single service by the receiving end.

Additionally, according to the present invention, a signal path that is to be independently processed will be referred to as a PLP. More specifically, each service may be transmitted and received through multiple RF channels. Herein, the PLP may represent a path through which such service is being transmitted or may represent a stream being transmitted through such path. The PLP may also be located in slots being distributed to multiple RF channels at predetermined time intervals, and the PLP may also be distributed in a single RF channel at predetermined time intervals. Such signal frame may transmit a PLP, which is distributed to a single RF channel based upon a time reference. In other words, one PLP may be distributed to a single RF channel or multiple RF channels based upon a time reference.

Fig. 2 illustrates an exemplary structure of a signal frame over a physical layer according to an embodiment of the present invention. The signal frame includes a P1 signaling part, an L1 signaling part, and a PLP part. More specifically, the P1 signaling part may be allocated to a foremost portion of the corresponding signal frame, and, then, the L1 signaling part and the PLP part may be sequentially allocated after the P1 signaling part. In the description of the present invention, only the information being included in the L1 signaling part may be referred to as L1 signaling information, or signaling information being included in the P1 signaling part and signaling information being included in the L1 signaling part may be collectively referred to as the L1 signaling information.

As shown in Fig. 2, P1 signaling information that is being transmitted to the P1 signaling part may be used for detecting a signal frame and may provide tuning information. Based upon the P1 signaling information, the subsequent L1 signaling part is decoded, so as to acquire information on the PLP structure and the signal frame configuration. More specifically, the L1 signaling information includes P1 signaling information of the P1 signaling part and L1-pre-signaling information and L2-post-signaling information of the L1 signaling part. Herein, the L1-pre-signaling information includes information required by the receiver to receive and decode L1-post-signaling information. And, the L1-post-signaling information includes parameters required by the receiver for accessing the PLP. The L1-post-signaling information may then include Configurable L1-post-signaling information, Dynamic L1-post-signaling information, Extension L1-post-signaling information, and CRC information, and the L1-post-signaling information may further include L1 padding data.

Meanwhile, in the signal frame, the PLP part is configured of at least one common PLP and at least one data PLP. Herein, the common PLP may include network information, such as an NIT (Network Information Table), or PLP information, and service information, such as an SDT (Service Description Table) or an EIT (Event Information Table). The data PLP may include audio, video and data TS streams, and PSI/SI information, such as a PAT (Program Association Table), PMT (Program Map Table), and so on. The data PLP may include a Type1 data PLP being transmitted by one sub-slice for each signal frame and a Type2 data PLP being transmitted by a plurality of sub-slices.

At this point, one data PLP may correspond to one service, or one data PLP may correspond to one of multiple service components configuring a service, .*g*., video (also referred to as video of a base layer), extension video (also referred to as video of an enhancement layer), audio, data component (or stream). In case the data PLP corresponds to a service component instead of a service, the L1-post-signaling information and, most particularly, a PLP_TYPE field within the Configurable L1-post-signaling information may be used to indicate that the PLP in question corresponds to a PLP respective to a service component.

The common PLP may be collectively decoded along with the data PLP, and the data PLP may be optionally (or selectively) decoded. More specifically, a common PLP+data PLP combination can be decoded at all times. However, in some cases, it may be impossible to perform decoding on a data PLP1 + data PLP2 combination. Information configuring the common PLP may include PSI/SI information. Moreover, Auxiliary Data may be additionally added to the signal frame. More specifically, referring to the signal frame on a symbol level, the P1 symbol transmits the P1 signaling information, at least one or more P2 symbols transmit the L1-pre-signaling information, the L1-post-signaling information, and the common PLP. And, data symbols transmit the data PLP.

Fig. 3 illustrates a block diagram showing a structure of broadcast signal transmitting apparatus (also referred to as a broadcast transmitter) according to the present invention.

As shown in Fig. 3, the broadcast signal transmitting apparatus may include an input pre-processor (128000), and input processor (128100), a BICM module (128200), a frame builder (128300), and an OFDM generator (128400).

An input stream may include at least one of an MPEG-TS stream, an Internet Protocol (IP) stream, and a GSE ((General Sream Encapsulation) stream (or also referred to as a GS stream).

The input pre-processor (128000) receives at least one of the MPEG-TS stream, IP stream, and GSE stream and generates at least one or more PLPs in service units (or service component units), so as to add robustness.

The input processor (128100) generates a BB frame including the at least one or more PLPs generated by the input pre-processor (128000). When the input processor (128100) receives a PLP corresponding to a service, the input processor (128100) may separate the received PLP to service-related PLPs and service component-related PLPs, so as to generate the respective BB frame. The BICM module (128200) adds a redundancy to an output of the input processor, so that an error occurring over a transmission channel can be corrected. Thereafter, the BICM module (128200) may perform interleaving. The frame builder (128300) maps multiple PLPs to the transmission frame in cell units, thereby completing the transmission frame structure.

The OFDM generator (128400) performs OFDM modulation on input data, so as to generate a baseband signal that can be transmitted to an antenna.

Fig. 4 illustrates a block diagram showing an exemplary structure of an input processor (128100) according to an embodiment of the present invention.

Herein, Fig. 4 shows an exemplary embodiment of an input processor (128100), wherein the number of input streams is equal to 1. When the number of input streams is equal to 1, the input processor (128100) may include an input interface module (129100), a CRC-8 encoder (129200), a BB header inserter (129300), a padding inserter (129300), and a BB scrambler (129400). In the description of Fig. 4, the input interface module (129100), the CRC-8 encoder (129200), and the BB header inserter (129300) will be collectively referred to as a mode adaptation module, and the padding inserter (129300) and the BB scrambler (129400) will be collectively referred to as a stream adaptation module.

The interface module (129100) slices the input stream to bit units corresponding to a number of bits required for generating a BB (Base Band) frame, so as to generate a BB frame. The CRC-8 encoder (129200) performs CRC encoding on the BB frame, and the BB header inserter (129300) inserts a header having a fixed size to a fore-end portion of the BB frame, which is processed with CRC encoding.

In case a data size of the inputted bit stream is smaller than a BB frame designated to FEC, the padding inserter (128300) may insert a padding bit to the BB frame, in order to configure the BB frame. The BB scrambler (129400) may perform a bitwise XOR (Exclusive OR) operation on a bit stream of the BB frame by using a PRBS (Pseudo Random Binary Sequence), so as to perform randomization.

Fig. 5 illustrates a block diagram showing an exemplary structure of a mode adaptation module of an input processor (128100) respective to a multi PLP input according to another embodiment of the present invention.

The input processor (128100) may include p+1 number of input interface modules (111200-0~p), p+1 number of input stream sync modules (111210-0~p), p+1 number of delay compensators (111220-0~p), p+1 number of null packet deleters (111230-0~p), p+1 number of CRC (Cyclic Redundancy Check) encoders (111240-0~p), and p+1 number of BB header inserters (111250-0~p). Fig. 5 shows an exemplary case when the input stream type corresponds to an MPEG-TS. Accordingly, if the input stream type corresponds to an IP, the delay compensators and the null packet deleters may be omitted from the structure. Furthermore, if the input stream type corresponds to a GSE, the delay compensators, the null packet deleters, and the CRC encoders may be omitted from the structure.

The inputted MPEG-TS or IP or GSE streams may be converted to p+1 number of streams that can each be independently processed by the input pre-processor (12800) or input processor (128100). At this point, a stream that is to be independently processed may correspond to a whole (or complete) TS stream including multiple service components, or may also correspond to a minimum unit TS stream including only one service component (*.g.*, video or audio). Similarly, such stream may also correspond to a whole (or complete) GSE stream including multiple service components, or may also correspond to a GSE stream including only one service component. Furthermore, by using the same method, such stream may also correspond to a whole (or complete) IP stream including multiple service components, or may also correspond to an IP stream including only one service component.

At this point, by including information that can be commonly transmitted to multiple PLPs, such as a transport layer signal of an MPEG-TS, in a single PLP, and by transmitting the processed PLP, the transmission efficiency may be increased. As shown in Fig. 5, the PLP-0 performs such function, and, in the description of the present invention, such PLP is referred to as a common PLP. The remaining P number of PLPs excluding the PLP-0, shown in Fig. 5, may be used for performing data transmission. And, in the description of the present invention, such PLP is referred to as a data PLP. Herein, the example given in Fig. 5 is merely exemplary, and, therefore, a plurality of common PLPs, such as PLP-0 of Fig. 5, may be used in the present invention.

The input interface modules (111200-0~p) may slice the input stream of the corresponding PLP to a number of bits required for generating the BB frame (Base Band frame), so as to generate a required BB frame.

When the corresponding receiving unit performs service recovery, the input stream sync modules (11210-0~p) may generate sync timing information based upon all delays that may occur in the respective channels and transmission processed, so that the corresponding service can be recovered to the initial timing. Herein, the sync timing information may correspond to an ISCR (Input Stream Clock Reference) information.

When multiple PLPs exist, the delay compensators (111220-0~p) may compensate the delay difference between each PLP, so that the frame can be efficiently configured. More specifically, based upon the sync timing information generated by the input stream sync modules (111210-0~p), the delay compensators (111220-0~p) may delay each of the PLPs so as to synchronize the PLPs.

In case of a VBR (variable bit rate) service, the null packet deleters (111230-0~p) may delete the inserted null packets, so as to increase the transmission efficiency. At this point, a number of deleted null packets (DNPs) may be inserted in the deleted positions, so as to be transmitted.

The CRC encoders (111240-0~p) performs CRC encoding on the corresponding frame, in order to enhance the transmission reliability of the BB frame, thereby adding CRC data.

The BB header inserters (111250-0~p) inserts a header having a fixed size on a fore-end portion of the corresponding BB frame, so that the format of the data field can be identified. Herein, the header may include diverse information, such as Mode Adaptation Type information indicating whether the stream type the of corresponding stream corresponds to a TS, an IP, or a GS, User Packet Length information, Data Field Length information, User Packet Sync Byte information, and so on.

Fig. 6 illustrates an exemplary structure of a stream adaptation module of an input processor (128100) respective to a multi PLP input according to another embodiment of the present invention.

The stream adaptation module may include a scheduler (110300), p+1 number of frame delayers (130100-0~p), p+1 number of in-band signaling/padding inserters (130200-0~p), and p+1 number of BB scramblers (130300-0~p).

The scheduler (110300) may perform scheduling in order to allocate multiple PLPs to each slot of a transmission frame.

In case the system uses a MIMO method, the scheduler (110300) may include a scheduler for dual polarity MIMO. More specifically, the scheduler (110300) may generate parameters that can be used by a second DEMUX, a cell interleaver, a time interleaver of the BICM module (128200). Herein, examples of such parameters may include parameters related to a polarity path, such as an H-path and a V-path. The frame delayers (130100-0~p) may delay input data by one transmission frame, so that scheduling information respective to a next frame can be transmitted through a current frame, in order to perform in-band signaling.

Among the non-delayed L1 signaling information, the in-band signaling/padding inserters (130200-0~p) insert information being included in a dynamic block, i.e., dynamic L1-post-signaling information, to the data being delayed by one transmission frame. In this case, if surplus space exists within the input data, a padding bit may be inserted in the surplus space, or in-band signaling information may be inserted in the surplus space.

Each of the BB scramblers (130300-0~p) randomizes each input bit sequence in order to minimize the correlation between the transmission bit sequences.

Moreover, in addition to the in-band signaling, the scheduler (110300) may transmit dynamic L1-post-signaling information of a current frame to a cell mapper of the frame builder. Herein, the cell mapper may use the inputted information so as to map the input cells to the transmission frame.

Furthermore, the scheduler (110300) may transmit the L1 signaling information to the BICM module (110200). Herein, the difference between a stream adaptation module respective to the multi PLP input, shown in Fig. 6, and a stream adaptation module respective to a single PLP input, shown in Fig. 4, is that the scheduler (110300), the p+1 number of frame delayers (130100-0~p), the p+1 number of in-band signaling/padding inserters (130200-0~p), and so on are additionally included in the stream adaptation module.

Fig. 7 illustrates a block diagram showing an exemplary structure of a BICM module (128200) of broadcast signal transmitting apparatus according to an embodiment of the present invention.

As shown in Fig. 7, the BICM module (110200), which is configured to encode the data included in the multiple PLPs, may include p+1 number of FEC encoders (131100-0~p), p+1 number of bit interleavers (131200-0~p), p+1 number of first Demuxes (or demultiplexers) (131300-0~p), p+1 number of constellation mappers (131400-0~p), p+1 number of cell interleavers (131600-0~p), and p+1 number of time interleavers (131700-0~p). Herein, the Constellation mapper may also be referred to as a Symbol mapper. And, the first demultiplexer may also be referred to as a Bit to Cell Demux (demultiplexer).

In order to perform a function of a FRFD (Full Rate Full Diversity) code, which corresponds to a MIMO component, the BICM module (110200) may further include p+1 number of second Demuxes (or demultiplexers) (131500-0~p) and p+1 number of constellation rotators/re-mappers (131800-0~p). Herein, the second demux (or demultiplexer) may also be referred to as a Cell to Polarity demux (or demultiplexer) or SM (spatial multiplexer). In case of using the FRFD code, and in case the FRFD code corresponds to a GC (Golden code), which is known as an optimal code of a 2x2 MIMO, it is inevitable for the receiver to perform a decoding process, which requires a high complexity level, such as an ML (Maximum Likelihood) decoding process.

Accordingly, by including the constellation rotators/re-mappers (131800-0~p), the present invention may reduce the decoding complexity level of the receiving unit. A method of transmitting a broadcast signal by using the MIMO method will be described in detail according to an exemplary embodiment of the present invention.

The present invention will hereinafter be described in detail by using an FEC encoder (131100-0), a bit interleaver (131200-0), a first Demux (or demultiplexer) (131300-0), a constellation mapper (131400-0), a second Demux (or demultiplexer) (131500-0), a cell interleaver (131600-0), a time interleaver (131700-0), and a constellation rotator/re-mapper (131800-0). Reference will be made on the detailed description for the description of the remaining blocks.

The FEC encoder (131100-0) adds a redundancy to a bit stream of an input PLP0, so that any error occurring over the transmission channel can be corrected, and the FEC encoder (131100-0) encodes the bit stream at a coding rate, such as 1/4, 1/3, and 2/5. For example, the FEC encoder (131100-0) may use an outer code, such as a BCH (Bose-Chaudhuri-Hocquengham)/LDPC (Low Density Parity Check) code, so as to add a redundancy for performing error correction, thereby performing the encoding process.

The bit interleaver (131200-0) performs interleaving in bit units on the encoded bit stream, and the first Demux (or demultiplexer) (131300-0) controls the robustness of the bits by adjusting the order of the bits configuring a cell and outputs the cell including the corresponding bits. More specifically, the first Demux (131300-0) adjusts the bit output order, so as to distribute and position the dispersion of the data reliability occurring during an LDPC encoding process, when the constellation mapper (131400-0) performs symbol mapper in a later process.

The constellation mapper (131400-0) maps the inputted cells to a constellation. The second Demux (or demultiplexer) (131500-0) divides the cells mapped to the constellation to an H polarity path (later on referred to as an H-path) and a V polarity path (later on referred to as a V-path).

The cell interleaver (131600-0) performs interleaving on cells included in one LDPC block, and the time interleaver (131700-0) performs interleaving in time units on cell being included in multiple LDPC blocks. According to the exemplary embodiment of the present invention, the cell interleaver (131600-0) and the time interleaver (131700-0) perform interleaving only within each polarity path.

The constellation rotator/re-mapper (131800-0) may rotate the constellation respective to the inputted H-path and V-path, and the constellation rotator/re-mapper (131800-0) may use an I/Q of the rotated constellation, so as to remap symbol sequences included in each path to an output constellation. Accordingly, I/Q components of the H-path and the V-path may be intermixed with one another, and so, the same information may be transmitted through each of the H-path and the V-path. Thus, diversity gain may be acquired (or gained). More specifically, each of the output constellations may include all information being included in each polarity path through the second Demux. In the present invention, a full rate and full diversity performance may be acquired through the constellation rotation and the constellation re-mapping.

According to another embodiment of the present invention, a ROT (rotation) Q-delay module may be equipped between the constellation mapper and the cell interleaver. By rotating the constellation respective to the output of the constellation mapper and by delaying a complex number part, the Rot Q-delay module may acquire additional gain.

Fig. 8 illustrates an exemplary structure of a BICM module according to an embodiment of the present invention.

The BICM module of Fig. 8 may include an L1 signaling generator (132100), 2 FEC encoders (132200-0~1), a bit interleaver (132200), a first Demux (or demultiplexer) (132300), and 2 constellation mappers (132400-0~1). The present invention may further be equipped with a time interleaver at a rear-end portion of each of the 2 constellation mappers (132400-0~1). Additionally, the L1 signaling generator (132100) may also be included in an input processor (128100) instead of the BICM module. As shown in Fig. 8, in order to perform the functions of an FRFD code, which corresponds to an MIMO component, the BICM module may further include 2 second Demuxes (or demultiplexers) (132500-0~1) and 2 constellation rotators/re-mappers (132600-0~1). Herein, the first Demux may also be referred to as a Bit to Cell Demux, and the second Demux may also be referred to as a Cell to Polarity Demux or an SM (spatial multiplexer).

The L1 signaling generator (132100) encodes the inputted dynamic L1-post-signaling information and configurable L1-post-signaling information, so as to output L1-pre-siganling information and L1-post-signaling information. Herein, according to the embodiment of the present invention, the dynamic L1-post-signaling information may be received from the scheduler (110300).

The 2 FEC encoders (132200-0~1) performs an FEC encoding procedure, which includes shortening and puncturing processes, on each of the inputted L1-pre-signaling information and the inputted L1-post-signaling information. Herein, the FEC encoding procedure may include BCH encoding and LDPC encoding.

Each of the bit interleaver (132200), the first Demux (or demultiplexer) (132300), the 2 constellation mappers (132400-0~1), the 2 second Demuxes (or demultiplexers) (132500-0~1), and the 2 constellation rotators/re-mappers (132600-0~1) performs the same functions as the blocks shown in Fig. 7. And, therefore, detailed description of the same will be omitted for simplicity.

Fig. 9 illustrates a block diagram showing an exemplary structure of a frame builder (128300) of the broadcast signal transmitting apparatus according to an embodiment of the present invention.

The frame builder (128300) may include a delay compensator (133100), a cell mapper (133200), and a frequency interleaver (133300). The cell mapper (133200) of Fig. 9 may include a common PLP assembler (133200-1), a sub-slice processor (133200-2), a data PLP assembler (133200-3), and a signaling information assembler (133200-4).

In order to perform cell mapping, the delayer compensator (133100) performs time synchronization on the PLPs, which are inputted by compensating for the delay occurring in the signaling information.

The cell mapper (133200) performs an assembly of (or assembles) the inputted common PLP cells, data PLP cells including general data, and cells including the signaling information in an OFDM based array, which is allocated to the transmission frame.

At this point, the cell mapper (133200) may user scheduling information included in the signaling information, so as to perform a function related to the assembly. The cell mapper (133200) may adopt the same cell mapping method on polarity paths, each being different from one another, in accordance with the MIMO method of the present invention. Alternatively, the cell mapper (133200) may also adopt different cell mapping methods. Herein, the adopted cell mapping method may vary depending upon the scheduling information.

More specifically, the common PLP assembler (133200-1) assembles the common PLP cells to the corresponding transmission frame in accordance with the scheduling information. And, the sub-slice processor (133200-2) generates a sub-slice and assembles the generated sub-slice to the signal frame based upon the scheduling information. The data PLP assembler (133200-3) assembles the data PLP cells, which include data, to the signal frame in accordance with the scheduling information. And, the signaling information assembler (133200-4) assembles the cells, which include the signaling information, to the signal frame in accordance with the scheduling information.

The frequency interleaver (133300) interleaves the cells, which are assembled to the signal frame based upon the OFDM symbol, in a frequency domain.

Fig. 10 illustrates a block diagram showing an exemplary structure of an OFDM generator (128400) according to an embodiment of the present invention. Most particularly, Fig. 10 shows an exemplary OFDM generator corresponding to a case when a broadcast signal is transmitted by using any one of the multi antennae transmission methods, such as the MISO or the MIMO.

The OFDM generator (128400) performs OFDM modulation on a signal inputted through a first path (*.g.*, H-path), so as to configure a first transmitter for transmitting the OFDM-modulated signal through a first transmission antenna (Tx1). And, the OFDM generator (128400) performs OFDM modulation on a signal inputted through a second path (*.g.*, V-path), so as to configure a second transmitter for transmitting the OFDM-modulated signal through a second transmission antenna (Tx2).

The OFDM generator (128400) may further include MISO processors (134100-0~1). And, each of the MISO processors (134100-0~1) performs MISO encoding, so that transmission diversity can be gained for the symbols, which are transmitted inputted through each path.

In order to simplify the description of the present invention, detailed description of the present invention will be made on a pilot inserter (134200-0) of the first transmitter, an IFFT module (134300-0), a PAPR reduction module (134400-0), a GI insertion module (134500-0), a P1 insertion module (134600-0), and a DAC (134700-0). And, since the operation of each block included in the second transmitter is identical to the operation of each block included in the first transmitter, the detailed description of the second transmitter will be omitted for simplicity.

The pilot inserter (134200-0) inserts a pilot of a predecided pilot pattern in a respective position within a transmission frame, which is outputted from the frequency interleaver, so that the receiving end can perform transmission channel estimation and time/frequency synchronization. Additionally, in order to reduce the PAPR of the time domain of the OFDM symbol included in the transmission frame, data may not be transmitted to a specific carrier.

The IFFT module (134300-0) performs inverse fast fourier transform (IFFT) transforming a frequency domain signal having a pilot inserted therein to a time domain signal.

The PAPR (Peak-to-Average Power Ratio) reduction module (134400-0) reduces the PAPR of the time domain signals. The PAPR reduction module (134400-0) uses at least one of an ACE (Active Constellation Extension) method or a Tone Reservation method, so as to reduce the PAPR of the OFDM symbol. Additionally, the PAPR reduction module (134400-0) may also feed-back information that is required based upon a PAPR reduction algorithm to the pilot inserter (134200-0).

The GI insertion module (134500-0) inserts a guard interval in the form of a cyclic prefix by copying a last portion of an effective OFDM symbol to a front portion of the respective OFDM symbol.

The P1 insertion module (134600-0) inserts a P1 symbol, which includes a minimum number of parameters required for performing a decoding procedure of the receiver, at a beginning portion of the transmission frame.

The DAC (134700-0) converts a transmission frame, which is configured in a digital format, having the P1 symbol inserted therein, to an analog signal. Thereafter, the analog signal being converted by the DAC (134700-0) is transmitted through the first transmission antenna (Tx1), and the analog signal being converted by the DAC (134700-1) is transmitted through the second transmission antenna (Tx2).

Fig. 11 illustrates a block diagram showing an exemplary structure of a broadcast signal receiving apparatus (also referred to as a broadcast receiver) according to an embodiment of the present invention.

The broadcast signal receiving apparatus according to the present invention may include an OFDM demodulator (138100), a frame demapper (138200), a BICM decoder (138300), and an output processor (138400).

The frame demapper (138200) may also be referred to as a frame parser. According to the embodiment of the present invention, at least one tuner may be included in a fore-end of the OFDM demodulator (138100). In the present invention, the tuner may select only a signal of a desired frequency band among the received signals. Additionally, according to the embodiment of the present invention, the tuner has an FH (Frequency Hopping) function, which enables the tuner to be applied to a TFS system.

The OFDM demodulator (138100) converts time domain signals to frequency domain signals. Herein, the time domain signals correspond to signals being received through multiple reception antennae and then being converted to digital signals. Among the signals being converted to frequency domain signals, the frame demapper (138200) outputs the PLPs designated to required services. The BICM decider (138300) corrects errors that occur due to the transmission channel, and the output processor (138300) performs procedures required for generating an output TS or IP or GS stream.

Fig. 12 illustrates a block diagram showing an exemplary structure of an OFDM demodulator (131800) of the broadcast signal receiving apparatus. According to the embodiment of the present invention, in order to receive a broadcast signal, which is transmitted by using a MIMO or MISO, two reception antennae (Rx1, Rx2) are used.

The OFDM demodulator (138100) of Fig. 12 includes a first receiving unit configured to perform OFDM demodulation on a signal of the H-path, which is received through the first reception antenna (Rx1), and a second receiving unit configured to perform OFDM demodulation on a signal of the V-path, which is received through the second reception antenna (Rx2).

The first receiving unit may include an ADC (139100-0), a P1 symbol detector (139200-0), a time/frequency synchronization unit (139300-0), a GI remover (139400-0), an FFT module (139500-0), a channel estimator (139600-0), and an equalization/MISO decoder (139700-0). And, the second receiving unit may include an ADC (139100-1), a P1 symbol detector (139200-1), a time/frequency synchronization unit (139300-1), a GI remover (139400-1), an FFT module (139500-1), a channel estimator (139600-1), and an equalization/MISO decoder (139700-1). The description of the present invention will be mostly made based upon the blocks included in the first receiving unit. And, since the operations of the blocks included in the second receiving unit are identical to those of the blocks included in the first receiving unit, the detailed description of the same will be omitted for simplicity.

The ADC (139100-0) converts an analog broadcast signal, which is inputted through the H-path, is converted to a digital broadcast signal.

The P1 symbol detector (139200-0) detects a P1 symbol from the digital broadcast signal, and the P1 symbol detector (139200-0) then uses P1 signaling information, which is carried by the P1 symbol, so as to determine the frame structure of the currently received signal.

The time/frequency synchronization unit (139300-0) uses the P1 signaling information so as to perform GI extraction and time synchronization and carrier frequency synchronization.

The GI remover (139400-0) removes the GI from the synchronized signal, and the FFT module (139500-0) converts the GI-removed signal to a frequency domain signal.

The channel estimator (139600-0) uses a pilot signal being inserted in the frequency domain signal, so as to estimate a transmission channel starting from a transmission antenna to a reception antenna. The equalization/MISO decoder (139700-0) uses the estimated channel, so as to compensate for a distortion in the transmission channel and to perform MISO decoding.

Fig. 13 illustrates a block diagram showing an exemplary structure of a frame demapper (138200) of the broadcast signal transmitting apparatus according to an embodiment of the present invention.

According to the embodiment of the present invention, the frame demapper (138200) performs an inverse process of the frame builder (128300) of the broadcast transmitting apparatus according to the present invention.

The frame demapper (138200) may include a frequency deinterleaver (140100) and a cell demapper (140200).

The frequency deinterleaver (140100) performs deinterleaving of a frequency domain respective to signals inputted through the H-path and the V-path. More specifically, the frequency deinterleaver (140100) performs deinterleaving as an inverse process of the frequency interleaver of the transmitting end. At this point, the broadcast signal transmitting apparatus may be equipped with a plurality of frequency deinterleavers, and the plurality of frequency deinterleavers may perform frequency deinterleaving on each MIMO input signal in parallel. The cell demapper (140200) may extract common PLP cells, data PLP cells, and L1 signaling cells from the frequency-interleaved signal. And, when required, the data being distributed and transmitted to multiple sub-slices are merged, so as to configure a single PLP.

Fig. 14 illustrates a block diagram showing an exemplary structure of a BICM decoder (138300) according to an embodiment of the present invention.

According to embodiment of the present invention, the BICM decoder (138300) performs an inverse process of the BICM module included in the broadcast transmitter.

The BICM decoder (138300) uses a data decoder (141100) so as to decode a plurality of PLPs, and the BICM decoder (138300) also uses a signaling information decoder (141200) so as to decode signaling information. According to the embodiment of the present invention, the data decoder (141100) may include a number of constellation demappers, time deinterleavers, cell deinterleavers, first muxes (or multiplexers), second muxes (or multiplexers), bit deinterleavers, and FEC decoders corresponding to the number of inputted PLPs.

For simplicity of the description of the present invention, the detailed description of the BICM decoder according to the present invention will be mostly focused on the constellation demapper, time deinterleaver, cell deinterleaver, first mux (or multiplexer), second mux (or multiplexer), bit deinterleaver, and FEC decoder for performing PLP0 decoding. And, reference will be made to the corresponding detailed description for the description of the blocks that are configured for other PLPs.

The constellation demapper calculates a 2D-LLR (2 Dimensional Log Likelihood Ratio) and divides the original signals to an H-path signal and a V-path signal. The time deinterleaver performs deinterleaving on symbols that are inputted from the time domain and, then, recovers the deinterleaved symbols back to their original (or initial) places (or positions). The cell deinterleaver performs deinterleaving on cells that are included in a single LDPC block and, then, recovers the deinterleaved cells back to their original (or initial) places (or positions). The first mux (or multiplexer) merges the cells, which are divided and inputted with respect to the H-path and the V-path, to a single cell stream, and the second mux (or multiplexer) recovers the bits allocated to a cell back to a bit stream format prior to being allocated.

The bit deinterleaver deinterleaves the inputted bit stream and recovers the bit stream to its initial order, and the FEC decoder receives the bit-deinterleaved bit stream so as to correct any error occurring during the transmission. In this case, according to the present invention, an LDPC decoding and/or a BCH decoding method is used as the decoding method.

Additionally, according to the embodiment of the present invention, the signal information decoding unit (141200) includes a constellation demapper, a first mux (or multiplexer), a second mux (or multiplexer), a bit deinterleaver, and an FEC decoder, in order to perform decoding of the L1-post-signaling information. And, the signal information decoding unit (141200) includes a constellation demapper, a first mux (or multiplexer), and an FEC decoder, in order to perform decoding of the L1-pre-signaling information. Herein, an L1 signaling decoder is equipped to the output end of each FEC decoder. The L1 signaling decoder receives the L1-post-signaling information and the L1-pre-signaling information from each FEC decoder, so as to decode and output dynamic L1-post-signaling information and configurable L1-post-signaling information. According to the embodiment of the present invention, each FEC decoder included in the signaling information decoding unit (141200) performs FEC decoding, after performing de-shortening and de-puncturing. The L1 signaling decoder recovers the L1 signaling information, which includes the L1-pre-signaling information and the L1-post-signaling information, back to its initial format, and outputs the recovered L1 signaling information as the dynamic L1-post-signaling information and the configurable L1-post-signaling information.

Referring to Fig. 14, as a Polarity to Cell mux, the first mux corresponds to a block that is necessary for supporting a dual polarity MIMO method. Herein, the second mux may also be referred to as a Cell to Bit mux.

Fig. 15 illustrates a block diagram showing an exemplary structure of an output processor (138300) of a broadcast signal receiving apparatus according to an embodiment of the present invention.

Fig. 15 shows an example of an output processor (138300) when the number of output streams is equal to 1 (or when the number of PLP inputs is equal to 1). Herein, Fig. 15 shows an example of an output processor (138300) performing an inverse process of an input processor (128100) of the broadcast transmitter according to the embodiment of the present invention.

In case the number of output streams is equal to 1, the output processor (138300) may include a BB descrambler (142100), a padding remover (142200), a CRC-8 decoder (142300), and a BB frame processor (142400).

The BB descrambler (142100) descrambles an inputted bit stream, and, whenever required, the padding remover (142200) removes the inserted padding bit. The CRC-8 decoder (142300) performs CRC decoding on the inputted bit stream. And, after decoding the information included in a BB frame header, the BB frame processor (142400) uses the decoded information so as to recover a TS/IP/GS stream and to output the recovered TS/IP/GS stream.

Fig. 16 illustrates a block diagram showing an exemplary structure of an output processor (138300) of a broadcast signal receiving apparatus according to another embodiment of the present invention.

Fig. 16 shows an example of an output processor (138300) when a plurality of output streams is being used.

In other words, Fig. 16 shows an example of an output processor (138300) receiving a plurality of PLPs. And, the operation of the output processor (138300) is similar to the inverse process of the input processor (110100) included in the broadcast transmitter.

When a plurality of output streams (p+1 number of output streams) is being used, the output processor (138300) may include p+1 number of BB descramblers (143100-0~p), p+1 number of padding removers (143200-0~p), p+1 number of CRC-8 decoders (143300-0~p), p+1 number of BB frame processors (143400-0~p), p+1 number of De-jitter buffers (143500-0~p), p+1 number of null packet inserters (143600-0~p), p-m+1 number of in-band signaling decoders (143700-m~p), a TS clock re-generator (143800), and a TS re-coupler (143900).

Herein, the operations of the BB descramblers (143100-0~p), the padding removers (143200-0~p), the CRC-8 decoders (143300-0~p), and the BB frame processors (143400-0~p) are identical to the operations of the respective blocks shown in Fig. 15. Therefore, reference may be made to Fig. 15 for the description of the corresponding blocks, and detailed description of the same will be omitted herein for simplicity. In the description of Fig. 16, only the portions that are different from the description of Fig. 15 will be provided herein in detail.

The De-jitter buffers (143500-0~p) compensate for delays, which are arbitrarily inserted by a transmitting end, in order to provide a sync between the plurality of PLPs, in accordance with a TTO (time to output parameter).

By referring to a DNP (deleted null packet), the null packet inserters (143600-0~p) insert null packets, which have been removed by the transmitting end. At this point, the TS clock re-generator (143800) may recover a detailed time synchronization of an output packet with reference to an ISCR (Input Stream Time Referce). The TS re-coupler (143900) recovers the common PLPs and the data PLPs, which are recovered as described above, back to the initial TS or IP or GS stream and outputs the recovered PLPs. According to the embodiment of the present invention, the TTO, DNP, and ISCR information are included in all BB frame headers, so as to be transmitted. The in-band signaling decoders (143700-m~p) recovers in-band signaling information being transmitted through data PLPs and outputs the recovered information.

Hereinafter, a MIMO scheme according to diverse embodiments of the present invention, which allows the present invention to transmit and receive broadcast signals by using the MIMO method.

At this point, the modulation scheme may be expressed as an M-QAM (Quadrature Amplitude Modulation) or an N-QAM. More specifically, when M (or N) is equal to 2, the modulation scheme corresponds to a 2-QAM indicating a BPSK (Binary Phase Shift Keying) scheme. And, when M (or N) is equal to 4, the modulation scheme corresponds to a 4-QAM indicating a QPSK (Quadrature Phase Shift Keying) scheme. Additionally, when M (or N) is equal to 16, the modulation scheme indicates a 16-QAM, when M (or N) is equal to 64, the modulation scheme indicates a 64-QAM, and when M (or N) is equal to 256, the modulation scheme indicates a 256-QAM. Herein, M and N represent a number of symbols being used for the modulation process.

For example, M+M QAM MIMO indicates that identical M-QAMs are used as the QAMs for the MIMO encoding procedure and the MIMO decoding procedure.

In another example, M+N QAM MIMO indicates that different M-QAM and N-QAM are used as the QAMs for the MIMO encoding procedure and the MIMO decoding procedure.

Fig. 17 illustrates a block diagram showing an exemplary structure of a broadcast signal transmitting system supporting the MIMO method according to an embodiment of the present invention. Hereinafter, the broadcast signal transmitting system supporting the MIMO method will be used in combination with the MIMO transmitting system or transmitter.

Referring to Fig. 17, the MIMO transmitting system includes an input signal generator (201010), a MIMO encoder (201020), a first transmission antenna (Tx1, 201030), and a second transmission antenna (Tx2, 201040).

Hereinafter, the MIMO encoder (201020) may also be referred to as a MIMO processor. The input signal generator (201010) generates a plurality of input signals that are to be transmitted to a plurality of antennae. More specifically, the signals that are to be transmitted may be distributed as a plurality of input signals, thereby being capable of outputting a first input signal S1 and a second input signal S2 for the MIMO transmission. The MIMO encoder (201020) may perform MIMO encoding on the plurality of input signals (S1 and S2), so as to output a first transmission signal St1 and a second transmission signal St2 for the MIMO transmission. And, each of the outputted transmission signals may be processed with the required signal processing and modulation processes, thereby being transmitted through each of the first transmission antenna (201030) and the second transmission antenna (201040). The MIMO encoder (201020) may perform encoding in symbol units.

As the MIMO encoding method, the present invention may use the SM method, the GC method, and so on. According to another embodiment of the present invention, the present invention proposes a new MIMO encoding method. The MIMO encoder may use the MIMO encoding method, which will hereinafter be described in detail, so as to be capable of performing MIMO encoding on the plurality of input signals. Most particularly, the MIMO encoder (201020) processes the plurality of input signals in accordance with a MIMO matrix, which will hereinafter be proposed, and a parameter value of the MIMO matrix and, then, the MIMO encoder (201020) outputs a plurality of transmission signals.

Although it is not shown in Fig. 17, as an element outputting a plurality of input signals for performing MIMO encoding, the input signal generator (201010) may also function as an element, such as a demultiplexer, a frame builder, and so on, depending upon the transmitting system. Additionally, being included in the MIMO encoder (201020), the MIMO encoder (201020) may generate a plurality of input signals and may, then, perform encoding on the generated input signals. Furthermore, the MIMO encoder (201020) may represent a device configured to perform MIMO encoding or MIMO processing on multiple signals, so as to acquire diversity gain and multiplexing gain of the MIMO transmitting system, and to output the processed signals.

Since the signal processing procedure after the input signal generator (201010) should be performed on multiple input signals, a plurality of devices may be provided in parallel so as to process the signals, or one device being equipped with a memory may sequentially or simultaneously process the signals in parallel.

Fig. 18 illustrates a block diagram showing an exemplary structure of a broadcast signal receiving system supporting the MIMO method according to an embodiment of the present invention. Hereinafter, the broadcast signal receiving system supporting the MIMO method will be used in combination with a MIMO receiving system or receiver.

The MIMO receiving system of Fig. 18 may include a first reception antenna (201050), a second reception antenna (201060), an MIMO decoder (201070), and an output signal generator (201080). Hereinafter, the MIMO decoder (201070) may also be referred to as an ML detector.

The MIMO receiving system of Fig. 18 may use the first reception antenna (Rx1, 201050) and the second reception antenna (Rx2, 201060), so as to receive a first reception signal Sr1 and a second reception signal Sr2. Additionally, the MIMO decoder (201070) processes the first reception signal and the second reception signal, so as to output a first transmission signal and a second output signal. Based upon the MIMO encoding method, which is used by the MIMO encoder, the MIMO decoder (201070) processes the first reception signal and the second reception signal. The MIMO decoder (201070) uses the MIMO matrix, reception signal, and information on the channel environment, which are used by the MIMO encoder in the transmitting system, so as to output the first transmission signal and the second output signal. According to the embodiment of the present invention, when performing ML detection, each of the first transmission signal and the second output signal may include likelihood information on a bit instead of a bit value. And, such first transmission signal and second output signal may be converted to bit values after being processed with FEC decoding.

The MIMO decoder (201070) processes the first reception signal and the second reception signal in accordance with the QAM type of a first input signal and a second input signal, which are processed by the MIMO transmitting system. Since the first reception signal and the second reception signal, which are received by the MIMO receiving system, respectively correspond to the first input signal and the second input signal corresponding to the same QAM type, or each corresponding to a different QAM type, which are processed with MIMO encoding and transmitted accordingly, the MIMO receiving system may determine which QAM type combination the reception signals correspond to, thereby being capable of performing MIMO decoding on the reception signals. Therefore, the MIMO transmitting system may transmit information enabling the system to identify the QAM type of the transmission signal. And, herein, the information for identifying the QAM type of the transmission signal may be included in a preamble portion of the transmission signal.

According to the embodiment of the present invention, information identifying the QAM type of the transmission signal is indicated by using a PLP_MOD field within the configurable L1-post-signaling information. Additionally, when performing MIMO decoding on the reception signal, the MIMO receiving system may refer to the information identifying the QAM type of the transmission signal. Hereinafter, a MIMO encoder and a MIMO encoding method having a low system complexity level, a high data transmission efficiency level, and a high signal recovery performance, in diverse channel environments, according to the embodiment of the present invention will be described in detail.

The SM method corresponds to a method of simultaneously transmitting data, which are to be transmitted, to multiple antennae without performing any separate encoding procedures for the MIMO method. In this case, the receiver may acquire information from the data that are simultaneously received by multiple reception antennae. In case of the SM method, an ML (Maximum Likelihood) decoder, which is used when performing signal recovery in the receiver, is required to determine (or verify) the combination of multiple received signals. Therefore, the SM method is advantageous in that the complexity level is comparatively low. However, the SM method is disadvantageous in that transmission diversity in the transmitting end cannot be expected. Hereinafter, in case of the SM method, the multiple input signals bypass the MIMO encoder, and such bypassing may be expressed as MIMO encoding.

The GC method corresponds to a method of first encoding the data, which are to be transmitted, in accordance with a decided rule (*.g.*, an encoding method using a Golden code) and then transmitting the encoded data to multiple antennae. In case of using 2 antennae, the GC method uses a 2x2 matrix. Thus, transmission diversity may be acquired in the transmitting end. However, since the ML decoder of the receiver is required to determine (or verify) 4 signal combinations, the GC method is disadvantageous in that the complexity level increases.

As compared to the SM method, the GC method is advantageous in that a more robust communication is available due to the acquisition of transmission diversity. However, this comparison is limited only to the cases of using the GC method and the SM method when performing data processing during the data transmission. Accordingly, when transmitting data while using a separate data coding procedure (also referred to as an outer coding procedure), the transmission diversity of the GC method may not be capable of providing additional gain. Most particularly, such phenomenon easily occurs when such outer coding procedure has a large minimum hamming distance. For example, when transmitting data, which are encoded by adding a redundancy for correcting error, by using an LDPC (Low Density Parity Check) code having a large minimum hamming distance, the transmission diversity of the GC method may not provide additional gain as compared to the SM method. And, in such case, it will be more advantageous for the broadcasting system to use the SM method, which has a lower complexity level. Herein, the hamming distance represents a number of non-matching bits between binary codes having the same number of bits.

Accordingly, by using the SM method, which as a low complexity level, and a robust outer code, the present invention seeks to design a more efficient MIMO broadcasting system.

Fig. 19 illustrates a data transmitting and receiving respective to an SM type MIMO transmission in a channel environment according to an exemplary embodiment of the present invention.

The MIMO transmitting system may respectively send a first input signal 1 (S1) and a second input signal 2 (S2) to transmission antenna 1 (Tx1) and transmission antenna 2 (Tx2) by using the SM method. Fig. 19 corresponds to an exemplary embodiment of transmitting a symbol modulated by 4-QAM from the transmitting end.

Reception antennae 1 (Rx1) may receive signals through two paths. And, in the channel environment shown in Fig. 19, a reception signal of reception antenna 1 (Rx1) corresponds to $S1*h_{11} + S2*h_{21}$, and a reception signal of reception antenna 2 (Rx2) corresponds to $S1*h_{12} + S2*h_{22}$. By performing channel estimation, the receiving end may acquire S1 and S2, so as to recover the data.

As a scenario corresponding to when the transmission and reception paths are independent from one another, such environment will hereinafter be referred to as being un-correlated. Conversely, just as in a LOS (Line Of Sight) environment, the correlation between the channels corresponding to transmission and reception paths may be extremely high, and such environment will be referred to as being fully correlated.

In the MIMO, a case when the channels correspond to fully correlated channels corresponds to when each of the parameters of the 2 by 2 matrix indicating the channel of Fig. 19 is equal to 1 ($h_{11}=h_{12}=h_{21}=h_{22}=1$). At this point, the reception antenna 1 and the reception antenna 2 receive the same reception signal (S1+S2). In other words, the reception antenna 1 and the reception antenna 2 receive a single signal, which is equivalent to a total sum of all transmission signals. Eventually, when the signals transmitted from 2 transmission antennae pass through the same channel, and when the corresponding signals are received by 2 reception antennae, the reception signal received by the receiver, *i.e.*, the data added by the channel, may not express both symbols S1 and S2. Referring to Fig. 19, in case of the fully correlated channel environment, the receiver is incapable of receiving a 16-QAM symbol, which corresponds to an added sum of signal S1, which is expressed as a 4-QAM symbol, and signal S2, which is also expressed as a 4-QAM symbol. And, as shown in the right-side drawing, since the receiver is capable of receiving a signal S1+S2, which is expressed as 9 symbols, S1 and S2 cannot be separated and recovered.

Hereinafter, a receiving signal that has passed through a fully correlated channel may be expressed as a signal equivalent to an added sum of all transmission signals transmitted from the MIMO transmitting system. More specifically, in case of using 2 antennae, when a first transmission signal and a second transmission signal are transmitted from the MIMO transmitting system, it will be assumed that the receiving signal, which has passed through the fully correlated channel, corresponds to an signal consisting of the first transmission signal being added to the second transmission signal. And, hereinafter, the MIMO encoding method will be described in detail based upon such assumption.

In this case, even if a receiver is included in a high SNR environment, the receiver is incapable of recovering the signal, which is transmitted via MIMO by using the SM method. In case of a communication system, since it is provided that the communication generally corresponds to a two-way (or bi-directional) communication, such channel status may be notified to the transmitter through a feedback channel between the transmitter and the receiver, so that the transmission method can be changed (or modified). However, in case of a broadcasting system, it may be difficult to perform a two-way (or bi-directional) communication through a feedback channel. And, since a number of receivers that is to be covered for each transmitter becomes higher, and since the area that is to be covered becomes larger, the broadcasting system has difficulty in responding to the diverse changes in the channel environment. Therefore, in such fully correlated channel environment, when using the SM method, the receiver cannot use a corresponding service, and if the coverage of the broadcasting network is not reduced, difficulty may occur is responding to such channel environment, thereby causing an increase in the cost.

Hereinafter, a method for overcoming a case when the correlation between the MIMO channels is equal to 1, i.e., a case of a fully correlated channel environment, will be described in detail.

The present invention seeks to design the MIMO system, so that the MIMO channel can overcome the case of a fully correlated channel environment, and so that a signal passing through the channel and being received can satisfy the conditions listed below.

1) A received signal should be capable of expressing both original signals S1 and S2. In other words, coordinates of a constellation received by the receiver should be capable of uniquely expressing sequences of S1 and S2.

2) A minimum Euclidean distance of the received signal should be increased, so that a symbol error rate can be reduced. Herein, a Euclidean distance refers to a distance between coordinates over a constellation.

3) A hamming distance characteristic of the received signal should be advantageous, so that the bit error rate can be reduced.

In order to meet with the above-described requirements, the present invention proposes a MIMO encoding method using an MIMO encoding matrix, which includes an encoding parameter (also referred to as an encoding coefficient) a, as shown below in Equation 1.

Equation 1

$$\begin{bmatrix} 1 & a \\ a & -1 \end{bmatrix}$$

When an MIMO encoder performs encoding on input signals S1 and S2 by using an MIMO encoding matrix, as shown in Equation 1, the reception signal 1 (Rx1) and the reception signal 2 (Rx2), which are received by reception antenna 1 and reception antenna 2, may be calculated by using Equation 2 shown below. And, most particularly, in case the MIMO channel corresponds to a fully correlated channel, the signals are calculated by using the last line shown in Equation 2.

Equation 2

$$\begin{aligned} Rx_1 &= h_{11}(S1 + aS2) + h_{21}(aS1 - S2) \\ Rx_2 &= h_{12}(S1 + aS2) + h_{22}(aS1 - S2) \end{aligned}, if\ h_{11} = h_{21} = h_{12} = h_{22} = h,$$

$$R = Rx_1 = Rx_2 = h\{(a+1)S1 + (a-1)S2\}$$

First of all, in case the MIMO channel corresponds to an un-correlated channel, the reception signal 1 (Rx1) may be calculated as Rx1 = $h_{11}$(S1+a*S2)+$h_{21}$(a*S1-S2), and the reception signal 2 (Rx2) may be calculated as Rx2 = $h_{12}$(S1+a*S2)+$h_{22}$(a*S1-S2), so that S1 and S2 can have the same power. Accordingly, all of the gain of the MIMO system may be used as in the SM method.

Meanwhile, when the MIMO channel corresponds to a fully correlated channel, the reception signals (R=Rx1=Rx2) may be acquired as R=h{(a+1)S1+(a-1)S2}. Thus, S1 and S2 may be separately acquired. Herein, S1 and S2 may also be designed to have different power levels, and by using such different power levels robustness may be ensured.

In other words, the MIMO encoder may encoder input signals, so that input signals S1 and S2 can have different power levels, in accordance with an encoding parameter (also referred to as an encoding coefficient) a, and so that S1 and S2 can also be received in different distribution formats in a fully correlated channel. For example, by performing an encoding process on S1 and S2, so that S1 and S2 can have different power levels, and by transmitting the encoded S1 and S2 to a constellation having different Euclidean distances due to a normalization process, even when signals go through a fully correlated channel, the receiver may separate (or divide) the input signals and recover the separated signals accordingly.

Based upon a normalization factor, the MIMO encoding matrix of Equation 1 may be expressed as shown below in Equation 3.

Equation 3

$$\frac{1}{\sqrt{1+a^2}}\begin{bmatrix}1 & a\\ a & -1\end{bmatrix}=\begin{bmatrix}\frac{1}{\sqrt{1+a^2}} & \frac{a}{\sqrt{1+a^2}}\\ \frac{a}{\sqrt{1+a^2}} & \frac{-1}{\sqrt{1+a^2}}\end{bmatrix}=\begin{bmatrix}\cos\theta & \sin\theta\\ \sin\theta & -\cos\theta\end{bmatrix}$$

A MIMO encoding method of the MIMO encoder, which uses the MIMO encoding matrix shown in Equation 3, may be considered as a method of rotating input signals by an arbitrary angle (Theta), which can be expresses as an encoding parameter a, so as to divide the signal into a cosine element of the rotated signal and a sine element (or real number element and imaginary (or false) number element) and to assign +/- signs to each of the divided elements, thereby transmitting the processed signal to another antenna. For example, the MIMO encoder may perform encoding so that a cosine element of input signal S1 and a sine element of input signal S2 can be transmitted to one transmission antenna, and that a sine element of input signal S1 and a cosine element, having a - sign added thereto, of input signal S2 can be transmitted to another transmission antenna. A rotation angle may vary depending upon a change in an encoding parameter value a, and power distribution between input signals S1 and S2 may vary depending upon a value and angle of the corresponding parameter. Since the varied power distribution may be expressed as a distance (*i.e.,* Euclidean distance) between symbol coordinates in a constellation. Even if the input signals pass through a fully correlated channel from the receiving end, such encoded input signals may be expressed in the form of a different constellation, so that the input signals can be identified, divided, and recovered.

In other words, since a Euclidean distance between transmission signals varies to a level corresponding to the distribution of the varied power, the transmission signals received by the receiving end may be expressed in the form of distinguishable constellations each having a different Euclidean distance. More specifically, the MIMO encoder may encode input signal S1 and input signal S2 as a signal having another Euclidean distance in accordance with the value a. And, such encoded transmission signals may be received by the receiving end in distinguishable (or identifiable) constellations and may be recovered accordingly.

The MIMO encoding of the input signal, which is performed by using the above-described MIMO encoding matrix, may be expressed as shown below in Equation 4.

Equation 4

$$\begin{bmatrix}X1\\ X2\end{bmatrix}=\frac{1}{\sqrt{1+a^2}}\begin{bmatrix}1 & a\\ a & -1\end{bmatrix}\begin{bmatrix}S1\\ S2\end{bmatrix}$$

In Equation 4, S1 and S2 represent normalized QAM symbols of a constellation, to which input signal S1 and input signal S2 are mapped by a constellation mapper of a MIMO path. And, each of X1 and X2 respectively represents a MIMO-encoded symbol. In other words, the MIMO encoder may apply the matrix, which is shown in Equation 4, to a 1$^{st}$ input signal including symbols corresponding to S1 and to a 2$^{nd}$ input signal including symbols corresponding to S2, so as to transmit a 1$^{st}$ transmission signal including symbols corresponding to X1 and symbols of a transmission signal X2 including symbols corresponding to X2.

The MIMO encoder may perform MIMO encoding on input signals by suing the above-described MIMO encoding matrix, and may also perform encoding by additionally adjusting an encoding parameter value a. More specifically, the consideration and adjustment of an additional data recovery performance of the MIMO transmitting and receiving system may be optimized by adjusting the encoding parameter value a. And, this will hereinafter be described in more detail.

1. First Embodiment: MIMO encoding method of optimizing an encoding parameter value a based upon a Euclidean distance (Fully correlated MIMO channel)

The value a, which corresponds to an encoding parameter, may be calculated by using the above-described MIMO encoding matrix while considering the Euclidean distance. According to the first embodiment of the present invention, a signal that is combined in the receiving end, after passing through a fully correlated MIMO channel, may be given a Euclidean distance, such as a QAM signal. For example, in a MIMO system having 2 transmission and receptions antennae, when a 1st transmission signal St1 corresponds to an M-QAM symbol, and when a 2nd transmission signal St2 corresponds to an N-QAM symbol, the signal S1+S2 that is being combined by the receiving end, after passing through the fully correlated MIMO channel, may correspond to (M*N)-QAM signal. In another example, also in a MIMO system having 2 transmission and receptions antennae, when a 1st transmission signal St1 corresponds to an M-QAM symbol, and when a 2nd transmission signal St2 corresponds to an M-QAM symbol, the signal S1+S2 that is being combined by the receiving end, after passing through the fully correlated MIMO channel, may correspond to (M*M)-QAM signal. Fig. 20 illustrates an input signal and a transmission or reception signal performing an MIMO encoding method according to the first embodiment of the present invention.

According to the embodiment shown in Fig. 20, the input signal S1 may have a constellation (203010) of a 4-QAM symbol, and the input signal S2 may have a constellation (203020) of a 4-QAM symbol. When the input signal S1 and the input signal S2 are MIMO-encoded by using an MIMO encoding matrix, the encoded 1st transmission signal St1 and the encoded 2nd transmission signal St2, which are respectively transmitted from transmission antenna 1 (Tx1) and transmission antenna 2 (Tx2), may become a 16-QAM symbol, and the respective constellations may correspond to constellation (203030) and constellation (203040) shown in Fig. 20.

The first embodiment of the present invention proposes a method of optimizing the value a, so that each symbol included in a symbol constellation (203050) of reception signals, which have passed through the fully correlated channel, can have the same Euclidean distance, as shown in Fig. 20. Referring to Fig. 20, the constellation (203050) of the reception signal corresponds to a constellation having the Euclidean distance adjusted by using a value a, which is shown below in Equation 5.

More specifically, when the MIMO encoder uses the above-described MIMO matrix so as to encode the input signals, the MIMO encoder may calculate or determine the value of the encoding parameter a, so that the Euclidean distance between the reception symbols can be consistent (or equal) in the constellation of the reception signals (i.e., a combined signal of the 1st transmission signal St1 and the 2nd transmission signal St2), which have passed through the fully correlated channel. And, accordingly, the MIMO encoder may perform an encoding process. Such value a may be expressed as Equation 5 shown below, in accordance with a combination of the modulation methods.

Equation 5

$$a = \begin{cases} 3 & \text{, for QPSK + QPSK} \\ \left(4+\sqrt{5}\right)/\left(4-\sqrt{5}\right) & \text{, for QPSK + 16QAM} \\ 0.6 & \text{, for16QAM + 16QAM} \end{cases}$$

In the embodiment of Fig. 20, as a case when the input signals respectively correspond to 4-QAM and 4-QAM, i.e., when the input signals correspond to QPSK+QPSK, the constellation (203050) of a reception symbol corresponds to a case when the MIMO encoding process is performed, wherein the value a is equal to 3. In other words, since the distribution and constellation of a transmission and reception symbol vary depending upon the modulation method of reception signals and the combination of the reception signals, the value a may also be varied in order to optimize the Euclidean distance. Equation 5 shows examples of calculating the value a, which optimizes the Euclidean distance, when the transmission and reception signal corresponds to a combination of 4-QAM and 16-QAM (QPSK+16-QAM), and when the transmission and reception signal corresponds to a combination of 16-QAM and 16-QAM (16-QAM+16-QAM).

In other words, in case of the first embodiment of the present invention, for example, in a signal wherein a 1st input signal of 4-QAM and a 2nd input signal of 4-QAM are MIMO-encoded and combined with outputted 1st transmission signal and 2nd transmission signals, the value a may be determined so that the constellation of the combined signal is identical to the constellation of a 16-QAM signal.

The MIMO encoding method according to the first embodiment of the present invention shows a more excellent SNR performance as compared to when using the GC method or the SM method in the fully correlated MIMO channel. Most particularly, the SNR gain according to the first embodiment of the present invention becomes higher as the coding rate of the outer code increases. Conversely, in case of the SM method, in a coding rate of 2/5 or higher, decoding cannot be performed at all in the fully correlated channel, and, regardless of the SNR, even the service reception cannot be performed. Additionally, the MIMO encoding method according to the first embodiment of the present invention shows the same performance in an un-correlated channel as the SM method, and the performance is more excellent as compared to the other methods.

Therefore, the MIMO encoding method according to the first embodiment of the present invention may provide a better performance by using a system having a lower complexity level as compared to the GC method. And, the MIMO encoding method according to the first embodiment of the present invention may provide a more excellent performance in the fully correlated channel, as compared to when using the SM method having a similar complexity level.

According to another embodiment of the present invention, when performing MIMO encoding, a GC subset may be used as the MIMO encoding matrix. And, in this case, the MIMO encoding matrix may be expressed as shown below in Equation 6.

Equation 6

$$\begin{bmatrix} \alpha & \alpha\theta \\ i\overline{\alpha} & i\overline{\alpha}\overline{\theta} \end{bmatrix} \begin{bmatrix} S1 \\ S2 \end{bmatrix}, \alpha = 1+(1-\theta)i, \overline{\alpha} = 1+(1-\overline{\theta})i, \theta = \frac{1+\sqrt{5}}{2}, \overline{\theta} = \frac{1-\sqrt{5}}{2}$$

In case of using an encoding matrix of Equation 6, the performance is shown to be better than the first embodiment of the present invention.

Fig. 21 illustrates a constellation diagram respective to a case of using a subset of a GC (or GC subset) as an MIMO encoding matrix and to a case according to the first embodiment of the present invention.

Fig. 21 corresponds to a constellation respective to a case when the transmitter uses a MIMO encoding matrix, so as to perform MIMO encoding on a 16-QAM type input signal S1 and a 16-QAM type input signal S2, thereby transmitting the MIMO-encoded input signals through 2 transmission antennae, and to a case when a receiver receives the signals transmitted from the 2 transmission antennae through the fully correlated MIMO channel. Herein, the left side of Fig. 21 corresponds to a reception constellation respective to a case when the GC subset is used, and the right side of Fig. 21 corresponds to a reception constellation respective to a case when the first embodiment of the present invention (SM OPT1) is used.

When the MIMO encoding process using the GC subset performed in the fully correlated MIMO channel is compared with the MIMO encoding process performed according to the first embodiment of the present invention (SM OPT1) in the fully correlated MIMO channel, in case of using the first embodiment of the present invention (SM OPT1), a minimum Euclidean distance within the constellation of the reception signal may be greater than the case of using the GC subset. However, the SNR performance respective to the case of using the GC subset (SM OLDP Golden) is shown to be better than the case of using the first embodiment of the present invention. Accordingly, it may be known that a difference in performance may occur due to factors other than the Euclidean distance, and the reason of the same will hereinafter be described in detail.

Fig. 22 illustrates a relationship between a Euclidean distance and a hamming distance in a constellation diagram respective to a case of using a subset of a GC (or GC subset) as an MIMO encoding matrix and a constellation diagram respective to a case according to the first embodiment of the present invention.

Herein, the left side of Fig. 22 corresponds to a constellation respective to a case when the GC subset is used, and the right side of Fig. 22 corresponds to a constellation respective to a case when the first embodiment of the present invention is used.

The minimum Euclidean distance respective to the case of using the first embodiment of the present invention is greater than the case of using the GC subset. However, the case of using the GC shows a higher SNR performance than the case of using the first embodiment of the present invention. This is due to a relationship between the Euclidean distance and the hamming distance.

For the case of using the first embodiment of the present invention and for the case of using the GC subset, the distribution itself of the hamming distance respective to both cases may be similar to one another. However, neither of the two case may have gray mapping. More specifically, the Euclidean distance within the 4 by 4 16-QAM constellations, which are distributes to 16 regions within the overall constellation may be similar to one another for both cases. However, the Euclidean distance between is larger in the case of using the GC subset, thereby compensating for the difference in performance of the hamming distance.

Due to such characteristics, the minimum Euclidean distance corresponding to the case of using the GC subset is smaller than the minimum Euclidean distance corresponding to the case of using the first embodiment of the present invention. However, the case of using the GC shows a higher BER performance than the case of using the first embodiment of the present invention. Therefore, in the following description of the present invention, a MIMO encoding method having a better SNR performance or a better BER performance will be proposed.

2. Second Embodiment: MIMO encoding method considering gray mapping in addition to a Euclidean distance

The second embodiment of the present invention proposes a MIMO encoding method enabling a reception signal, which has passed through the fully correlated channel in a state when the value a is determined to have a value that can optimize the Euclidean distance, as in the first embodiment of the present invention, to have gray mapping applied thereto.

In the MIMO encoding method according to the second embodiment of the present invention, among the input signals S1 and S2, signs of the real number part and the imaginary number part of input signal S2 may be changed in accordance with the S1 value, so that gray mapping can be performed in the receiving end. The change in the data value included in S2 may be performed by using the method shown below in Equation 7.

More specifically, the MIMO encoder may use the MIMO encoding matrix used in the first embodiment of the present invention and may perform MIMO encoding by changing the sign of the input signal S2 in accordance with the value of S1. In other words, as shown in Equation 7, after deciding the sign of input signal S2 in accordance with the sign of input signal S1, MIMO encoding matrix may be applied to the decided input signal S1 and input signal S2, as described above, so that 1st transmission signal St1 and 2nd transmission signal St2 can be outputted.

Equation 7

$$
\begin{aligned}
& S1 = b_0 b_1 \ldots b_{N-1}, \quad N = \log_2 M, \quad M = \text{QAM size of } S1 \\
& real(S1) = b_0 b_2 .. b_{N-2} \\
& imag(S1) = b_1 b_3 .. b_{N-1} \\
& for\ i = 1 \ldots N-1 \\
& \quad si = sq = 1 \\
& \quad if\ i = index\ of\ real(S1)\ and\ b_i = 1 \\
& \qquad si = -si \\
& \quad if\ i = index\ of\ imag(S1)\ and\ b_i = 1 \\
& \qquad sq = -sq \\
& end\ for \\
& S2 = si \cdot real(S2) + i \cdot sq \cdot imag(S2)
\end{aligned}
$$

Fig. 23 illustrates an input signal and a transmission or reception signal performing an MIMO encoding method according to the second exemplary embodiment of the present invention.

As shown in Equation 7, an XOR operation is performed on each of the bit values allocated to the real number part and the imaginary number part of S1 among the input signal S1 (206010) and the input signal S2 (206020). Then, based upon the result of the XOR operation, the signs respective to the real number part and the imaginary number part of S2 may be decided. Additionally, when transmission signal 1 (206030) and transmission 2 (206040), which respectively correspond to input signal S1 and input signal S2 having the MIMO encoding matrix applied thereto, as described above, are transmitted from transmission antenna 1 and transmission antenna 2, the reception symbols of the reception signal (206050), having passed through the fully correlated channel and being received by the receiver, may have gray mapping. Therefore, as shown in Fig. 23, the hamming distance between neighboring symbols within the constellation may not exceed the value of 2.

Since the (M*N)-QAM signal (or (M*M)-QAM signal) received by the receiving end has a minimum (or uniform) Euclidean distance and gray mapping, in case of the second embodiment of the present invention, the same performance of the SIMO method may also be expected in the fully correlated MIMO channel. However, when the ML decoder decodes the reception signal and acquired S1 and S2, since the S2 value depends upon S1, the complexity level may be increased. And, in an un-correlated MIMO channel, the performance is likely to be degraded due to a correlation between the input signals.

3. Third Embodiment: MIMO encoding method determining an MIMO encoding parameter while considering a hamming distance in addition to a Euclidean distance

The third embodiment of the present invention proposes a method of performing MIMO encoding by determining a value a, so that the overall constellation of the reception signal does not have a minimum Euclidean distance, as in the first embodiment of the present invention, and so that the Euclidean distance can be optimized based upon a hamming distance of the reception signal.

Fig. 24 illustrates an MIMO encoding method according to the third exemplary embodiment of the present invention.

Fig. 24 shows a relationship between a hamming distance in a constellation of the reception signal, which is received through the fully-correlated MIMO channel, and a value of the encoding parameter a of the MIMO encoding matrix. According to the third embodiment of the present invention, in the constellation of the reception signal, since the hamming distance of D_E1 section is smaller than the hamming distance of D_E2 section, the Euclidean distance is adjusted so that the difference in the hamming distance can be compensated by having the D_E1 section maintain a difference in power 2 times the amount (or level) of the D_E2 section. In other words, in order to compensate a difference in the recovery performance respective to a difference in the hamming distance with a difference in the power level, the Euclidean distance is being adjusted.

Referring to Fig. 24, the D_E2 section has a hamming distance corresponding to 2 times the size of the D_E1 section. More specifically, with respect to neighboring symbols, wherein a difference in the number of bits of one symbol is 2 times that of another symbol, a performance degradation respective to a difference in the hamming distance, which may occur during the reception signal recovery, may be compensated by adjusting (i.e., increasing) the Euclidean distance, so that the section having 2 times the hamming distance can be provided with greater power level. First of all, a relative Euclidean distance is determined with respect to a reception signal, shown in Fig. 24, which corresponds to a combination of the 2 transmission signals (St1, St2) both being received by the receiving end. Referring to the above-described Equation 2, it will be apparent that the minimum Euclidean distance of a 16-QAM symbol having a decreasing power level is equal to 2(a-1), and that the minimum Euclidean distance of a 16-QAM symbol having an increasing power level is equal to 2(a+1) (this is because one reception signal is expressed as R = h{(a+1)S1+(a-1)S2}). Referring to Fig. 24, D_E1 corresponds to the Euclidean distance of 16-QAM symbols having decreased power levels. Additionally, it may be known that D_E2 corresponds to 2 times a distance, which is calculated by subtracting a distance, which corresponds to 3/2 of the Euclidean distance of 16-QAM symbols having decreased power levels, from 1/2 of the Euclidean distance of 16-QAM symbols having increased power levels. And, this may be expressed by using Equation 8 shown below.

Equation 8

$$2D_{H_1} = D_{H_2}$$

$$\sqrt{2}D_{E_1} = D_{E_2}$$

$$2\sqrt{2}(a-1) = 2((a+1) - 3(a-1))$$

$$a = \frac{\sqrt{2}+4}{\sqrt{2}+2}$$

In other words, the MIMO encoder uses the above-described MIMO matrix in order to perform MIMO encoding, so that each input signal can be assigned with a different power level, and so that each input signal can have a different Euclidean distance. In this case, according to the third embodiment of the present invention, the MIMO encoder may calculate and determine the value of an encoding parameter a, so that input signals being assigned with different power levels can each have a Euclidean distance, which can compensate for the difference in the hamming distance. Thus, the MIMO encoding process may be performed.

Fig. 25 illustrates an input signal and a transmission or reception signal performing an MIMO encoding method according to the third exemplary embodiment of the present invention.

Referring to Fig. 25, when performing MIMO encoding on input signal S1 (208010) and input signal S2 (208020) according to the third embodiment of the present invention, the constellation of the transmission signals being encoded and transmitted may respectively correspond to transmission signal 1 (208030) and transmission signal 2 (208040). When such transmission signals are outputted from the fully correlated MIMO channel, the constellation of the reception signal being received by the receiver may correspond to reception signal (208050). And, it will be apparent that the Euclidean distance has been adjusted in the reception signal constellation (208050) in accordance with the hamming distance.

The example of the present invention, which has been described above with reference to Fig. 24 and Fig. 25, corresponds to an example of calculating the value a, when the input signal S1 corresponds to 16-QAM, and when the input signal S2 corresponds to 16-QAM. Herein, by using the same principle, the value a of another modulation method may be calculated by using Equation 9 shown below.

Equation 9

$$a=\begin{cases}\sqrt{2}+1 & \text{, for QPSK + QPSK}\\ \left(\sqrt{2}+3+\sqrt{5}\right)/\left(\sqrt{2}+3-\sqrt{5}\right) & \text{, for QPSK + 16QAM}\\ \left(\sqrt{2}+4\right)/\left(\sqrt{2}+2\right) & \text{, for 16QAM + 16QAM}\end{cases}$$

In case of QPSK+16QAM MIMO, it will be assumed that the value proposed above corresponds to when the constellation mapper has performed normalization of the power level to 1, after performing QAM modulation on input signal S1 and input signal S2 by respectively using QPSK and 16QAM. In case the normalization process is not performed, the value a may be corrected accordingly.

Additionally, in addition to the value proposed in the case of QPSK+16QAM MIMO, a value of 4.0 may be used as the value a. In case of QPSK+16QAM MIMO, this is due to the characteristic enabling the combined signal to express both S1 and S2, even in a case of using the SM method in the fully correlated channel. In this case, in order to compensate for the performance in a high coding rate of an outer code, a value proximate to 4.0 may be used instead of the value calculated by using Equation 9.

Based upon the description presented above, when comparing the second embodiment of the present invention with the third embodiment of the present invention, in the fully correlated MIMO channel, the second embodiment of the present invention shows a performance identical to that of the SIMO, thereby causing no loss in the performance. Accordingly, the disadvantages of the MIMO method of the fully correlated MIMO channel may be enhanced. However, according to the second embodiment of the present invention, due to the MIMO encoding process, since the input data S1 and S2 are not independent from one another, the input data S2 may vary in accordance with the input data S1, thereby causing degradation in the performance in an un-related channel. Therefore, the reception of S1 and any decoding error occurring during the reception of S1 may be reflected to S2, thereby causing additional decoding error in S2. In order to resolve such problem, the present invention may use an iterative ML detection process.

The iterative ML detection includes an outer code in an iterative loop. Then, the iterative ML detection process uses a soft posteriori probability value of S1, which is outputted from the outer code, as a priori probability value of the ML detector. Accordingly, by reducing any detection error, any possible application of the detection error of S1 to the S2 detection may be reduced. By using this method, when using the MIMO encoding method according to the second embodiment of the present invention, the fully correlated MIMO channel may show the performance of an SIMO system, and the un-correlated MIMO channel may show the performance of the SM method.

The MIMO encoding process according to the third embodiment of the present invention is devised and designed so that the reception signal being received through the fully correlated MIMO channel can consider both the hamming distance and the Euclidean distance. Accordingly, the third embodiment of the present invention shows an excellent performance in the fully correlated MIMO channel. And, in comparison with the SM method, since the MIMO encoding process according to the third embodiment of the present invention shows no loss in performance in the un-correlated MIMO channel, it is verified that the gain in both the MIMO transmission and the MIMO reception can be used. In this case, since the complexity level of the receiver is similar to the complexity level corresponding to the SM method, the MIMO encoding process according to the third embodiment of the present invention is also advantageous in implementing the receiver of the present invention.

Hereinafter, a broadcast signal transmitting apparatus, which transmits broadcast signals by performing the above-described MIMO encoding or MIMO processing, and a broadcast signal receiving apparatus, which receives broadcast signals processed with MIMO encoding and MIMO processing, will be described in detail.

Fig. 26 illustrates a block diagram showing an exemplary structure of a broadcast signal transmitting apparatus according to another embodiment of the present invention. Hereinafter, the broadcast signal transmitting apparatus will be used in combination with a MIMO transmitting system or transmitter.

The broadcast signal transmitting apparatus of Fig. 26 corresponds to an exemplary broadcast signal transmitting apparatus transmitting broadcast signals via 2 antennae by using the MIMO method. The broadcast signal transmitting apparatus of Fig. 26 may be applied to a case when the modulation method of each input signal is identical to one another. For example, the broadcast signal transmitting apparatus of Fig. 26 may be used when the 2 input signals S1 and S2, which are to be transmitted by using 2 antennae, respectively correspond to QPSK+QPSK and 16-QAM+16-QAM. Hereinafter, the modulation method may be expressed as M-QAM+M-QAM. The inputted data may be processed in stream or PLP units.

The broadcast signal transmitting apparatus of Fig. 26 may include a BICM module (209010), a frame builder (209020), a MIMO encoder (209040), and an OFDM generator (209050). And, the BICM module (209010) may include an FEC encoder (209060), a bit interleaver (209070), a DEMUX (or demultiplexer) (209080), a constellation mapper (209090), and a time interleaver (209100).

The MIMO encoder (209040) may also be referred to as a MIMO processor. According to the embodiment of the present invention, the frame builder (209020) includes a cell mapper and a frequency interleaver. According to another embodiment of the present invention, instead of being included in the frame builder, the frequency interleaver may be provided after the frame builder. The BICM module (209010) may further include an ROT (ROTation) Q-delay module and a cell interleaver between the constellation mapper (209090) and the time interleaver (209080). The ROT Q-delay module may rotate the symbol-mapped constellation along an imaginary number direction, so as to generate a cyclic delay. And, the cell interleaver may disperse the data cells by performing cell unit interleaving, so as to reduce a regularity of the FEC. In the broadcast signal transmitting apparatus, multiple PLPs may be inputted through respective BICM paths. And, Fig. 26 shows an example wherein a single PLP is being inputted to the BICM module (209010), and the broadcast signal transmitting apparatus according to the embodiment of the present invention will be described accordingly. Herein, a plurality of BICM modules may be provided, and each of the separately BICM-processed PLPs may be inputted to the frame builder (209020).

For the description of the operation of each block of the broadcast signal transmitting apparatus of Fig. 26, reference may be made to the description of the operations of each block having the same name shown in Fig. 7 to Fig. 10. And, therefore, a detailed description of the same will be omitted for simplicity. Herein, only the portions different from the description of Fig. 7 to Fig. 10 will be described in detail. Herein, according to the embodiment of the present invention, for the operations that are not described herein, the operations of the blocks, which are described in Fig. 7 to Fig. 10, may be applied without any modification.

The DEMUX (209080) demultiplexes a bit stream received from the bit interleaver (209070) and outputs the demultiplexed bit stream with reference to M-QAM. The constellation mapper (209090) performs M-QAM gray mapping on the bit stream, which is outputted from the DEMUX (209080), so as to output an M-QAM symbol stream. The time interleaver (209100) interleaves the symbol stream in time units, and, most particularly, the time interleaver (209100) performs time-interleaving on the symbols being outputted from one LDPC block or multiple LDPC blocks. Referring to Fig. 26, the signal processing procedure performed by blocks positioned after the constellation mapper may be performed in symbol units.

The frame builder (209020) assembles (or positions) the PLP-unit symbols, which are each outputted after passing through each BICM path, to a signal frame. The frame builder (209020) additionally performs a function of an input signal generator, which corresponds to generating or aligning multiple input signals in order to perform MIMO transmission. At this point, in the broadcast signal transmitting apparatus, the frame builder (209020) may align the symbols, so that different PLPs can avoid being collectively MIMO encoded. In the embodiment shown in Fig. 26, wherein transmission is performed through 2 antennae, the frame builder (209020) may assemble (or position) 2 symbols, each being different from one another, to the same cell position, so as to generate and output 2 input signals. Additionally, when the cell mapper of the frame builder (209020) outputs 2 symbol data (i.e., 2 input signals) being allocated to the same cell position in parallel, the frequency interleaver performs interleaving on the 2 symbol data in the frequency domain by using the same pattern.

The MIMO encoder (209040) performs MIMO encoding on 2 input signals for 2 antennae, i.e., 2 symbol data being outputted from the frequency interleaver. Herein, any one of the MIMO encoding methods according to the first to third embodiments of the present invention may be used as the MIMO encoding method. More specifically, the MIMO encoding process may be performed by using a MIMO encoding matrix including the above-described encoding parameter a. For a detailed description of the same, reference may be made to the above-described MIMO encoding method.

The OFDM generator (209050) may perform OFDM modulation on the MIMO-encoded symbol data and may transmit the OFDM-modulated symbol data. Herein, the OFDM generator (209050) may include a pilot inserter, an IFFT module, a PAPR reduction module, a GI insertion module, a P1 insertion module, and a DAC. Since reference may be made to the description of Fig. 10 for the description of the OFDM generator (209050), a detailed description of the same will be omitted for simplicity.

In addition to the MIMO encoding, the MIMO encoder (209040) may perform MISO processing or may additionally perform SISO processing. According to the embodiment shown in Fig. 26, when the MIMO encoder (209040) performs only the MIMO processing, the broadcast signal transmitting apparatus may use 2 antennae. And, when the MISO processing is additionally performed, the broadcast signal transmitting apparatus may use 4 antennae. When the MIMO encoder (209040) performs SISO processing on all PLPs, the broadcast signal transmitting apparatus 1 antenna to 4 antennae may be arbitrarily used.

Accordingly, the broadcast signal transmitting apparatus uses at least 2 antennae in order to perform MIMO signal reception. And, when the reception signal corresponds to a SISO signal or a MISO signal, the broadcast signal transmitting apparatus may use at least 1 antenna.

Additionally, the number of the frequency interleavers and the OFDM generators (209050), which are provided in parallel, may correspond to the number of input signals being transmitted to multiple antennae by using the MIMO method. And, such operation may be performed in parallel. Alternatively, according to the embodiment of the present invention, one frequency interleaver and one OFDM generator (209050) may be equipped with a memory, so as to be capable of processing the multiple signals in parallel.

Meanwhile, the broadcast signal transmitting apparatus of Fig. 26 may even be applied to a case when the modulation methods of the input signals are different from one another. More specifically, the broadcast signal transmitting apparatus may be used even when the 2 input signals, which are to be transmitted by using 2 antennae, respectively correspond to BPSK+QPSK, QPSK+16-QAM. Hereinafter, this will be expressed as M-QAM+N-QAM. However, in relation with the operations of the demux (or demultiplexer), cases corresponding to QPSK+QPSK, QPSK+16-QAM, 16-QAM+16-QAM will be collectively described in detail.

In this case, the demux (209080) may adjust the bit output order of the bit stream, which is being outputted from the bit interleaver (209070). Herein, this process is carried out in order to perform dispersed positioning of data reliability, which occurs during the LDPC encoding process, when performing symbol mapping. The demux (209080) demultiplexes the bit stream with reference to M-QAM and N-QAM and then outputs the demultiplexed bit stream. The demux (209080) may additionally perform the function of the input signal generator, which generates or positions multiple input signals in order to perform MIMO transmission. The constellation mapper (209090) may perform M-QAM/N-QAM gray mapping on the bit stream, which is outputted from the demux (209080), so as to output an M-QAM symbol stream and an N-QAM symbol stream. At this point, since multiple constellation mappers (209090) are provided, each of the multiple constellation mappers (209090) may perform M-QAM/N-QAM gray mapping, in parallel, on a bit stream being demultiplexed with reference to M-QAM and a bit stream being demultiplexed with reference to N-QAM, so as to output an M-QAM symbol stream and an N-QAM symbol stream.

At this point, the demux (209080) may be differently operated in accordance with the QAM size of each input signal being used for the MIMO transmission. More specifically, in case the combination of the input signals for the MIMO transmission corresponds to QPSK+QPSK or 16-QAM+16-QAM MIMO, a QAM demultiplexer and a 16-QAM demultiplexer may be used. And, in case the combination of the input signals for the MIMO transmission corresponds to QPSK+16-QAM, a 64-QAM demultiplexer may be used. Alternatively, when the combination corresponds to QPSK+QPSK or 16-QAM+16-QAM, a 16-QAM demultiplexer and a 256-QAM demultiplexer may be respectively used. Herein, the M+N-QAM MIMO transmission performs transmission of a number of bits, which is equal to M*N QAM SISO, all at once. Herein, for the portion of the present invention that has not been described, the description of the M-QAM+M-QAM processing may be applied without any modification.

Fig. 27 illustrates a block diagram showing an exemplary structure of a broadcast signal receiving apparatus according to another embodiment of the present invention. Hereinafter, the broadcast signal receiving apparatus will be used in combination with a MIMO receiving system or receiver. The broadcast signal receiving apparatus of Fig. 27 may be applied to a case when the modulation method of each input signal, being received through 2 antennae by using the MIMO method, is identical to one another. For example, the broadcast signal receiving apparatus of Fig. 27 may be used when the 2 input signals are modulated by using QPSK+QPSK, 16-QAM+16-QAM, and so on, and when the modulated signals are transmitted by using 2 antennae. Hereinafter, the modulation method may be expressed as M-QAM+M-QAM.

The broadcast signal receiving apparatus of Fig. 27 includes an OFDM demodulator (209110), a MIMO decoder (209120), a frequency deinterleaver (209130), a frame parser (209140), a time deinterleaver (209150), a mux (209160), a bit deinterleaver (209170), and an FEC decoder (209180). The frequency deinterleaver (209130) and the frame parser (209140) may be collectively referred to as a frame demapper. And, the frame parser may also be referred to as a cell demapper. The time deinterleaver (209150), the mux (209160), the bit deinterleaver (209170), and the FEC decoder collectively perform inverse processes of the BICM module included in the transmitting end, and may hereinafter be collectively referred to as a BICM decoder (209190). The MIMO decoder (209120) may also be referred to as a MIMO ML detector.

For the description of the operation of each block of the broadcast signal receiving apparatus of Fig. 27, reference may be made to the description of the operations of each block having the same name shown in Fig. 11 to Fig. 16. And, therefore, a detailed description of the same will be omitted for simplicity. Herein, only the portions different from the description of Fig. 11 to Fig. 16 will be described in detail. Herein, according to the embodiment of the present invention, for the operations that are not described herein, the operations of the blocks, which are described in Fig. 11 to Fig. 16, may be applied without any modification. More specifically, the description on the operation of the OFDM demodulator shown in Fig. 12 may be directly used without any modification for the description on the operation of the OFDM demodulator (209110).

The MIMO decoder (209120) processes channel information acquired from the OFDM demodulator (209110) and multiple reception symbol data, so as to output multiple output signals. The MIMO decoder (209120) may use Equation 10 shown below.

Equation 10

$$\log\left(\frac{\sum_{s\in S_0} e^{-\frac{1}{2\sigma^2}\sum_{s,h,t}\left|y_{h,t}-H_{h,t}WS_s\right|^2}}{\sum_{s\in S_1} e^{-\frac{1}{2\sigma^2}\sum_{s,h,t}\left|y_{h,t}-H_{h,t}WS_s\right|^2}}\right)$$

In Equation 10, yh,t represents a signal received by the receiver. And, since h represents a receiving channel receiving signals for each reception antenna, yh,t represents a reception signal passing through the corresponding channel at time t. For example, in case of the SM method, the yh,t may represent a signal received during a 1-unit time period. And, in case of the Alamouti coding method, and the GC method, the yh,t may represent a signal received during a 2-unit time period. Hh,t represent information on a channel through which the received signal passes. According to the embodiment of the present invention, h may be expressed as a 2x2 matrix indicating an MIMO channel, and t represents a time unit. W represents one of the many MIMO encoding matrices according to the above-described embodiments of the present invention. And, as a transmitted QAM signal, Ss represents an input signal prior to being processed with MIMO encoding. Herein, the small s corresponds to a unit respective to 2 signals, which are used for the MIMO transmission.

In Equation 10,

$$\|\mathbf{Y}-\mathbf{HWS}\|^2$$

indicates a difference between a received signal vector (since 2 signals are simultaneously received, the signal vector may also be referred to as a vector) and a transmitted signal vector. Accordingly, the MIMO decoder (209120) seeks to find a vector Ss that can minimize the difference between the received signal vector and the transmitted signal vector. Therefore, since the MIMO decoder (209120) is aware of the yh,t, Hh,t, and W values, the MIMO decoder (209120) may use Equation 10, so as to compare a likelihood of the corresponding bit to be equal to 1 (S1) with a likelihood of the corresponding bit to be equal to 0 (S0) in a log domain, so as to acquire an LLR (Log Likelihood Ratio).

As described above, the MIMO decoder (209120) may use Equation 10 in order to use a method of finding a signal most approximate to the transmission signal from the received signal. At this point, since the information acquired from the detection result, which is detected by the MIMO decoder (209120), corresponds to a bit unit probability, the multiple output signals being outputted from the MIMO decoder (209120) correspond to bit-unit data being expressed as LLR (Log Likelihood Ratio). At this point, the MIMO decoder (209120) performs an operation of comparing all combinations of data used for the MIMO encoding with the data that are received by using the channel information, in order to gain the LLR value. Herein, the MIMO decoder (209120) may use an Approximated ML method using only the value most approximate to the data, which are received in order to reduce the complexity level, a Sphere decoding method using only a combination of data within a predetermined proximity to the received signal, and so on. More specifically, referring to Fig. 27, the MIMO decoder (209120) may perform MIMO decoding on 2 reception signals, which are received by using 2 antennae, so as to output multiple output signals S1 and S2, such as the input signals of the transmitting end. At this point, the output signals S1 and S2 that are being outputted may correspond to a bit unit stream. In this case, each of the output signals may correspond to an output signal respective to the QAM type of the input signals of the transmitting end.

Among the equations used in the MIMO decoder (209120), WS and W, which correspond to MIMO encoding matrices, includes all MIMO encoding matrices of the MIMO encoding method proposed as described above. The MIMO transmitting system may transmit information indicating an MIMO encoding matrix used for the MIMO encoding process, and the MIMO receiving system may use such information so as to determine and decode the MIMO encoding matrix. Optionally, the MIMO receiving system may also use a predetermined MIMO encoding matrix.

The frequency deinterleaver (209130) performs a deinterleaving process as an inverse process of the interleaving process performed by the frequency interleaver included in the transmitter with respect to multiple output signals. At this point, as compared to the frequency interleaver of the transmitter, which performs frequency interleaving in symbol units, since the frequency deinterleaver (209130) of the receiver uses LLR bit information, the frequency deinterleaver (209130) re-aligns all sets of the LLR bit information belonging to a single QAM symbol in symbol units and outputs the re-aligned LLR bit information. Herein, a plurality of the frequency deinterleavers (209130) is provided in the broadcast signal receiving apparatus, so that frequency deinterleaving may be performed in parallel on each of the MIMO input signals.

The frame parser (209140) acquires only the data of wanted (or desired) PLPs from the output data of the frequency deinterleaver and outputs the acquired data. Then, the time deinterleaver (209150) performs deinterleaving as an inverse process of the time interleaver, which is included in the transmitter. Herein, since the time deinterleaver (209150) also performs deinterelaving in bit units, unlike in the transmitter, the time deinterleaver (209150) may also re-align the bit streams based upon the LLR bit information and output the re-aligned bit streams. At this point, the frame parser (209140) performs frame parsing on the multiple input signals and re-positions (or re-assembles) the input signals to a single stream, so as to output the single stream. More specifically, the frame parser (209140) performs an inverse process of the input signal generating unit, which is described above with reference to Fig. 27. And, the blocks positioned after the frame parser (209140) in the receiving unit may perform signal processing on a single stream.

The mux (209160) re-aligns the LLR bit information being outputted from the time interleaver (209150), and the bit deinterleaver (209170) performs bit deinterleaving on the output of the mux (209160). The FEC decoder (209180) performs LDPC/BCH decoding on the output of the bit deinterleaver (209170) so as to perform error correction, thereby outputting the bit data of the PLP. A plurality of the above-described frequency interleaver, frequency deinterleaver, OFDM generator, and OFDM demodulator is provided, so that the above-described operations of the corresponding blocks can be performed in parallel on the MIMO transmission and reception signals in accordance with the number of MIMO transmission and reception signals. Furthermore, the plurality of the above-described blocks may also be replaced with a frequency interleaver, a frequency deinterleaver, an OFDM generator, and an OFDM demodulator collectively including a memory that can process multiple sets of data all at the same time, so as to reduce system complexity.

Meanwhile, the broadcast signal receiving apparatus of Fig. 27 may even be applied to a case when the modulation methods of the signals being received through 2 antennae are different from one another. For example, the broadcast signal receiving apparatus may be used even when the 2 input signals of the transmitting end are modulated to QPSK+16-QAM and transmitted through 2 antennae. Hereinafter, this will be expressed as M-QAM+N-QAM.

In this case, the frequency deinterleaver (209130) performs deinterleaving on the multiple output signals as an inverse process of the interleaving procedure, which is performed in the frequency interleaver of the transmitter. At this point, as compared to the frequency interleaver of the transmitter, which performs frequency interleaving in symbol units, since the frequency deinterleaver (209130) of the receiver uses LLR bit information, the frequency deinterleaver (209130) re-aligns the LLR bit data belonging to an M-QAM symbol and the LLR bit data belonging to an N-QAM symbol in symbol units and outputs the re-aligned LLR bit data. Most particularly, since the number of bit data included in the M-QAM symbol of the MIMO input signal and the number of bit data included in the N-QAM symbol of the MIMO input signal may be different from one another, the deinterleaving process should be performed with respect to such difference. This identically applies in the time deinterleaver (209150). The mux (209160) performs an inverse process of the input signal generating unit, which is described in Fig. 17, and the blocks that are positioned after the mux (209160) in the broadcast signal receiving apparatus perform signal processing on a single stream. Herein, for the portion of the present invention that is not described, the description of the M-QAM+M-QAM processing may be directly applied without any modification.

Fig. 28 illustrates a block diagram showing an exemplary structure of a broadcast signal transmitting apparatus according to yet another embodiment of the present invention. The broadcast signal transmitting apparatus of Fig. 28 corresponds to an exemplary broadcast signal transmitting apparatus transmitting broadcast signals via 2 antennae by using the MIMO method.

The broadcast signal transmitting apparatus of Fig. 28 may be applied to a case when the modulation method of each input signal is identical to one another. For example, the broadcast signal transmitting apparatus of Fig. 26 may be used when the 2 input signals, which are to be transmitted by using 2 antennae, respectively correspond to QPSK+QPSK and 16-QAM+16-QAM.

The broadcast signal transmitting apparatus of Fig. 28 may include a BICM module (210010), a frame builder (210020), and an OFDM generator (210040). And, the BICM module (210010) may include an FEC encoder (210050), a bit interleaver (210060), a demux (or demultiplexer) (210070), a constellation mapper (210080), a MIMO encoder (210090), and a time interleaver (210100). According to an embodiment of the present invention, the frame builder (210020) includes a cell mapper and a frequency interleaver. According to another embodiment of the present invention, the frequency interleaver may be provided after the frame builder, instead of being included in the frame builder. The difference between Fig. 28 and Fig. 26 is the position of the MIMO encoder. More specifically, the MIMO encoder (210090) of Fig. 28 is positioned between the constellation mapper (210080) and the time interleaver (210100). And, the MIMO encoder (209040) of Fig. 26 is positioned between the frequency interleaver of the frame builder (209020) and the OFDM generator (209050).

Therefore, the structure and operation of the broadcast signal transmitting apparatus of Fig. 28 are similar to the structure and operation of the broadcast signal transmitting apparatus of Fig. 26. Hereinafter, the description of the structure and operation of the broadcast signal transmitting apparatus of Fig. 28 that are identical to the structure and operation of the broadcast signal transmitting apparatus of Fig. 26 will be omitted for simplicity. And, only the difference between Fig. 28 and Fig. 26 will be described in detail.

More specifically, in Fig. 26, the frame builder outputs the QAM symbols, which are to be processed with MIMO encoding, in parallel, whereas, in Fig. 28, the MIMO encoder (210090) receives the symbols that are outputted from the constellation mapper (210080) and positions the received symbols in parallel. Then, the MIMO encoder (210090) performs MIMO encoding on the data in parallel and outputs the MIMO-encoded data. Herein, the MIMO encoder (210090) performs the functions of the input signal generating unit, so as to generate multiple input signals. Then, the MIMO encoder (210090) performs MIMO encoding on the generated input signals so as to output multiple transmission signals. The MIMO transmission data that are being transmitted in parallel may be processed in parallel and transmitted by multiple time interleavers (210100), frame builders (210020), and OFDM generators (210040) or by a time interleaver (210100), a frame builder (210020), and an OFDM generator (210040), which internally process data in parallel, so as to be transmitted afterwards. In the embodiment using 2 antennae, as shown in Fig. 28, each of the time interleaver (210100), the frame builder (210020), and the OFDM generator (210040) may be provided in pairs, so as to be capable of processing data, which are being outputted from the MIMO encoder (210090).

Any one of the MIMO encoding methods according to the first to third embodiments of the present invention may be used as the MIMO encoding method performed by the MIMO encoder (210090). More specifically, the MIMO encoding process may be performed by using a MIMO encoding matrix including the above-described encoding parameter a. For a detailed description of the same, reference may be made to the above-described MIMO encoding method.

Meanwhile, the broadcast signal transmitting apparatus of Fig. 28 may even be applied to a case when the modulation methods of the input signals are different from one another. For example, the broadcast signal transmitting apparatus may be used even when the 2 input signals, which are to be transmitted by using 2 antennae, correspond to QPSK+16-QAM.

Fig. 29 illustrates a block diagram showing an exemplary structure of a broadcast signal receiving apparatus according to yet another embodiment of the present invention. Hereinafter, the broadcast signal receiving apparatus will be used in combination with a MIMO receiving system or receiver. The broadcast signal receiving apparatus of Fig. 29 may be applied to a case when the modulation method of each input signal, being received through 2 antennae by using the MIMO method, is identical to one another. For example, the broadcast signal receiving apparatus of Fig. 29 may be used when the 2 input signals are modulated by using QPSK+QPSK, 16-QAM+16-QAM, and so on, and when the modulated signals are transmitted by using 2 antennae.

The broadcast signal receiving apparatus of Fig. 29 includes an OFDM demodulator (210110), a frequency deinterleaver (210120), a frame parser (210130), a time deinterleaver (210140), a MIMO decoder (210150), a mux (210160), a bit deinterleaver (210170), and an FEC decoder (210180). The frequency deinterleaver (210120) and the frame parser (210130) may be collectively referred to as a frame demapper. And, the frame parser (210130) may also be referred to as a cell demapper.

The time deinterleaver (210150), the multiplexer (210160), the bit deinterleaver (210170), and the FEC decoder collectively perform inverse processes of the BICM module included in the transmitting end, and may hereinafter be collectively referred to as a BICM decoder (210190). The MIMO decoder (210150) may also be referred to as a MIMO ML detector.

The difference between Fig. 29 and Fig. 27 is the position of the MIMO decoder. More specifically, the MIMO decoder (210150) of Fig. 29 is positioned between the time deinterleaver (210140) and the mux (210160). And, the MIMO decoder (209120) of Fig. 27 is positioned between the OFDM demodulator (209110) and the frame deinterleaver (209130).

Therefore, the structure and operation of the broadcast signal receiving apparatus of Fig. 29 are similar to the structure and operation of the broadcast signal receiving apparatus of Fig. 27. Hereinafter, the description of the structure and operation of the broadcast signal transmitting apparatus of Fig. 29 that are identical to the structure and operation of the broadcast signal receiving apparatus of Fig. 27 will be omitted for simplicity. And, only the difference between Fig. 29 and Fig. 27 will be described in detail.

More specifically, in the broadcast signal receiving apparatus of Fig. 29, the OFDM demodulator (210110), the frequency deinterleaver (210120), the frame parser (210130), and the time deinterleaver (210140) may process a MIMO signal, which is received through multiple antennae, through multiple paths in symbol units. And, the MIMO decoder (210150) converts symbol-unit data to LLR bit data and outputs the converted data. In the embodiment shown in Fig. 29, a plurality of the OFDM demodulators (210110), the frequency deinterleavers (210120), the frame parsers (210130), and the time deinterleavers (210140) may be provided. And, by being equipped with a memory that can perform the above-described parallel processing, the above-described plurality of blocks may be replaced with single blocks. Since the frequency deinterleaver (210120), the frame parser (210130), and the time deinterleaver (210140) can collectively process the symbol-unit data, the complexity or required memory size may be reduced, as compared with the embodiment of Fig. 27, which processes the LLR bit information.

Referring to Fig. 26 to Fig. 29, the frame builder/frame demapper respectively perform the functions of a divider/merger. However, the functions of the divider/merger may also be performed by another device element. For example, in the broadcast signal transmitting apparatus, the demux may perform the function of the divider, and divider may be provided after the demux. And, the broadcast signal receiving apparatus corresponding to the above-described broadcast signal transmitting apparatus may perform the function of the merger in the mux, and the merger may be provided in front of the mux. However, depending upon the positions of the divider/merger, a plurality of elements is provided as many as the number output signals of the divider. And, the corresponding elements, which are provided after the divider, may process output signals in parallel along a number of paths corresponding to the number of output signals of the divider. Alternatively, a plurality of elements is provided as many as the number input signals being inputted to the merger. And, the corresponding elements, which are provided in front of the merger divider, may process input signals in parallel along a number of paths corresponding to the number of input signals of the divider.

Meanwhile, the broadcast signal receiving apparatus of Fig. 29 may also be applied to a case the modulation methods of the input signals are different from one another. For example, the broadcast signal receiving apparatus may be used even when the 2 input signals are modulated to QPSK+16-QAM, and when the modulated input signals are transmitted by using 2 antennae.

Referring to Fig. 26 to Fig. 29, the broadcast signal transmitting apparatus may also transmit information indicating the QAM type of input signals, which are used when performing MIMO encoding. Herein, according to the embodiment of the present invention, the information indicating the QAM type may be signaled to the configurable L1-post-signaling information. More specifically, information indicating the QAM type of 1st input signal and 2nd input signal, which are outputted from the frame builder, may also be signaled to the configurable L1-post-signaling information, so as to be transmitted. According to the embodiment of the present invention, the 1st input signal and the 2nd input signal may either have the same QAM type, or may have different QAM types. In this case, the MIMO decoder of the broadcast signal receiving apparatus may use the information indicating the QAM type of the input signals, which are included in the reception signal, so as to perform MIMO decoding and to output QAM type output signals. However, such QAM type output signals include bit unit data, and such bit unit data correspond to a soft decision value indicating the above-described bit-unit probability (or likelihood). Such soft decision values may then be converted to hard decision values by performing FEC decoding.

Meanwhile, according to the embodiment of the present invention, among the components configuring a broadcast service, video data (or video signals) may be categorized as multiple components and may be transmitted.

According to the embodiment of the present invention, by encoding video data by using the SVC method, the data may be divided into base layer data and enhancement layer data. In the description of the present invention, the base layer data may be used in combination with a base layer video component, and the enhancement layer data may be used in combination with an enhancement layer video component.

The base layer data correspond to data for images having basic picture quality. Herein, although the base layer data are robust against the communication environment, the picture quality of the base layer data is relatively low. And, the enhancement layer data correspond to additional data for images having higher picture quality. And, although the enhancement layer data can provide high picture quality images, the enhancement layer data are more or less resilient to the communication environment.

In the present invention, video data for terrestrial broadcasting may be divided into base layer data and enhancement layer data. And, in order to allow the video data for mobile broadcasting to flexibly respond to the mobile broadcasting communication environment, the video data for mobile broadcasting may be divided into base layer data and enhancement layer data.

The receiver may receive and decode only the base layer video data, so as to acquire images having basic image quality. And, the receiver may also receive and decode both the base layer video data and the enhancement layer video data, so as to acquire images having a higher picture quality. Hereinafter, the definition of the base layer may include video data corresponding to the base layer, and the definition of the enhancement layer may include video data corresponding to the enhancement layer. Additionally, hereinafter, a SVC target may not correspond only to the video data. And, the base layer may be used to indicate data that can provide a basic service including the basic image (or video)/voice (or audio)/data corresponding to the base layer, and the enhancement layer may be used to indicate data that can provide a higher service including higher layer image (or video)/voice (or audio)/data corresponding to the enhancement layer.

According to the embodiment of the present invention, the broadcast signal transmitting apparatus transmits the base layer data by using the SISO or MISO method and transmits the enhancement layer data by using the MIMO method, in order to provide an enhanced throughput. According to another embodiment of the present invention, the broadcast signal transmitting apparatus may transmit both the base layer data and the enhancement layer data. For example, in case of a receiver being equipped with a single antenna, the receiver may receive the base layer data by using the SISO method or the MISO method, so as to acquire images having basic picture quality. And, in case of a receiver being equipped with multiple antennae, the receiver may receive both the base layer data and the enhancement layer data by using the MIMO method, so as to acquire images having higher picture quality.

Fig. 30 illustrates a MIMO transmission system using an SVC and a broadcast signal transmitting method according to an embodiment of the present invention.

As shown in Fig. 30, the MIMO transmitting system may include an SVC encoder (244100), which encodes broadcasting data by using the SVC method, and a MIMO encoder (244200), which distributes data by using a spatial diversity or spatial multiplexing method, so that the data can be transmitted to multiple antennae. Hereinafter, the MIMO encoder may also be referred to as a MIMO processor.

Fig. 30 shows an exemplary broadcast signal transmitting apparatus, which uses a Hierarchical modulation method.

The SVC encoder (244100) performs SVC encoding on the broadcast data and outputs the SVC-encoded data as the base layer data and the enhancement layer data. The base layer data are equally transmitted from a 1st transmission antenna (Tx1; 244300) and a 2nd transmission antenna (Tx2; 244400). And, the enhancement layer data are processed with MIMO encoding by the MIMO encoder (244200), thereby being respectively outputted through the 1st transmission antenna (244300) and the 2nd transmission antenna (244400) as identical data or as different data. In this case, the constellation mapper of the transmitting system perform symbol mapping on the corresponding symbol in accordance with the modulation type, as shown on the left-side drawing. For example, the constellation mapper may perform layer modulation, so as to map bits corresponding to the base layer to an MSB (Most Significant Bit) portion of the corresponding symbol, and to map bits corresponds to the enhancement layer to an LSB (Least Significant Bit) portion of the corresponding symbol.

The receiving system may use a constellation demapper, so as to separate the base layer data and the enhancement layer data from the demodulated bit information and to acquire the separated data. The enhancement layer data may be processed with MIMO decoding, so as to be acquired by using bit information of a final SVC. In case the bit information corresponding to the MIMO cannot be separated, the receiver may use only the bit information corresponding to the SISO or the MISO, so as to acquire the base layer data and to provide the respective service.

Fig. 31 illustrates a MIMO transmission system using an SVC and a broadcast signal transmitting method according to another embodiment of the present invention.

As shown in Fig. 31, the MIMO transmitting system may include an SVC encoder (245100), which encodes broadcasting data by using the SVC method, and a MIMO encoder (245200), which distributes data by using a spatial diversity or spatial multiplexing method, so that the data can be transmitted to multiple antennae. Fig. 31 illustrates an exemplary transmitting system using a hybrid modulation method or an FDM (Frequency Division Multiplexing) method.

The SVC encoder (245100) performs SVC encoding on the broadcast data and outputs the SVC-encoded data as the base layer data and the enhancement layer data. The base layer data are equally transmitted from a 1st transmission antenna (Tx1; 245300) and a 2nd transmission antenna (Tx2; 245400). And, the enhancement layer data are processed with MIMO encoding by the MIMO encoder (245200), thereby being respectively outputted through the 1st transmission antenna (245300) and the 2nd transmission antenna (245400) as identical data or as different data.

At this point, in order to enhance data transmission efficiency, the MIMO transmitting system of Fig. 31 may process data by using the FDM method. Most particularly, by using the OFDM method, the MIMO transmitting system may transmit data through multiple subcarriers. As described above, the transmitting system using the OFDM method may allocate subcarriers as a subcarrier used for transmitting SISO/MISO signals and as a subcarrier used for transmitting an MIMO signal, thereby being capable transmitting each signal. The base layer data being outputted from the SVC encoder (245100) may be equally transmitted from multiple antennae through the SISO/MISO carrier, and the enhancement layer data being processed with MIMO encoding may be transmitted from multiple antennae through the MIMO carrier.

The receiving system receives an OFDM symbol. Then, the receiving system performs SISO/MISO decoding on the data corresponding to the SISO/MISO carrier, so as to acquire the base layer data. And, the receiving system performs MIMO decoding on the data corresponding to the MIMO carrier, so as to acquire the enhancement layer data. Thereafter, based upon the channel status and the receiving system, when the MIMO decoding process cannot be performed, the decoding process may be performed by using only the base layer data. Alternatively, when the MIMO decoding process can be performed, the decoding process may be performed by using both the base layer data and the enhancement layer data. Thus, a corresponding service may be provided. In case of the second embodiment of the present invention, since the MIMO processing may be performed after mapping the bit information of the service to a symbol, the MIMO encoder (245200) may be positioned after the constellation mapper. Accordingly, the structure of the receiving system may be more simplified as compared to the structure of the receiving system shown in Fig. 30.

Fig. 32 illustrates a MIMO transmission system using an SVC and a broadcast signal transmitting method according to yet another embodiment of the present invention.

As shown in Fig. 32, the MIMO transmitting system may include an SVC encoder (246100), which encodes broadcasting data by using the SVC method, and a MIMO encoder (246200), which distributes data by using a spatial diversity or spatial multiplexing method, so that the data can be transmitted to multiple antennae. Fig. 32 illustrates an exemplary transmitting system using a layer PLP method or a TDM method.

In the embodiment shown in Fig. 32, the transmitting system may respectively transmit SVC-encoded base layer data and SVC-encoded enhancement layer data through an SISO/MISO slot and a MIMO slot. This slot may correspond to a time unit slot or a frequency unit slot of the transmission signal. And, in the embodiment shown in Fig. 32, the slot is illustrated as a time unit slot. Furthermore, this slot may also correspond to a PLP.

The receiving system may determine the slot type of the slot that is being received. And, the receiving system may receive base layer data from the SISO/MISO slot, and the receiving system may receive enhancement layer data from the MIMO slot. And, as described above, based upon the channel and the receiving system, when the MIMO decoding process cannot be performed, the decoding process may be performed by using only the base layer data. Alternatively, when the MIMO decoding process can be performed, the decoding process may be performed by using both the base layer data and the enhancement layer data. Thus, a corresponding service may be provided.

According to the embodiment of the present invention, the MIMO encoder (244200, 245200, 246200) of Fig. 30 to Fig. 32 may use at least one of the MIMO encoding methods proposed in the first embodiment to the third embodiment. This is merely exemplary, and, therefore, the MIMO encoding process may also be performed by using the SM method or the GC method.

In the present invention, the base layer data and the enhancement layer data may be transmitted by using one PLP. And, each of the base layer data and the enhancement layer data may be respectively transmitted by using different PLPs.

According to an embodiment of the present invention, the base layer data may be transmitted through a T2 frame (i.e., a terrestrial broadcasting frame), and the enhancement layer data may be transmitted through an FEF part.

According to another embodiment of the present invention, the base layer data and the enhancement layer data may only be transmitted through the FEF part.

In the description of the present invention, the FEF part, which transmits the base layer data and the enhancement layer data, will be referred to as a MIMO broadcasting frame for simplicity. Herein, the MIMO broadcasting frame will be used in combination with a signal frame or a transmission frame.

Also, in the description of the present invention, the base layer data and the enhancement layer data will be collectively referred to as MIMO broadcasting data for simplicity.

Hereinafter, in the following description of the present invention, the MIMO broadcasting data may be generated by any one of the 1st method to 3rd method, which will be described as presented below, thereby being transmitted. Alternatively, the MIMO broadcasting data may also be generated and transmitted by a combination of at least one or more of the 1st method to 3rd method described below.

(1) Method for transmitting MIMO broadcasting data to a specific PLP

In the present invention, a method for including MIMO broadcasting data to a specific PLP and transmitting the specific PLP, after differentiating the specific PLP from a PLP including the terrestrial broadcasting (*.g.*, T2 broadcasting) data may be used. In this case, the specific PLP may be used in order to transmit the MMO broadcasting data. And, at this point, additional information on the specific PLP may be signaled, so as to prevent any malfunction in the conventional receiving system from occurring. Hereinafter, the specific PLP including the MMO broadcasting data may be referred to as a MIMO broadcasting PLP, and the PLP including the terrestrial broadcasting data may be referred to as a terrestrial broadcasting PLP.

Since the conventional terrestrial broadcasting signal receiving apparatus may not be capable of processing the MIMO broadcasting data, additional information for identifying the terrestrial broadcasting PLP and the MIMO broadcasting PLP is required to be signaled. At this point, the signaling of the information for identifying the PLP type may use a reserved field included in the L1 signaling information. For example, in order to identify the PLP type, a PLP_TYPE field of the L1-post-signaling information may be used. At this point, the MIMO broadcasting PLP may be indicated by using any one of the values ranging from 011~111 as the PLP_TYPE field value.

When transmitting the PLP, in order to acquire a more enhanced robustness, a new modulation method and a new coding rate of the error correction code may be used. In this case, in order to identify such modulation method and coding rate of the error correction code, the L1-post-signaling information may be used. According to an embodiment of the present invention, the present invention may use a PLP_COD field of the L1-post-signaling information in order to indicate the coding rate of the MIMO broadcasting PLP. For example, in order to identify the coding rate of the MIMO broadcasting PLP, any one of 110 or 111 may be used as the PLP_COD field value.

Furthermore, according to an embodiment of the present invention, the present invention may use a PLP_MOD field of the L1-post-signaling information in order to indicate a modulation method of the MIMO broadcasting PLP. For example, in order to identify the modulation method of the MIMO broadcasting PLP, any one of values 100 to 111 may be used as the PLP_MOD field value.

At this point, the base layer data and the enhancement layer data configuring the MIMO broadcasting data may be collectively transmitted to a single PLP, or may be separately transmitted to each PLP. For example, when the base layer data are transmitted to the PLP of the base layer, and when the enhancement layer data are transmitted to the PLP of the enhancement layer, the receiving apparatus may use a PLP_PROFILE field, so as to indicate whether the current PLP corresponds to the base layer PLP or to the enhancement layer PLP.

(2) Method for transmitting MIMO broadcasting data to a specific frames

In the present invention, a method for including MIMO broadcasting data to a specific frame and transmitting the specific frame, after differentiating the specific frame from a frame including the conventional terrestrial broadcasting data may be used. In this case, the specific frame may be used in order to transmit the MMO broadcasting data. And, at this point, additional information on the specific frame may be signaled, so as to prevent any malfunction in the conventional receiving system from occurring. Hereinafter, the specific frame including the MMO broadcasting data may be referred to as a MIMO broadcasting frame, and the frame including the terrestrial broadcasting data may be referred to as a terrestrial broadcasting frame. Additionally, in case the specific frame including the MIMO broadcasting frame corresponds to an FEF, the FEF may be referred to as an MIMO broadcasting frame.

The present invention may differentiate the terrestrial broadcasting data from the MIMO broadcasting data in frame units and may transmit the differentiated data accordingly. And, at this point, by identifying a frame by using the L1 signaling information, and by ignoring (or disregarding) the MIMO broadcasting frame, the convention terrestrial broadcasting receiving apparatus may be prevented from malfunctioning.

(3) Method for transmitting a MIMO broadcasting PLP to a terrestrial broadcasting frame and a MIMO broadcasting frame

The present invention may transmit a PLP including the MIMO broadcasting data through a terrestrial broadcasting frame and a MIMO broadcasting frame. For example, the base layer data may be transmitted through the terrestrial broadcasting frame, and the enhancement layer data may be transmitted through the MIMO broadcasting frame. In this case, unlike the above-described embodiments of the present invention, since a MIMO broadcasting PLP also exists in the terrestrial broadcasting frame, a relation between interconnected PLPs existing in the terrestrial broadcasting frame and in the MIMO broadcasting frame, is required to be signaled. In order to do so, the L1 signaling information should also be included in the MIMO broadcasting frame, and the information on the MIMO broadcasting PLP, which exists within the frame, may be transmitted along with the L1 signaling information of the terrestrial broadcasting frame.

Fields respective to the PLP being included in the L1-post-signaling information of each frame may be used for the connection between the MIMO broadcasting PLPs existing in different frames. For example, the receiving system may use at least one of a PLP_ID field, a PLP_TYPE field, a PLP_PAYLOAD_TYPE field, and a PLP_GROUP_ID field, which are included in the L1-post-signaling information, so as to verify the interconnection relation of the MIMO broadcasting PLPs included in different frames. Then, desired MIMO broadcasting PLPs may be consecutively decoded, so as to acquire a service.

The terrestrial broadcasting PLP existing in the conventional terrestrial broadcasting frame (*i.e.*, T2 frame) may be pre-defined by the terrestrial broadcasting system, so as to be transmitted to a supported transmission mode. Also, as described above, the terrestrial broadcasting PLP may be transmitted in a new transmission mode supporting the MIMO system. For example, as described above, a MIMO broadcasting PLP being included in the terrestrial broadcasting frame may be transmitted in a transmission mode of terrestrial broadcasting as a base layer by using the MISO or SISO method, and a MIMO broadcasting PLP being included in the MIMO broadcasting frame may be transmitted as an enhancement layer by using the MIMO method.

Fig. 33 illustrates an exemplary super frame structure according to another embodiment of the present invention. Herein, Fig. 33 shows an example of transmitting a base layer PLP through a terrestrial broadcasting frame and transmitting an enhancement layer PLP through a MIMO broadcasting frame (*i.e.*, FEF part). At this point, a PLP including base layer data may be transmitted by using an SISO method or a MISO method. And, a PLP including enhancement layer data may be transmitted by using an SISO method, a MISO method, or a MIMO method.

Fig. 34 illustrates an exemplary super frame structure according to yet another embodiment of the present invention. Herein, Fig. 34 shows an example of transmitting both a base layer PLP and an enhancement layer PLP through a MIMO broadcasting frame (*i.e.*, FEF part).

At this point, a base layer PLP including base layer data may be transmitted by using an SISO method or a MISO method. And, an enhancement layer PLP including enhancement layer data may be transmitted by using an SISO method, a MISO method, or a MIMO method. As described above, the ratio between the base layer PLP and the enhancement layer PLP within the MIMO broadcasting frame may vary within a range of 0~100%.

Fig. 35 illustrates an exemplary super frame structure according to yet another embodiment of the present invention. Herein, Fig. 35 shows an example of transmitting both base layer data and enhancement layer data through a MIMO broadcasting frame (*i.e.*, FEF part). However, unlike in the example shown in Fig. 34, in the example shown in Fig. 35, the base layer and the enhancement layer are transmitted by being differentiated as carriers, instead of being differentiated as PLPs. More specifically, the data corresponding to the base layer and the data corresponding to the enhancement layer may respectively be allocated to each separate subcarrier, so as to be processed with OFDM modulation, thereby being transmitted.

Fig. 36 illustrates a block diagram showing an exemplary structure of a broadcast signal transmitting apparatus according to yet another embodiment of the present invention.

The broadcast signal transmitting apparatus of Fig. 36 corresponds to an embodiment of the present invention, wherein the base layer data are identified as the base layer PLP, and wherein the enhancement layer data are identified as the enhancement layer PLP. Although it is not shown in Fig. 36, the broadcast signal transmitting apparatus may include an SVC encoder configured to perform SVC encoding on the data, so as to output the SVC encoded data as the base layer data and the enhancement layer data. At this point, according to the embodiment of the present invention, the base layer data are described to be included in PLP1, and the enhancement layer data are described to be included in PLP2.

The broadcast signal transmitting apparatus of Fig. 36 includes a first BICM module (258100) configured to perform BICM processing on a base layer PLP (PLP1), a second BICM module (258200) configured to perform BICM processing on an enhancement layer PLP (PLP2), a frame builder (258300) configured to receive the PLPs processed by the first and second BICM modules (258200) and to build a frame, an MIMO encoder (258400) configured to perform MIMO, MISO, or SISO processing on output data of the frame builder (258300), a first OFDM generator (258500) configured to perform OFDM modulation on a first transmission signal being outputted from the MIMO encoder (258400), and a second OFDM generator (258600) configured to perform OFDM modulation on a second transmission signal being outputted from the MIMO encoder (258400).

The detailed description on the operations of the first BICM module (258100), the second BICM module (258200), the frame builder (258300), the MIMO encoder (258400), the first OFDM generator (258500), and the second OFDM generator (258600), which are included in the broadcast signal transmitting apparatus of Fig. 36, may be identical to the operations of the respective blocks configuring the broadcast signal transmitting apparatus of Fig. 26. Therefore, detailed description of the same will be omitted for simplicity.

In the broadcast signal transmitting apparatus of Fig. 36, the MIMO encoder (258400) may also be positioned between a constellation mapper and a time interleaver within the second BICM module (258200). In this case, the operations of the broadcast signal transmitting apparatus of Fig. 36 may be identical to the description of the operations of the broadcast signal transmitting apparatus of Fig. 28.

Fig. 37 illustrates a block diagram showing an exemplary structure of a broadcast signal receiving apparatus according to yet another embodiment of the present invention.

The broadcast signal receiving apparatus of Fig. 37 corresponds to an embodiment of the present invention, wherein the base layer data and the enhancement layer data are identified as PLPs. Although it is not shown in Fig. 37, the broadcast signal receiving apparatus may include an SVC decoder configured to perform SVC decoding on the base layer data and the enhancement layer data, so as to recover the initial data. At this point, according to the embodiment of the present invention, the base layer data are described to be received by being included in PLP1, and the enhancement layer data are described to be received by being included in PLP2.

The broadcast signal receiving apparatus of Fig. 37 includes OFDM demodulators (259100, 259200) each configured to perform OFDM demodulation on signals received through multiple antennae, a MIMO decoder (259300) configured to perform MIMO decoding on the signals, which are OFDM-demodulated by the OFDM demodulators (259100, 259200), in accordance with the channel characteristics, a frame demapper (259400) configured to output a base layer PLP and an enhancement layer PLP from a signal frame, which includes the MIMO-decoded signal, and BICM decoders (259500, 295600) each configured to perform an inverse process of the BICM module on each PLP being outputted from the frame demapper (259400), so as to correct any error occurring due to the transmission channel.

The detailed description on the operations of the OFDM demodulators (259100, 259200), the MIMO decoder (259300), the frame demapper (259400), and the BICM decoders (259500, 295600), which are included in the broadcast signal receiving apparatus of Fig. 37, may be identical to the operations of the respective blocks configuring the broadcast signal receiving apparatus of Fig. 27. Therefore, detailed description of the same will be omitted for simplicity.

The broadcast signal receiving apparatus of Fig. 37 acquires base layer data from the PLP (PLP1), which is outputted from the first BICM decoder (259500), and acquires enhancement layer data from the PLP (PLP2), which is outputted from the second BICM decoder (259600). Then, the broadcast signal receiving apparatus may perform SVC decoding on the acquired data, so as to provide the respective services. In case the broadcast signal receiving apparatus acquires only the base layer data, the broadcast signal receiving apparatus may decoder the base layer data, so as to provide the basic service. And, in case the broadcast signal receiving apparatus acquires the base layer data and also the enhancement layer data, the broadcast signal receiving apparatus may provide services having high picture quality/sound quality.

Meanwhile, according to an embodiment of the present invention, in case both the base layer data and the enhancement layer data are transmitted by using a single PLP, a mux may be further included in front of the BICM module of the broadcast signal transmitting apparatus of Fig. 36.

More specifically, the base layer data and the enhancement layer data, which are outputted from the SVC encoder, may be included in a single PLP (PLP1) and then inputted to the mux. In this case, the mux may differentiate the base layer data from the enhancement layer data, which are both included in the single PLP (PLP1), so as to respectively output the base layer data and the enhancement layer data to each of the BICM modules (258100, 258200). In this case, the broadcast signal transmitting apparatus is provided with one time interleaver. And, a base layer and an enhancement layer may be combined with one another in the time interleaver, and the time interleaver may perform interleaving while the two layers are intermixed, thereby acquiring time domain diversity. At this point, according to the embodiment of the present invention, data corresponding to the base layer within a PLP may be SISO or MISO processed and transmitted, and data corresponding to the enhancement layer may be MIMO processed and transmitted.

Also, in case the transmitting end uses a single PLP so as to transmit both the base layer data and the enhancement layer data, a frame demapper of the broadcast signal receiving apparatus of Fig. 37 may extract and output a PLP (PLP1) including the base layer data and the enhancement layer data. And, in this case, the broadcast signal receiving apparatus may be equipped with one time deinterleaver. And, the time deinterleaver may deinterleave the PLP (PLP1), so as to divide the base layer data and the enhancement layer data from one another, thereby repositioning each of the divided data sets in the time domain and outputting the repositioned data sets to each stream. BICM decoders (259500, 259600) may respectively process the base layer stream and the enhancement layer stream.

At this point, error corrected base layer data and enhancement layer data, which are outputted from the BICM decoders (259500, 259600) may be SVC decoded, so as to provide a service. In case of acquiring only the base layer data, the base layer data may be decoded so as to provide a basic service. And, in case of acquiring both the base layer data and the enhancement layer data, a service having high picture quality/sound quality may be provided.

In the broadcast signal receiving apparatus of Fig. 37, a MIMO decoder (259300) may be located between the frame demapper (259400) and the BICM decoders (259500 and 259600). In this case, the description of the operations of the broadcast signal receiving apparatus of Fig. 37 may be identical to those of the broadcast signal receiving apparatus of Fig. 29.

Meanwhile, a cell mapper being included in the frame builder of the present invention may receive cells of a common PLP, cells of a data PLP, and cells including signaling information from the BICM modules and may, then, map the received cells to respective signal frames. According to the embodiment of the present invention, the cell mapper maps cells belonging to one or more PLPs to a single signal frame. At this point, the frame builder may correspond to the frame builder included in any one of Fig. 3, Fig. 26, Fig. 28, and Fig. 36.

Most particularly, when the present invention maps the cells of the PLP to a signal frame, the mapping may be performed to a narrow subband unit frequency domain, thereby minimizing the power consumed by the receiver. More specifically, when the receiver is allowed to receive only the narrow frequency domain, being inversely proportional to the bandwidth of the subband, the sampling rate may be reduced. And, accordingly, since the operation frequency that is required for all processing steps starting from the ADC of the receiver can be reduced, the consumed power level of the receiver may eventually be minimized. The present invention may be more effective when applied to a broadcast transmitter/receiver for mobile communication.

Hereinafter, diverse embodiments according to the present invention for mapping a PLP to a signal frame will be described in detail.

According to each embodiment of the present invention, a scheduler of an input processor included in the transmitter may schedule a PLP, which transmits each service (or service component), and a frame builder performs cell mapping, so as to configure a signal frame.

The signal frame according to the present invention include a P1 signaling part, an L1 signaling part, and a PLP part. The PLP part is configured of at least one common PLP and at least one data PLP. In light of an OFDM symbol level, the signal frame may include a P1 symbol, at least one or more P2 symbols, at least one or more data symbols. At this point, the P1 symbol may be located at the beginning of each signal frame and may transmit P1 signaling information. The P2 symbol may be located immediately after the P1 symbol, so as to transmit L1 signaling information, and may also transmit data. Herein, an area including the P1 symbol and the P2 symbol may be referred to as a preamble area or a pilot area. The P2 symbol is included in the common PLP.

(a) to (d) of Fig. 38, Fig. 39, and Fig. 40 illustrate exemplary cell mapping methods according to embodiments of the present invention.

(a) of Fig. 38 illustrates an example of allocating PLP cells to a signal frame according to an embodiment of the present invention. Most particularly, (a) of Fig. 38 shows an example of allocating cells of a PLP to a subband having a constant bandwidth within a specific signal frame. In case of (a) of Fig. 38, a frequency position to each a PLP is allocated (*i.e.*, a subcarrier value) may be identical for all data symbols included in the signal frame. More specifically, in the receiver, a tuning frequency and a tuning bandwidth for receiving the PLP may be identical for all data symbols included in the signal frame. At this point, a bandwidth of the subband may vary depending upon a number of subcarriers included in the subband.

As shown in (a) of Fig. 38, when mapping a PLP to the signal frame, since the bandwidth and frequency required for performing PLP transmission is limited, a maximum power saving effect may be gained. However, according to an embodiment of the present invention, since the scheduling, shown in (a) of Fig. 38, cannot be changed after having the frequency interleaver receive the output of the cell mapper, a final cell mapping process may be performed by a function block located after the frequency interleaver. At this point, the frequency interleaving may be realized within a bandwidth of a subband. And, accordingly, a single signal frame may be provided with a limited frequency interleaving performance.

(b) of Fig. 38 illustrates an example of allocating PLP cells to a signal frame according to another embodiment of the present invention. (b) of Fig. 38 shows an example for acquiring a frequency interleaving performance higher than the example shown in (a) of Fig. 38.

In the example shown in (b) of Fig. 38, although the bandwidth of a subband is consistently maintained, the frequency position, to which a PLP is allocated, is differently scheduled and allocated for each data symbol. Thus, the frequency interleaving effect may be enhanced. More specifically, in the receiver, although the receiver has a fixed tuning bandwidth for receiving the PLP, the tuning frequency may be differently set for each data symbol within a signal frame. Therefore, in case of (b) of Fig. 38, the tuner of the receiver should change the tuning position for each data symbol. Accordingly, the example shown in (b) of Fig. 38 may yield a greater frequency interleaving effect than the example shown in (a) of Fig. 38, yet yield a lower power saving effect than the example shown in (a) of Fig. 38.

(c) of Fig. 38 illustrates an example of allocating PLP cells to a signal frame according to yet another embodiment of the present invention. (c) of Fig. 38 shows an example more enhanced frequency interleaving and power saving effects.

In the example shown in (c) of Fig. 38, each PLP has the same subband bandwidth and frequency position during a single signal frame. However, for each signal frame a frequency position to which the PLP is allocated may differently scheduled and allocated. More specifically, a tuning frequency and tuning bandwidth enabling the receiver to receive the PLP may be identical for each data symbol included in the signal frame. However, the tuning frequency may vary for each signal frame. Therefore, in case of the example shown in (c) of Fig. 38, the tuner of the receiver may perform reception only with respect to a limited bandwidth of a fixed frequency position within a single signal frame, thereby gaining a power saving effect. And, the receiver may also gain a frequency interleaving effect through a frequency position, which may vary for each signal frame. However, the frequency interleaving may be limited within a single signal frame.

(d) of Fig. 38 illustrates an example of allocating PLP cells to a signal frame according to yet another embodiment of the present invention. Although the bandwidth of the subband is consistently maintained, by differently scheduling and allocating the frequency position, to which the PLP is allocated, for each cell unit, the frequency interleaving effect and the power saving effect may both be enhanced. More specifically, although the tuning bandwidth enabling the receiver to receive the PLP is fixed, the tuning frequency may vary for each cell unit.

(d) of Fig. 38 shows an example of 2 PLPs (*i.e.*, PLP1, PLP2) having the same subband bandwidth and being allocated to different frequency positions for each cell unit. One or more PLPs may be allocated to one signal frame.

The cell unit corresponds to a unit according to which the tuner of the receiver can perform reception in a fixed frequency position. One cell unit is configured of one or more data symbols and one or more subcarriers. In the example shown in (d) of Fig. 38, a cell unit is identified as a small rectangular unit within a data symbol section.

Herein, if the length of the cell unit is longer than a guard period, when scheduling is performed so that a PLP can be transmitted for each cell unit pair, there will occur no problem in allocating a single PLP to different frequency positions within a single signal frame. Herein, the guard period corresponds to a specific time period required by a tuner of the receiver to perform frequency hopping, so as to be re-positioned (or to move) to a new tuning position, and to measure the gain of the received signal, so as to perform normal operations.

Therefore, by receiving a limited subband bandwidth in the same frequency position during one cell unit, the receiver may gain the power saving effect, and the receiver may also gain a frequency interleaving effect within a single signal frame through different frequency positions respective to different cell units.

Furthermore, according to the present invention, when using the bandwidth of a limited subband, as shown in (a) of Fig. 38, (c) of Fig. 38, and (d) of Fig. 38, a pilot may be transmitted to each subband edge. Accordingly, when the receiver performs decoding on each PLP, the receiver may use the pilot of each subband, so as to enhance the channel estimation performance.

Fig. 39 illustrates a cell mapping method using a cell unit according to another embodiment of the present invention.

Referring to Fig. 39, N_GP indicates a guard period. Herein, the guard period refers to a time period required by the tuner of the receiver in order to perform a normal decoding process of the reception signal (or received signal) through a re-tuning process. In other words, the guard period corresponds to a specific time period required by a tuner of the receiver to perform frequency hopping, so as to be re-positioned (or to move) to a new tuning position, and to measure the gain of the received signal, so as to perform normal operations. According to the embodiment of the present invention, the guard period (N_GP) information is signaled to the L1 signaling information. According to another embodiment of the present invention, the guard period (N_GP) information may also be signaled to an in-band signaling information, which transmits the PLP information.

At this point, when a cell unit is used so as to perform cell-mapping on each service (or service component), a transmission process performing slicing in both the time domain and the frequency domain within a single signal frame may be performed. Therefore, in this case, the power saving effect may be maximized, and since the PLPs are spread to a broad area to both the time and frequency domains at the same time, a maximum diversity gain may be acquired.

For example, in case of a receiver, which receives a broadcast signal, by using a Single tuner, for all PLPs seeking to gain a power saving effect, the distance between the allocated cell units should be equal to or greater than the guard period (N_GP). This case may correspond to PLP1 and PLP2 of Fig. 39. In conclusion, such PLPs may have limited transmission rates, and the maximum transmission rate that can be logically transmitted may correspond to 1/2 of the maximum transmission rate performed through the entire frame. Conversely, for a service (or service component) requiring a higher transmission rate, the power saving gain should inevitably abandoned, and only the diversity effect may be gained. In this case, the distance between unit cells may be smaller than N_GP. This case may correspond to PLP3 and PLP4 of Fig. 39.

In another example, in case of a receiver, which receives a broadcast signal, by using two or more tuners, the power saving effect and the interleaving effect may always be gained without any limitations respective to the cell mapping process.

In case of the cell mapping method, shown in Fig. 39, the tuning frequency and the tuning bandwidth, which are used by the receiver in order to receive a single PLP, may be identical for each data symbol included in the signal frame.

Fig. 40 illustrates a cell mapping method using a cell unit according to yet another embodiment of the present invention.

Referring to Fig. 40, N_TS represents a distance between cell units over a time domain, wherein the cell units are allocated by using a time slicing method on an arbitrary PLP. N_FS represents a distance between cell units over a frequency domain, wherein the cell units are allocated by using a time slicing method. Herein, the N_TS and the N_FS may each have a different value for each PLP. And, the N_TS and the N_FS may also be maintained to have a fixed value within a single signal frame, and the N_TS and the N_FS may also be changed to a super frame unit having different signal frames or multiple signal frames as a single unit. Furthermore, N_CU represents a total number of cell units available in the frequency domain for a single data symbol (*i.e.,* OFDM symbol).

In case of the cell mapping method, shown in Fig. 40, the tuning bandwidth being used by the receiver in order to receive a single PLP may correspond to a fixed tuning bandwidth within a single signal frame. However, the tuning frequency may be identical to one another in an arbitrary data symbol in accordance with the N_TS, N_FS, and N_CU values. And, the tuning frequency may vary in other data symbols. According to the embodiment of the present invention, information on the time interval (or distance) (N_TS) and the frequency interval (N_FS) between cell units may be signaled to the L1 signaling information. According to another embodiment of the present invention, the guard period (N_GP) information may also be signaled to an in-band signaling information, which transmits the PLP information.

Referring to Fig. 40, each of PLP1 and PLP2 uses a different scheduling method. Additionally, in light of the transmission rate of each service (or service component) and the QoS, when cell mapping is performed on a single signal frame, the cell mapper of the transmitter should prevent cell unit allocation from causing contention between each of the PLPs, when the scheduling process is performed by using the time-frequency slicing method.

Fig. 41 illustrates an exemplary structure of a receiver receiving PLPs and recovering the received PLPs, when PLPs are allocated and transmitted to the signal frame, as described above in the exemplary cell mapping method according to the above-described embodiments of the present invention.

The receiver of Fig. 41 includes a tuner (301010), an OFDM demodulator (301020), a frame demapper (301030), a BICM decoder (301040), and an output processor (301050). The receiver of Fig. 41 may use at least one or more tuners. And, in case the receiver of Fig. 41 uses 2 tuners, the receiver may further include a tuner (30101n). The receiver receives a broadcast signal through one antenna or 2 or more antennae. Additionally, the tuner (301010) may be used in an analog processing end.

More specifically, depending upon a tuning frequency and a tuning bandwidth, which are inputted from a system controller (not shown), the tuner (301010) may perform frequency hopping, so as to receive a broadcast signal including a signal frame. More specifically, the tuner (301010) tunes to a broadcast signal corresponding to a tuning bandwidth, based upon the inputted tuning frequency. The broadcast signal, which is tuned as described above, passes through an automatic gain control process, thereby being outputted to the OFDM demodulator (301020).

The OFDM demodulator (301020) performs OFDM demodulation on the inputted broadcast signal, thereby outputting the OFDM-demodulated broadcast signal to the frame demapper (301030) in signal frame units.

P1 signaling information, which is transmitted to a P1 symbol, is detected by the OFDM demodulator (301020). Herein, the signal frame configuration of the currently received signal may be known (or determined) from the P1 signaling information.

The frame demapper (301030) performs frequency deinterleaving and cell demapping on the demodulated signal frame, which is outputted from the OFDM demodulator (301020), so as to recover each PLP (or a PLP including a service wanted (or desired) by the user), thereby outputting the recovered PLP to the BICM decoder (301040). Herein, the receiver may be equipped with only one BICM decoder (301040), or the receiver may be equipped with multiple BICM decoders respective to a number of PLPs being included in the signal frame.

The BICM decoder (301040) performs an inverse process of the BICM respective to an inputted PLP, so as to correct any error occurring in the transmission channel, thereby outputting the error-corrected PLP to the output processor (301050). The output processor (301050) performs process steps, which are required for generating a TS or IP or GS stream from a corresponding PLP being outputted from the BICM decoder (301040).

Hereinafter, the operations of a tuner (301010) included in the receiver of Fig. 41, when a PLP is mapped to a signal frame and transmitted, as described in the embodiments of the present invention shown in (a) to (d) of Fig. 38, Fig. 39, and Fig. 40, will be described in detail.

As shown in (a) of Fig. 38, in a single signal frame, when a subband bandwidth allocating a PLP is consistently maintained, and when the frequency position, to which a PLP is allocated, is identical for each symbol data, a parameter (*i.e.*, tuning frequency and tuning bandwidth) may be fixed for each PLP. More specifically, the tuning frequency and the tuning bandwidth for receiving the PLP may be identical for each data symbol included in the signal frame. Therefore, once a PLP is selected, the tuner (301010) of Fig. 41 may use a fixed parameter (*i.e.*, tuning frequency and tuning bandwidth), so as to perform the tuning process.

As shown in (b) of Fig. 38, in a single signal frame, and when a subband bandwidth allocating a PLP is consistently maintained, and when the frequency position, to which a PLP is allocated, varies for each symbol data, the tuning bandwidth for receiving the PLP may be differently determined for each data symbol within the signal frame. Therefore, the tuner (301010) of Fig. 41 may perform the tuning process by changing the tuning frequency (*i.e.*, tuning position) for each data symbol.

As shown in (c) of Fig. 38, in a single signal frame, and when a subband bandwidth allocating a PLP and a tuning position are consistently maintained, and when the frequency position, to which a PLP is allocated, varies for each symbol data, the tuning frequency and the tuning bandwidth enabling the receiver to receive the PLP may be identical for each data symbol included in the signal frame. However, the tuning frequency may vary for each signal frame.

Accordingly, the tuner (301010) of Fig. 41 performs the tuning process by using a fixed parameter (*i.e.*, tuning frequency and tuning bandwidth) during a single signal frame, and the tuner (301010) may perform the tuning process by changing the tuning frequency (*i.e.*, tuning position) for each signal frame. More specifically, the tuner performs frequency hopping for each signal frame.

As shown in (d) of Fig. 38, in a single signal frame, and when a subband bandwidth allocating a PLP is consistently maintained, and when the frequency position, to which a PLP is allocated, varies for each symbol data, although the tuning bandwidth enabling the receiver to receive the PLP is identical is a single signal frame, the tuning frequency may vary for each cell unit.

At this point, since a sufficient guard period required for performing frequency hopping is ensured, the tuner (301010) of Fig. 41 may perform frequency hopping even in a single signal frame. Herein, the guard period corresponds to a specific time period required by the tuner (301010) to perform frequency hopping, so as to be re-positioned (or to move) to a new tuning position, and to measure the gain of the received signal, so as to perform normal operations.

When cell mapping and reception are performed, as shown in (a) of Fig. 38 to (d) of Fig. 38, an ADC of the OFDM demodulator (301020) included in the receiver of Fig. 41 uses a sampling rate, which is decreased in proportion to the limited bandwidth, so as to perform digital conversion. Additionally, an FFT size, which is to be performed by the FFT module, also decreases in proportion to the corresponding bandwidth. Moreover, a memory, which is configured to perform time deinterleaving, and which is included in the BICM decoder (301040), is used less, and an LDPC decoding rate is also decreased. As described above, since a decrease occurs in the frequency, according to which the overall modules of the receiver are being operated, the receiver may gain a power saving effect.

Meanwhile, as shown in Fig. 39, when cell mapping is performed by using a cell unit, the receiver of Fig. 41 may first perform decoding on the L1 signaling information in the BICM decoder (301040), thereby acquiring cell mapping information on a PLP, which is requested to be decoded, from each field including the L1 signaling information. Herein, the cell mapping information includes information on a time interval (or distance) (N_GP) between cell units, information on a number of cell units used in the frequency domain, and so on. Then, based upon the acquired cell mapping information, the tuning frequency and tuning bandwidth may be detected, and the detected tuning frequency and tuning bandwidth are delivered to the tuner (301010). At this point, based upon the tuning frequency inputted by the tuner (301010), when broadcast signals respective to the tuning bandwidth are tuned, the receiver may receive only the signals corresponding to the band, which is transmitting the cell units that are to be decoded.

Meanwhile, as shown in Fig. 40, when cell mapping is performed by using a cell unit, the receiver may first perform decoding on the L1 signaling information in the BICM decoder (301040), thereby acquiring cell mapping information on a PLP, which is requested to be decoded, from each field including the L1 signaling information. Herein, the cell mapping information includes information on a time interval (N_TS) and a frequency interval (N_FS) between cell units, information on a number of cell units (N_CU) used in the frequency domain, and so on. Then, based upon the acquired cell mapping information, the tuning frequency and tuning bandwidth may be detected, and the detected tuning frequency and tuning bandwidth are delivered to the tuner (301010). At this point, based upon the tuning frequency inputted by the tuner (301010), when broadcast signals respective to the tuning bandwidth are tuned, the receiver may receive only the signals corresponding to the band, which is transmitting the cell units that are to be decoded.

Meanwhile, the present invention may transmit separate signaling information from the transmitter, so that the receiver can identify additional broadcast signal frame, such as an NGH frame, and process the identified frame. The present invention transmits separate signaling information through a P1 symbol. And, herein, the P1 symbol will be referred to as a new_system_P1 symbol.

The new_system_P1 symbol may be different from the P1 symbol, and a plurality of new_system_P1 symbols may be used herein. At this point, according to the embodiment of the present invention, the new_system_P1 symbol is located at the beginning of the signal frame, *i.e.*, located at a front portion of a first P2 symbol within a preamble region. In this case, the preamble region may be configured of at least one or more new_system_P1 symbols and at least one or more P2 symbols.

(a) of Fig. 42 illustrates a P1 symbol structure according to the present invention. In (a) of Fig. 42, the P1 symbol and P2 symbol portion will be referred to as a preamble region, and a body region will be referred to as a data region. The data region may be configured of a plurality of data symbols (also referred to as data OFDM symbols).

In (a) of Fig. 42, P1 symbol is generated by having each of a front portion and an end portion of an effective (or valid) symbol copied, by having a frequency shift performed as much as $+f_{sh}$, and by having the frequency-shifted copies respectively positioned at a front portion (C) and an end portion (B) of the effective symbol (A). In the present invention, the C portion will be referred to as a prefix, and the B portion will be referred to as a postfix. More specifically, P1 symbol is configured of a prefix portion, an effective symbol portion, and a postfix portion. In the description of the present invention, such P1 symbol structure will also be referred to as a C-A-B structure. At this point, according to the present invention, the P1 symbol corresponds to 1K OFDM symbol. And, according to the embodiment of the present invention, the A portion ($T_{P1A}$) may have the length of 112us, the C portion ($T_{P1C}$) may have the length of 59us, and the B portion ($T_{P1B}$) may have the length of 53us.

(b) of Fig. 42 illustrates a block diagram showing an exemplary structure of a P1 symbol generator according to the present invention. Herein, (b) of Fig. 42 includes a CDS (Carrier Distribution Sequence) table module (280110), an MSS (Modulation Signaling Sequence) module (280120), a DBPSK (Differential Binary Phase Shift Keying) mapping module (280130), a scrambling module (280140), an IFFT module (280160), and a C-A-B structure module (280170). After being processed with the operations of each block included in the P1 symbol generator shown in (b) of Fig. 42, the P1 symbols shown in (a) of Fig. 42 is finally outputted from the C-A-B structure module (280170).

According to the embodiment of the present invention, the structure of the P1 symbol, shown in (a) of Fig. 42, may be modified, or the P1 symbol generator, shown in (b) of Fig. 42 may be modified, so as to generate a new_system_P1 symbol.

If the new_system_P1 symbol is generated by modifying the P1 symbol shown in (a) of Fig. 42, the new_system_P1 symbol may be generated by using at least one of the following methods. For example, the new_system_P1 symbol may be generated by modifying a frequency shift (or displacement) value ($f_{SH}$) for a prefix and a postfix. In another example, the new_system_P1 symbol may be generated by modifying (or changing) the length of the P1 symbol (e.g., $T_{P1C}$ and $T_{P1B}$ lengths). In yet another example, the new_system_P1 symbol may be generated by replacing the length of the P1 symbol from 1K to 512,256,128, and so on. In this case, the parameters (*.g.*, $f_{SH}$, $T_{P1C}$, $T_{P1B}$) that are used in the P1 symbol structure should be adequately corrected.

If the new_system_P1 symbol is generated by modifying the P1 symbol generator shown in (b) of Fig. 42, the new_system_P1 symbol may be generated by using at least one of the following methods. For example, the new_system_P1 symbol may be generated by using a method of changing the distribution of active carriers (*.g.*, a method of having the CDS table module (280110) use another CSS (Complementary Set of Sequence)), which are used for the P1 symbol, through the CDS table module (280110), the MSS module (280120), and the C-A-B structure module (280170). In another example, the new_system_P1 symbol may be generated by using a method of changing a pattern for transmitting information to the P1 symbol (*.g.*, a method of having the MSS module (280120) use another CSS), and so on.

Meanwhile, the present invention may additionally allocate a preamble symbol to the preamble region within a signal frame. Hereinafter, the additional preamble signal will be referred to as an AP1 symbol (Additional Preamble symbol) for simplicity in the description of the present invention. In order to enhance the detection performance for detecting a mobile broadcast (i.e., NGH) signal, in a considerably low SNR condition or a time-selective fading condition, at least one or more AP1 symbol is added to the signal frame.

At this point, according to the embodiment of the present invention, the AP1 symbol is located between a P1 symbol and a first P2 symbol within the preamble region of a signal frame. More specifically, the P1 symbol and the AP1 symbol are consecutively transmitted. According to the embodiment of the present invention, if the P2 symbol is not transmitted to the signal frame, the AP1 symbol may be located between the P1 symbol and the first data symbol within the preamble region of the signal frame. According to another embodiment of the present invention, the P1 symbol and the AP1 symbol may be allocated to nonconsecutive positions within a single signal frame, so as to be transmitted.

In a signal frame according to the present invention, the preamble region is configured of a P1 symbol, at least one or more AP1 symbols, and at least one or more P2 symbols. And, the data region may be configured of a plurality of data symbols (or data OFDM symbols).

As described in the embodiments for generating the new_system_P1 symbol, according to the embodiment of the present invention, the AP1 symbol may be generated by modifying the structure of the P1 symbol, shown in (a) of Fig. 42, or by modifying the P1 symbol generator, shown in (b) of Fig. 42. According to the embodiment of the present invention, the AP1 symbol may be generated by modifying both the structure of the P1 symbol, shown in (a) of Fig. 42, and the P1 symbol generator, shown in (b) of Fig. 42.

According to the embodiment of the present invention, the P1 symbol and the AP1 symbol may be inserted for each signal frame by a P1 insertion module, which is included in the OFDM generator of the transmitter. More specifically, the P1 insertion module may insert at least 2 or more preamble symbols in each signal frame. According to another embodiment of the present invention, an AP1 insertion module may be added behind (or after) the P1 insertion module, and an AP1 symbol may be inserted by the AP1 insertion module. As described in the embodiment of the present invention, when at least 2 or more preamble symbols are used, the present invention is advantageous in that the present invention can be more robust against a burst fading effect, which may occur in a mobile fading environment, and that a signal detection performance can be enhanced.

Fig. 43 illustrates an exemplary super frame structure for transmitting an additional broadcast signal including the AP1 symbol, *.g.,* a mobile broadcast signal according to the present invention.

A signal frame configured to transmit an additional broadcast signal within the super frame, .g., an NGH frame transmitting an NGH signal, may be configured of a P1 symbol, an AP1 symbol, at least one or more P2 symbols, and a plurality of data symbols, as shown in Fig. 43. Herein, the P1 symbol transmits P1 signaling information, the AP1 symbol transmits AP1 signaling information, and the P2 symbol transmits the L1 signaling information. Herein, the P1 signaling information includes an S1 field and an S2 field. Herein, the S1 field signals a preamble format, and the S2 field signals an FFT size.

Apart from the AP1 symbol, since the other remaining symbols are identical to those described in Fig. 1, the description of the identical portions may be omitted for simplicity, and only the different portions will hereinafter be described in detail.

The AP1 signaling information being transmitted by the AP1 symbol may include an additional transmission parameter. According to the embodiment of the present invention, the AP1 signaling information may include pattern information of a pilot, which is inserted in the corresponding signal frame. By using the AP1 signaling information, L1 pre-signaling information may be spread to a transmission frame (*.g.*, data symbols of the data region), thereby enhancing robustness against the fading environment of the L1 pre-signaling information.

Once the present invention has indicated a pilot pattern of the current signal frame by using the AP1 signaling information, even when the L1-pre-signaling information is spread to the data symbols of the data region, the receiver may be aware of the pilot pattern prior to decoding the L1-pre-signaling information of the data region.

Fig. 44 illustrates a block diagram showing an exemplary structure of an OFDM generator, which is included in the broadcast signal transmitting apparatus, for inserting the AP1 symbol according to an embodiment of the present invention. The OFDM generator of Fig. 44 shows an exemplary embodiment corresponding to when a broadcast signal is being transmitted by using a MISO or MIMO method. Most particularly, Fig. 44 shows an example of transmitting a broadcast signal through 2 transmission antennae by using the MISO or MIMO method.

In order to do so, the OFDM generator includes a MISO/MIMO processor (302110), 2 pilot inserters (302121, 302122), 2 IFFT modules (302131, 302132), 2 PAPR reduction modules (302141, 302142), 2 GI insertion modules (302151, 302152), 2 P1 symbol insertion modules (302161, 302162), 2 AP1 symbol insertion modules (302171, 302172), and 2 DACs (302181, 302182). In the description of the present invention, a block configured to modulate a broadcast signal that is to be transmitted though a 1$^{st}$ transmission antenna (Tx1) will be referred to as a first transmission unit, and a block configured to modulate a broadcast signal that is to be transmitted though a 2$^{nd}$ transmission antenna (Tx2) will be referred to as a second transmission unit. Herein, the first transmission unit includes a pilot inserter (302121), an IFFT module (302131), a PAPR reduction module (302141), a GI insertion module (302151), a P1 symbol insertion module (302161), an AP1 symbol insertion module (302171), and a DAC (302181). And, the second transmission unit includes a pilot inserter (302122), an IFFT module (302132), a PAPR reduction module (302142), a GI insertion module (302152), a P1 symbol insertion module (302162), an AP1 symbol insertion module (302172), and a DAC (302182).

In order to transmit signals through 2 transmission antennae, the MISO/MIMO processor (302110) first performs MISO and/or MIMO encoding on signals, each being inputted through a different path, so that the signals can gain transmission diversity. The, MISO/MIMO processor (302110) respectively outputs the MISO and/or MIMO encoded signals to each of the 2 pilot inserters (302121, 302122). Herein, the MIMO encoding may be performed by a constellation mapper included in the BICM module. And, in this case, the MIMO encoding is not performed by the OFDM generator.

Each of the pilot inserters (302121, 302122) may insert a pilot of a decided pilot pattern to a corresponding position within the signal frame, and may then output the pilot-inserted signals to the IFFT modules (302131, 302132). At this point, the pilot pattern information may be signaled to the AP1 signaling information, or may be signaled to the L1 signaling information. Alternatively, the pilot pattern information may also be signaled to both the AP1 signaling information and the L1 signaling information.

Each of the IFFT modules (302131, 302132) may convert each of the pilot-inserted signals to a time domain through a Fast Fourier Transform process. Then, each of the IFFT modules (302131, 302132) may respectively output the time-converted signals to the PAPR reduction modules (302141, 302142).

Each of the PAPR reduction modules (302141, 302142) may reduce the PAPR of the time domain signals, and may then transmit the processed signals to the GI insertion modules (302151, 302152). Additionally, based upon a PAPR reduction algorithm, the PAPR reduction modules (302141, 302142) may respectively feed-back required information to the pilot inserters (302121, 302122).

By copying a last portion of an effective OFDM symbol to a front portion of the corresponding OFDM symbol, each of the GI insertion modules (302151, 302152) may insert a guard interval in the form of a cyclic prefix, thereby outputting the processed symbol to the P1 symbol insertion modules (302161, 302162). Herein, the GI information may be signaled to the L1 pre signaling information. And, a portion of the GI information may be signaled to the P1 signaling information.

Each of the P1 symbol insertion modules (302161, 302162) may insert a P1 symbol at the beginning (or starting portion) of each signal frame, thereby outputting the processed signal frame to the AP1 symbol insertion modules (302171, 302172).

Each of the AP1 symbol insertion modules (302171, 302172) may insert an AP1 symbol after the P1 symbol, thereby outputting the processed signal frame to the DACs (302181, 302182). Herein, the insertion of the P1 symbol and the AP1 symbol may be performed by the P1 symbol insertion modules (302161, 302162). And, in this case, the AP1 symbol insertion modules (302171, 302172) may be omitted.

Each of the DACs (302181, 302182) may convert each of the AP1 symbol inserted signal frames to analog signals, and may then respectively output the converted signals to the corresponding transmission antennae (Tx1 and Tx2).

Meanwhile, when a pilot is inserted in each signal frame and transmitted by the pilot inserters (302121, 302122), the receiver may use the pilot in frame synchronization, frequency synchronization, time synchronization, channel estimation, transmission mode recognition, and so on.

The pilot according to the present invention may be divided into 2 different types, one being a scattered pilot and the other being continual pilot. More specifically, the scattered pilot is used to enable the receiver to estimate and compensate for any influence caused by a radio channel. And, the continual pilot to enable the receiver to remove any accurate frequency synchronization or phase error.

In the present invention, a plurality of scattered pilot patterns may exist. And, according to the embodiment of the present invention, among the plurality of scattered pilot patterns, one scattered pilot pattern may be selected in accordance with an FFT size and a guide interval (GI) size, so as to be inserted in OFDM symbols of a signal frame and transmitting the pilot-inserted symbols. More specifically, according to the embodiment of the present invention, when the present invention uses the MIMO method, among 9 scattered pilot patterns (PP1~PP9), one scattered pilot pattern is selected based upon the FFT size and the GI size, so as to be inserted in the OFDM symbols of the corresponding signal frame.

In the description of the present invention, according to the embodiment of the present invention, 1k, 2k, 4k, 8k, and 16k may be used as the FFT size, and 1/128, 1/32, 1/16, 19/256, 1/8, 19/128, and 1/4 may be used as the GI size. The FFT size refers to a number of subcarriers configuring a single OFDM symbol. And, the GI size refers to a ratio being occupied by the GI in a single OFDM symbol. Therefore, the length of an OFDM symbol may vary depending upon the FFT size and GI size.

The GI size information may be signaled to a GUARD_INTERVAL field of the L1 pre signaling information. And, the pilot pattern information, which is being inserted in the current signal frame, may be signaled to the L1 pre signaling information and/or the AP1 signaling information.

Fig. 45 illustrates a table showing an exemplary parameter of 9 scattered pilot patterns according to the present invention.

In the table shown in Fig. 45, Dx represents a distance between subcarriers transmitting pilots in a frequency domain, and Dy represents a number of OFDM symbols used between pilot subcarriers of the same position within a time domain. More specifically, Dx refers to a distance (or interval) between subcarriers (*i.e.,* Separation of pilot bearing carriers) transmitting a pilot within a single OFDM symbol, and Dy refers to a distance (or interval) between OFDM symbols of a pilot (*i.e.,* Number of symbols forming one scattered pilot sequence).

Herein, in a 1$^{st}$ scattered pilot pattern (PP1), the Dx value is equal to 6, and a Dy value is equal to 4. More specifically, the 1$^{st}$ scattered pilot pattern (PP1) may be allocated to a specific OFDM symbol within the signal frame at an interval of 6 subcarriers. And, the 1$^{st}$ scattered pilot pattern (PP1) may also be allocated to 4 OFDM symbols within a specific subcarrier of the same position within the signal frame. In a 2$^{nd}$ scattered pilot pattern (PP2), the Dx value is equal to 12, and a Dy value is equal to 2. In a 3$^{rd}$ scattered pilot pattern (PP3), the Dx value is equal to 12, and a Dy value is equal to 4. In a 4$^{th}$ scattered pilot pattern (PP4), the Dx value is equal to 24, and a Dy value is equal to 2. In a 5$^{th}$ scattered pilot pattern (PP5), the Dx value is equal to 24, and a Dy value is equal to 4. In a 6$^{th}$ scattered pilot pattern (PP6), the Dx value is equal to 48, and a Dy value is equal to 2. In a 7$^{th}$ scattered pilot pattern (PP7), the Dx value is equal to 24, and a Dy value is equal to 4. In an 8$^{th}$ scattered pilot pattern (PP8), the Dx value is equal to 12, and a Dy value is equal to 16. And, finally, in a 9$^{th}$ scattered pilot pattern (PP9), the Dx value is equal to 6, and a Dy value is equal to 2. More specifically, the 9$^{th}$ scattered pilot pattern (PP9) may be allocated to a specific OFDM symbol within the signal frame at an interval of 6 subcarriers. And, the 9$^{th}$ scattered pilot pattern (PP9) may also be allocated to 2 OFDM symbols within a specific subcarrier of the same position within the signal frame. According to another embodiment of the present invention, in the 9$^{th}$ scattered pilot pattern (PP9), the Dx value may be set to 12, and the Dy value may be set to 3. This embodiment will be described later on in more detail.

Fig. 46 illustrates examples of scattered pilot patterns that can be used in a corresponding signal frame in accordance with an FFT size and a GI size, among the 9 scattered pilot patterns that can be used by the MIMO type transmitting apparatus according to the present invention.

For example, when the FFT size is equal to 16K, and when the GI size is equal to 1/32 of the FFT size, the corresponding signal frame may use any one of the 2$^{nd}$ pilot pattern (PP2), the 4$^{th}$ pilot pattern (PP4), and the 5$^{th}$ pilot pattern (PP5). In another example, when the FFT size is equal to 16K, and when the GI size is equal to 1/16 of the FFT size, the corresponding signal frame may use any one of the 2$^{nd}$ pilot pattern (PP2), the 3$^{rd}$ pilot pattern (PP3), and the 9$^{th}$ pilot pattern (PP9).

In Fig. 45 and Fig. 46, referring to each scattered pilot pattern, it will be apparent that the scattered pilot pattern, which is to be inserted in each signal frame, is decided based upon the Dx value, the Dy value, the FFT size, and the GI size.

Fig. 47 illustrates an exemplary 9$^{th}$ pilot pattern (PP9) according to an embodiment of the present invention.

Referring to Fig. 47, in the 9$^{th}$ pilot pattern (PP9), the distance between the subcarriers transmitting a pilot in the frequency domain corresponds to Dx=6, and the number of OFDM symbols between pilot subcarriers being located in the same position within the time domain corresponds to Dy=2. This rule is equally applied to all OFDM symbols excluding the last OFDM symbol within the signal frame. In the last OFDM symbol within the signal frame of Fig. 47, the pilot pattern is modified (or changed). For example, the Dx value of the last OFDM symbol is equal to 3.

The 9th scattered pilot pattern (PP9) of Fig. 47 is used in a MIMO/MISO system, which uses two transmission antennae. For simplicity in the description of Fig. 47, an OFDM symbol including pilot cells hatched with dotted patterns (or dotted pilot cells), will be referred to as an even index OFDM symbol, and an OFDM symbol including pilot cells hatched with diagonal line patterns (or diagonally-hatched pilot cells), will be referred to as an odd index OFDM symbol. In this case, the last OFDM symbol will be excluded. More specifically, the last OFDM symbol includes both the dotted pilot cells and the diagonally-hatched pilot cells. Additionally, a pilot is inserted in the first cell (*i.e.,* first subcarrier) of the even index OFDM symbols and in the first cell (*i.e.,* first subcarrier) of the odd index OFDM symbols. In this case, the distance (or interval) between the first pilot cell of each odd index OFDM symbol and the second pilot cell of each odd index OFDM symbol, *i.e.,* Dx is equal to 3. And, thereafter, the Dx is equal to 6.

At this point, in order to allow the receiver to estimate a transmission channel starting from each transmission antenna to each reception antenna, for the even index OFDM symbol, the transmitter may unify the sign of the scattered pilot, which is to be transmitted to two antennae, and for the odd index OFDM symbol, the transmitter may transmit a scattered pilot having an opposite sign. More specifically, each of the dotted pilot cells corresponds to a position, to which two transmission antennae transmit the same pilot values having the same sign. And, although each of the diagonally-hatched pilot cells corresponds to a position, to which two transmission antennae transmit the same pilot values having the same sign, the pilot values correspond to opposite positions of the dotted pilot signals. Therefore, when the receiver detects a pilot, a sum of the pilot values being transmitted from two transmission antennae may be detected in the dotted pilot cells, and a difference between the pilot values being transmitted from two transmission antennae may be detected in the diagonally-hatched pilot cells. At this point, the pilot values may correspond to values, which are pre-decided based upon an agreement between the transmitting apparatus/receiving apparatus. More specifically, when a broadcast signal including each signal frame is transmitted through 2 transmission antennae, the pilot inserter of the first transmitting unit and the pilot inserter of the second transmitting unit within the OFDM generator respectively insert a pilot signal to each signal frame. At this point, any one of the pilot inserter of the first transmitting unit and the pilot inserter of the second transmitting unit may set the code of the pilot signal, which is being inserted in the diagonally-hatched pilot cells, to an opposite code. Additionally, in the pilot inserter of the first transmitting unit and in the pilot inserter of the second transmitting unit, the codes of the two pilot signals being inserted in the dotted pilot cells may be identical to one another. According to an embodiment of the present invention, the first transmitting unit and the second transmitting unit respectively insert pilot signals having the same pilot pattern to a corresponding signal frame.

At this point, in the scattered pilot pattern of Fig. 47, a cycle period for transmitting the sum and the difference may correspond to a duration period of 2 OFDM symbols. More specifically, the sum and difference may be transmitted at a cycle period of 2 OFDM symbols.

When the sum and difference are transmitted as described above, the receiver may use the sum and difference, so as to recover the pilot signal transmitted from each transmission antenna and to estimate a channel.

In this case, in order to receive both the sum and difference, 2 OFDM symbols should be received. And, therefore, the requirement condition for the transmission channel of this system indicates that a coherence time of a channel should be greater than a time period (symbol duration), during which 2 OFDM symbols are received. Since this condition is identical to the condition of the above-described case when Dy=2, any additional requirement caused by the Dy value does not occur. At this point, since the Dy value is equal to 2, and the Dx value is equal to 6, the 9th pilot pattern (PP9), shown in Fig. 42, may be suitable for a fast mobile service.

Fig. 48 illustrates an exemplary 9th pilot pattern (PP9) according to another embodiment of the present invention.

Referring to Fig. 48, in the 9th pilot pattern (PP9), the distance between the subcarriers transmitting a pilot in the frequency domain corresponds to Dx=12, and the number of OFDM symbols between pilot subcarriers being located in the same position within the time domain corresponds to Dy=3. This rule is equally applied to all OFDM symbols excluding the last OFDM symbol within the signal frame. In the last OFDM symbol within the signal frame of Fig. 48, the pilot pattern is modified (or changed). For example, the Dx value of the last OFDM symbol is equal to 4.

The 9th scattered pilot pattern (PP9) of Fig. 48 is used in a MIMO/MISO system, which uses two transmission antennae. Each OFDM symbol within the symbol frame includes both pilot cells hatched with dotted patterns (or dotted pilot cells) and pilot cells hatched with diagonal line patterns (or diagonally-hatched pilot cells). Additionally, the dotted pilot cells are allocated to the first subcarrier of each OFDM symbol, and the diagonally-hatched pilot cells are allocated to the second subcarrier of each OFDM symbol.

At this point, in order to allow the receiver to estimate a transmission channel starting from each transmission antenna to each reception antenna, for the even index OFDM symbol, the transmitter may transmit a sum and difference of the pilots from two transmission antennae. More specifically, each of the dotted pilot cells corresponds to a position, to which two transmission antennae transmit the same pilot values having the same sign. And, although each of the diagonally-hatched pilot cells corresponds to a position, to which two transmission antennae transmit the same pilot values having the same sign, the pilot values correspond to opposite positions of the dotted pilot signals. Therefore, when the receiver detects a pilot, a sum of the pilot values being transmitted from two transmission antennae may be detected in the dotted pilot cells, and a difference between the pilot values being transmitted from two transmission antennae may be detected in the diagonally-hatched pilot cells. At this point, the pilot values may correspond to values, which are pre-decided based upon an agreement between the transmitting apparatus/receiving apparatus.

In a pilot pattern having the structure shown in Fig. 48, the sum and difference of pilot values are transmitted for each OFDM symbol. Most particularly, the first 2 subcarriers of each OFDM symbol are each used in order to transmit the sum and difference the pilot values. Therefore, a requirement condition required by a transmitter, which uses the pilot pattern shown in Fig. 48, to the transmission channel, indicates that the coherence time of a channel should be equivalent to 1 OFDM symbol duration period. This requirement condition corresponds to the fastest channel estimation speed that can be provided by a system using the OFDM method. Therefore, the 9$^{th}$ pilot pattern (PP9), shown in Fig. 48, may be suitable for a fast mobile service.

However, as shown in Fig. 48, according to the embodiment of the present invention, since Dy=3, in order to acquire the above-described maximum channel estimation speed, the OFDM demodulator according to the present invention performs interpolation on the estimated channel only in the frequency domain starting from the scattered pilot position.

Additionally, by using the 9$^{th}$ pilot pattern (PP9) of Fig. 48, since the pilot position, from which the sum and difference of the pilot are transmitted, exist in each OFDM symbol, each OFDM symbol may transmit an edge pilot for the sum and the difference. Thus, a difference in the channel estimation may be reduced in the edge of a spectrum.

When the sum and difference are transmitted as described above, the receiver may use the transmitted sum and difference, so as to recover the pilot signal, which is transmitted from each transmission antenna, and to estimate the channel. In this case, even if 1 OFDM symbol is received, the sum and difference of the pilot may both be received. In this case, the coherence time of a channel corresponds to a symbol duration during which 1 OFDM symbol is being received.

Fig. 49 illustrates an exemplary structure of a P1 symbol and an exemplary structure of an AP1 symbol according to an embodiment of the present invention. Fig. 49 shows an example of generating an AP1 symbol by modifying the P1 symbol.

In Fig. 49, P1 symbol, which is shown on the left side, is generated by having each of a front portion and an end portion of an effective (or valid) symbol copied, by having a frequency shift performed as much as $+f_{sh}$, and by having the frequency-shifted copies respectively positioned at a front portion (C) and an end portion (B) of the effective symbol (A). In the present invention, the C portion will be referred to as a prefix, and the B portion will be referred to as a postfix. More specifically, P1 symbol is configured of a prefix portion, an effective symbol portion, and a postfix portion.

In Fig. 49, AP1 symbol, which is shown on the right side, is generated by having each of a front portion and an end portion of an effective (or valid) symbol copied, by having a frequency shift performed as much as $-f_{sh}$, and by having the frequency-shifted copies respectively positioned at a front portion (F) and an end portion (E) of the effective symbol (D). In the present invention, the F portion will be referred to as a prefix, and the E portion will be referred to as a postfix. More specifically, AP1 symbol is configured of a prefix portion, an effective symbol portion, and a postfix portion.

Herein, the two frequency-shift values $+f_{sh}$, $-f_{sh}$, which are used in the P1 symbol and the AP1 symbol, may have the same absolute value yet be given opposite signs. More specifically, the frequency-shift is performed in opposite directions. And, the lengths C and F, which are copied to the front portion of the effective symbol, may be set to have different values. And, the lengths B and E, which are copied to the end portion of the effective symbol, may be set to have different values. Alternatively, the lengths C and F may be set to have different values, and the lengths B and E may be set to have the same value, or vice versa. According to another embodiment of the present invention, an effective symbol length of the P1 symbol and an effective symbol length of the AP1 symbol may be differently determined. And, according to yet another embodiment of the present invention, a CSS (Complementary Set Sequence) may be used for tone selection and data scrambling within the AP1 may be scrambled by AP1.

According to the embodiment of the present invention, the lengths of C and F, which are copied to the front portion of the effective (or valid) symbol, may be set to have different values, and the lengths of B and E, which are copied to the end portion of the effective (or valid) symbol, may also be set to have different values.

The C,B,F,E lengths according to the present invention may be obtained by using Equation 11 shown below.

Equation 11

$$\text{Length of C } (T_C) = \{\text{Length of A } (T_A)/2 + 30\}$$

$$\text{Length of B } (T_B) = \{\text{Length of A } (T_A)/2 - 30\}$$

$$\text{Length of E } (T_F) = \{\text{Length of D } (T_D)/2 + 15\}$$

$$\text{Length of E } (T_E) = \{\text{Length of D } (T_D)/2 - 15\}$$

As shown in Equation 11, P1 symbol and AP1 symbol have the same frequency shift value. However, each of the P1 symbol and the AP1 symbol are given opposite signs. Additionally, in order to determine the lengths of C and B, the present invention determines an offset value being added to or subtracted from a value corresponding to the length of A ($T_A$)/2. And, in order to determine the lengths of F and E, the present invention determines an offset value being added to or subtracted from a value corresponding to the length of D ($T_D$)/2. Herein, each of the offset values is set up differently. According to the embodiment of the present invention, the offset value of P1 symbol is set to 30, and the offset value of AP1 symbol is set to 15. However, the values given in the above-described examples are merely exemplary. And, therefore, it will be apparent that the corresponding values may easily be varied or changed by anyone skilled in the art. Thus, the present invention will not be limited only to the values presented herein.

According to the present invention, by generating AP1 symbol and an AP1 symbol to configure the structure shown in Fig. 49, and by inserting the generated symbols to each signal frame, the P1 symbol does not degrade the detection performance of the AP1 symbol, and, conversely, the AP1 symbol does not degrade the detection performance of the P1 symbol. Additionally, the detection performance of the P1 symbol is almost identical to the detection performance of the AP1 symbol. Furthermore, by configuring the symbols so that the P1 symbol and the AP1 symbol have similar symbol structures, the complexity level of the receiver may be reduced.

At this point, the P1 symbol and the AP1 symbol may be transmitted consecutively, or each of the symbols may be allocated to different positions within the signal frame and may then be transmitted. And, in case the P1 symbol and AP1 symbol are each allocated to a different position within the signal frame, so as to be transmitted, a high time diversity effect may be gained with respect to the preamble symbol. According to the embodiment of the present invention, the P1 symbol and the AP1 symbol are consecutively transmitted.

Fig. 50 illustrates a block diagram showing a structure of an OFDM demodulator according to yet embodiment of the present invention. According to an embodiment of the present invention, the OFDM demodulator uses 2 reception antennae (Rx1, Rx2) in order to receive the signals transmitted via MIMO or MISO. The OFDM demodulator of Fig. 50 receives a broadcast signal passing through each path and being received through two antennae (Rx1, Rx2), thereby performing OFDM demodulation on each of the received signals.

The OFDM demodulator of Fig. 50 consists of a 1st receiving unit and a 2nd receiving unit. Herein, the 1st receiving unit includes an ADC (306600), a P1 symbol detector (306601), an AP1 symbol detector (306602), a Time/Frequency synchronization unit (306603), a GI remover (306604), an FFT module (306605), and a channel estimator (306606). And, the 2nd receiving unit includes an ADC (306610), a P1 symbol detector (306611), an AP1 symbol detector (306612), a Time/Frequency synchronization unit (306613), a GI remover (306614), an FFT module (306615), and a channel estimator (306616). Herein, the 1st receiving unit may further include an equalization/MISO decoder, and the 2nd receiving unit may also further include an equalization/MISO decoder.

Since the 1st receiving unit and the 2nd receiving unit have the same structure in the present invention. Only the 1st receiving unit will be described in detail.

More specifically, the ADC (306600) converts an analog broadcast signal, which is received through an antenna (Rx1), to a digital signal, thereby outputting the converted digital broadcast signal to the P1 symbol detector (306601). Herein, among the digital broadcast signals, the P1 symbol detector (306601) detects and decodes the P1 symbol, which transmits P1 signaling information, so as to determine the frame configuration of the currently received signal. Among the digital broadcast signals, the AP1 symbol detector (306602) detects and decodes the AP1 symbol, which transmits AP1 signaling information, so as to acquire pilot pattern information of the current signal frame. Herein, the detection and decoding of the P1 symbol and the AP1 symbol may be performed by the P1 symbol detector (306601). And, in this case, the AP1 symbol detector (306602) may be omitted.

The time/frequency synchronization unit (306603) uses the P1 signaling information and the AP1 signaling information, so as to perform time synchronization and frequency synchronization including guard interval detection. After performing the synchronization process, the guard interval (GI) remover (306604) may remove the guard interval from the received and processed signal. Then, the processed signal may be converted to a frequency domain signal by the FFT module (306605). The channel estimator (306606) estimates a transmission channel starting from the transmission antenna to a reception channel from the pilot signals inserted in the frequency domain.

Fig. 51 illustrates an exemplary structure of a P1 symbol detector (306601) according to an embodiment of the present invention. Herein, the P1 symbol detector (306601) may also be referred to as a C-A-B preamble detector. More specifically, the signal that is converted to a digital signal from the ADC (306600) may be inputted to a down shifter (307101), a 1st conjugator (307103), and a 2nd delayer (307106) of the P1 symbol detector (306601).

The down shifter (307101) performs inverse modulation by multiplying

$$e^{-j2\pi f_{SH}t}$$

by the input signal. When inverse modulation is performed by the down shifter (307101), the signal being frequency-shifted and inputted is recovered to the original signal. The inverse modulated signal may be outputted to a 1st delayer (307102) and a 2nd conjugator (307107).

The 1st delayer (307102) delays the inverse-modulated signal by a length of part C ($T_C$) and then outputs the delayed signal to the 1st conjugator (307103). The 1st conjugator (307103) performs complex-conjugation on the signal, which is delayed by a length of part C ($T_C$). Then, the 1st conjugator (307103) multiplies the input signal by the complex-conjugated signal, thereby outputting the processed signal to a 1st filter (307104). The 1st filter (307104) uses a running average filter having the length of $T_R$=$T_A$, so as to remove (or eliminate) any excessively and unnecessarily remaining modulation elements, thereby outputting the processed signal to a 3rd delayer (307105). The 3rd delayer (307105) delays the filtered signal by a length of part A (*i.e.,* effective (or valid) symbol) ($T_A$), so as to output the delayed signal to a multiplier (307109).

The 2nd delayer (307106) delays the input signal by a length of part B ($T_B$) and then outputs the delayed signal to the 2nd conjugator (307107). The 2nd conjugator (307107) performs complex-conjugation on the signal, which is delayed by a length of part B ($T_B$). Then, the 2nd conjugator (307107) multiplies the complex-conjugated signal by an inverse-modulated signal, thereby outputting the processed signal to a 2nd filter (307108). The 2nd filter (307108) uses a running average filter having the length of $T_R$=$T_A$, so as to remove (or eliminate) any excessively and unnecessarily remaining modulation elements, thereby outputting the processed signal to the multiplier (307109).

The multiplier (307109) multiplies the output of the 2nd filter (307109) by a signal, which is delayed by a length of part A ($T_A$). Thus, a P1 symbol may be detected from each signal frame of the received broadcast signal.

Herein, the length of part C ($T_C$) and the length of part B ($T_B$) may be obtained by applying Equation 11 shown above.

Fig. 52 illustrates an exemplary structure of an AP1 symbol detector (306602) according to an embodiment of the present invention. Herein, the AP1 symbol detector (306602) may also be referred to as an F-D-E preamble detector. More specifically, the signal that is converted to a digital signal from the ADC (306600) or a signal that is outputted from the P1 symbol detector (306601) may be inputted to an up-shifter (308101), a 1st conjugator (308103), and a 2nd delayer (308106) of the AP1 symbol detector (306602).

The up-shifter (308101) performs inverse modulation by multiplying

$$e^{j2\pi f_{SH}t}$$

by the input signal. When inverse modulation is performed by the up-shifter (308101), the signal being frequency-shifted and inputted is recovered to the original signal. More specifically, the up-shifter (308101) of Fig. 52 has the same structure as the down-shifter (307101) of the P1 symbol detector (306601). However, the frequency direction of each inverse modulation process is completely opposite to one another. The signal that is inverse modulated by the up-shifter (308101) may be outputted to a 1st delayer (308102) and a 2nd conjugator (308107).

The 1st delayer (308102) delays the inverse-modulated signal by a length of part F ($T_F$) and then outputs the delayed signal to the 1st conjugator (308103). The 1st conjugator (308103) performs complex-conjugation on the signal, which is delayed by a length of part F ($T_F$). Then, the 1st conjugator (308103) multiplies the input signal by the complex-conjugated signal, thereby outputting the processed signal to a 1st filter (308104). The 1st filter (308104) uses a running average filter having the length of $T_R$=$T_D$, so as to remove (or eliminate) any excessively and unnecessarily remaining modulation elements, thereby outputting the processed signal to a 3rd delayer (308105). The 3rd delayer (308105) delays the filtered signal by a length of part D (*i.e.,* effective (or valid) symbol) ($T_D$), so as to output the delayed signal to a multiplier (308109).

The 2nd delayer (308106) delays the input signal by a length of part E ($T_E$) and then outputs the delayed signal to the 2nd conjugator (308107). The 2nd conjugator (308107) performs complex-conjugation on the signal, which is delayed by a length of part E ($T_E$). Then, the 2nd conjugator (308107) multiplies the complex-conjugated signal by an inverse-modulated signal, thereby outputting the processed signal to a 2nd filter (308108). The 2nd filter (308108) uses a running average filter having the length of $T_R$=$T_D$, so as to remove (or eliminate) any excessively and unnecessarily remaining modulation elements, thereby outputting the processed signal to the multiplier (308109).

The multiplier (308109) multiplies the output of the 2nd filter (308109) by a signal, which is delayed by a length of part D ($T_D$). Thus, an AP1 symbol may be detected from each signal frame of the received broadcast signal. Herein, the length of part F ($T_F$) and the length of part E ($T_E$) may be obtained by applying Equation 11 shown above.

Meanwhile, the receiver uses the pilot, so as to perform frame synchronization, frequency synchronization, time synchronization, channel estimation, and transmission mode recognition.

In order to do so, the receiver should first use P1 signaling information, AP1 signaling information, and L1 signaling information, so as to be aware of an FFT size, a GI size, a pilot pattern, and so on, of the corresponding signal frame. The receiver of the present invention may decode the P1 signaling information from the OFDM demodulator, so as to extract the FFT size, and may decode the L1 signaling information from the BICM decoder, so as to extract the GI size, the pilot pattern, and so on. At this point, the pilot pattern may be acquired from the AP1 signaling information, which is decoded by the OFDM generator. More specifically, the channel estimator (306606, 306616) of Fig. 50 may calculate the position of a subcarrier having a pilot inserted therein from each OFDM symbol within each signal frame, based upon the FFT size, the GI size, and the pilot pattern information, which are acquired from the P1 signaling information, the AP1 signaling information, and the L1 signaling information. Also, by using a pilot value corresponding to the pilot subcarrier position, which is calculated as described above, the transmission channel may be estimated. Such estimated channel value may be used in the receiver for channel equalization or MIMO decoding in a later process. If only one reception antenna is used, the above-described signaling information (*i.e.,* P1, AP1, L1 signaling information) may be acquired by a receiving unit within the OFDM demodulator, and, then, a channel estimation process may be performed by using the pilot signal. In another example, when 2 reception antennae are provided, the above-described process may be simultaneously performed by the 1st receiving unit and the 2nd receiving unit within the OFDM modulator.

Hereinafter, the process of estimating a channel by using a scattered pilot, as shown in Fig. 47, will be described in detail.

Referring to Fig. 47, the distance (or interval) between the subcarriers transmitting a pilot in the frequency domain corresponds to Dx=6, and the number of OFDM symbols between pilot subcarriers being located in the same position within the time domain corresponds to Dy=2. And, more specifically, each of the dotted cells corresponds to a position, to which two transmission antennae transmit the same pilot values having the same sign. And, although each of the diagonally-hatched cells corresponds to a position, to which two transmission antennae transmit the same pilot values having the same sign, the pilot values correspond to opposite positions of the dotted signals.

At this point, the absolute value of the pilot value belonging to the transmitting end may be referred to as p, and a transmission channel starting from transmission antenna x to reception antenna y may be referred to as hxy. Accordingly, a receiver using a 2x2 MIMO method may acquire a pilot value, which is received by each reception antenna during an even index OFDM symbol section, which includes the dotted cells, by using Equation 12 shown below.

Equation 12

$$r1(2k) = h11*p + h21*p$$

$$r2(2k) = h12*p + h22*p$$

Similarly, a pilot value, which is received by each reception antenna during an odd index OFDM symbol section, which includes the diagonally-hatched cells, by using Equation 13 shown below.

Equation 13

$$r1(2k+1) = h11*p - h21*p$$

$$r2(2k+1) = h12*p - h22*p$$

Referring to Equations 12, 13, rm(n) signifies a pilot value being received during an $n^{th}$ OFDM symbol duration period by an $m^{th}$ reception antenna. Therefore, the result of a channel estimation process starting from each transmission antenna to each reception antenna may be acquired by performing a simple calculation using Equation 14 shown below.

Equation 14

$$h11 = (r1(2k) + r1(2k+1)) / 2p$$

$$h12 = (r2(2k) + r2(2k+1)) / 2p$$

$$h21 = (r1(2k) - r1(2k+1)) / 2p$$

$$h22 = (r2(2k) - r2(2k+1)) / 2p$$

The calculated channel estimation value may be used for channel equalization and MIMO decoding. At this point, since a subcarrier position (*i.e.,* dotted cell position), which receives the sum of the pilot values within the signal frame, is different from a subcarrier position (*i.e.,* diagonally-hatched cell position), which receives the difference between the pilot values within the signal frame, the sum and difference of the pilot values in all subcarrier positions should first be calculated prior to performing channel estimation. In order to do so, the channel estimator of the receiver uses a pilot value in a pilot position for each OFDM symbol, so as to perform demodulation and to first estimate the channel value in a pilot position. Thereafter, the channel estimator performs frequency interpolation, so as to acquire the channel value corresponding to all subcarrier positions. The channel values, which are acquired as described above, may be used to calculate the sum of the channel values corresponding to the even index OFDM symbol, and may also be used to calculate the difference between the channel values corresponding to the odd index OFDM symbol. By using the two values, when the same calculation is performed by applying the value p=1 in Equations 12 and 13, the transmission channel values respective to all subcarrier positions may be calculated and obtained.

Another method for performing channel estimation in the channel estimator will hereinafter be described in detail. First of all, a time interpolation process is performed along a time direction on each of a dotted cell position and a diagonally-hatched cell position. Then, by using the two different time interpolated channel values, channel estimation may be performed for each OFDM symbol by using Equation 14. Thereafter, when a pilot is inserted in the form of a pilot pattern shown in Fig. 47, it will be assumed that all of the transmission channels should not be changed (or should remain unchanged) during a 2-OFDM symbol duration period. Accordingly, time coherence occurs during the 2-OFDM symbol duration period.

Hereinafter, the process of estimating a channel by using a scattered pilot, as shown in Fig. 48, will be described in detail.

Referring to Fig. 48, the distance (or interval) between the subcarriers transmitting a pilot in the frequency domain corresponds to Dx=12, and the number of OFDM symbols between pilot subcarriers being located in the same position within the time domain corresponds to Dy=3. And, more specifically, each of the dotted cells corresponds to a position, to which two transmission antennae transmit the same pilot values having the same sign. And, although each of the diagonally-hatched cells corresponds to a position, to which two transmission antennae transmit the same pilot values having the same sign, the pilot values correspond to opposite positions of the dotted signals.

At this point, the absolute value of the pilot value belonging to the transmitting end may be referred to as p, and a transmission channel starting from transmission antenna x to reception antenna y may be referred to as hxy. Accordingly, a receiver using a 2x2 MIMO method may acquire a pilot value, which is received from the dotted cell of each OFDM symbol, by using Equation 12 shown above.

Similarly, a pilot value, which is received from the diagonally-hatched cell of each OFDM symbol, by using Equation 13 shown above.

Furthermore, the result of a channel estimation process starting from each transmission antenna to each reception antenna may be acquired by performing a simple calculation using Equation 14 shown above.

The calculated channel estimation value may be used for channel equalization and MIMO decoding. At this point, when using a $9^{th}$ pilot pattern, as shown in Fig. 48, since a sum of the pilot values and a difference between the pilot values are transmitted for each OFDM symbol, even if the channel estimator performs only the frequency interpolation process in the frequency domain for each OFDM symbol, the sum and difference of transmission channel values respective to one OFDM symbol may be acquired. Therefore, according to the embodiment of the present invention, regardless of the even index OFDM symbol or the odd index OFDM symbol, the sum and difference of the pilot values may be obtained by using only the channel estimation performed on one OFDM symbol. And, separate channel calculation may be performed by using the sum and difference value obtained by using the above-described method. In this case, additional interpolation along the time direction is not required to be performed.

If the transmission corresponds to a case when a Doppler speed is low, yet when a frequency selective fading effect caused by multiple paths is high, the receiver may use another method in order to enhance the channel estimation performance. According to an embodiment of the present invention, a time interpolation process is first performed along a time direction on each of a dotted cell position and a diagonally-hatched cell position. Then, when a frequency interpolation process is performed along a frequency direction by using the time interpolation result, this results in effective Dx=8. Accordingly, channel estimation may also be performed on a channel delay profile, which is 3 times longer than Dx=24, which corresponds to the above-described case of using only the frequency interpolation process.

According to the present invention, by having the transmitter insert a $9^{th}$ pilot pattern (PP9), shown in Fig. 47 and Fig. 48, in a signal frame and transmit the processed signal frame, and by having the receiver use the processed signal frame for channel estimation, the present invention may be capable of responding to the fast and frequent channel changes with robustness. Most particularly, the $9^{th}$ pilot pattern (PP9) is advantageous in that mobility can be enhanced, while using a network infra of the conventional terrestrial broadcasting system without any modification.

Fig. 53 illustrates a flow chart showing the process steps of a method of receiving a broadcast signal according to an embodiment of the present invention.

The tuner receives a broadcast signal being transmitted through a first transmission antenna and a second transmission antenna, while consistently maintaining a subband bandwidth and changing a tuning frequency for each cell unit (S36010).

The OFDM demodulator detects a $1^{st}$ preamble signal and a $2^{nd}$ preamble signal, which are inserted in a signal frame of the received broadcast signal (S36020). Thereafter, the OFDM demodulator identifies a pilot position, which is inserted in the signal frame, based upon FFT size information included in the detected $1^{st}$ preamble signal and based upon pilot pattern information included in the detected $2^{nd}$ preamble signal, estimates a transmission channel through which the broadcast signal is transmitted by using a pilot signal corresponding to the identified pilot position and then performs channel equalization (S36030). Subsequently, the OFDM demodulator performs error correction on the channel-equalized broadcast signal (S36040).

If the broadcast signal receiving apparatus includes 2 antennae, the tuner may be configured of a $1^{st}$ tuner and a $2^{nd}$ tuner, and the OFDM demodulator may be configured of a $1^{st}$ receiving unit and a $2^{nd}$ receiving unit. Herein, according to the embodiment of the present invention, the $2^{nd}$ tuner performs the same operations as the $1^{st}$ tuner, so as to receive the broadcast signal, and the $2^{nd}$ receiving unit performs the same operations as the $1^{st}$ receiving unit, so as to perform channel estimation and channel equalization by using a pilot. According to the embodiment of the present invention, the error correction is performed by the BICM decoder.

The $1^{st}$ preamble signal corresponds to a P1 symbol, and the $2^{nd}$ preamble signal corresponds to an AP1 symbol.

According to the embodiment of the present invention, the $1^{st}$ preamble signal is detected by performing an inverse modulation process of multiplying the broadcast signal by a $e^{-j2\pi fSHt}$ value, and the $2^{nd}$ preamble signal is detected by performing an inverse modulation process of multiplying the broadcast signal by a $e^{j2\pi f_{SH}t}$ value.

According to the embodiment of the present invention, the signal frame includes at least one or more even index OFDM symbols and at least one or more odd index OFDM symbols. And, the sum of two pilot signals being transmitted from the $1^{st}$ transmission antenna and the $2^{nd}$ transmission antenna is detected from a subcarrier of a pilot position of each even index OFDM symbol of the signal frame. And, the difference between two pilot signals being transmitted from the $1^{st}$ transmission antenna and the $2^{nd}$ transmission antenna is detected from a subcarrier of a pilot position of each odd index OFDM symbol of the signal frame. This corresponds to an exemplary detection that is performed in a case when a pilot signal, which is inserted in accordance with a $9^{th}$ pilot pattern shown in Fig. 47, is received.

According to another embodiment of the present invention, the signal frame includes at least one or more OFDM symbols. And, herein, a sum of two pilot signals being transmitted from the $1^{st}$ and $2^{nd}$ transmission antennae is detected from a subcarrier of at least one pilot signal within each OFDM symbol. And, a difference between two pilot signals being transmitted from the $1^{st}$ and $2^{nd}$ transmission antennae is detected from a subcarrier of at least one other pilot signal. This corresponds to an exemplary detection that is performed in a case when a pilot signal, which is inserted in accordance with a $9^{th}$ pilot pattern shown in Fig. 48, is received.

The present invention will not be limited only to the exemplary embodiments disclosed in the description set forth herein. And, it will be apparent to those skilled in the art that various modifications and variations can be made in the present invention without departing from the scope of the invention. Thus, it is intended that the present invention covers the modifications and variations of this invention provided they come within the scope of the appended claims.

**[Mode for Carrying Out the Present Invention]**

As described above, the present invention is described with respect to the best mode for carrying out the present invention.

**[Industrial Applicability]**

As described above, the present invention may be fully (or entirely) or partially applied to digital broadcasting systems.

## Claims

1. A method for processing a broadcast signal in a transmitter, the method comprising:

   performing Forward Error Correction, FEC, encoding on Physical Layer Pipe, PLP, data;
   performing bit interleaving on the FEC-encoded PLP data;
   performing Multi-input Multi-Output, MIMO, encoding on first data cells and second data cells of the bit-interleaved PLP data;
   time interleaving the MIMO encoded first data cells and the MIMO encoded second data cells;
   building a first frame including the time interleaved first data cells and a second frame including the time interleaved second data cells;
   frequency interleaving the data cells of the first frame and the data cells of the second frame;
   inserting a first symbol and a second symbol at a beginning of the first frame, wherein the first symbol is located before the second symbol in the first frame;
   inserting a first symbol and a second symbol at a beginning of the second frame, wherein the first symbol is located before the second symbol in the second frame,
   wherein the first symbol of the first frame or the second frame includes a front portion, an effective portion, and an end portion, wherein each of the front portion and the end portion is generated by applying a first frequency shift to a part of the effective portion,
   wherein the second symbol of the first frame or the second frame includes a front portion, an effective portion, and an end portion, wherein each of the front portion and the end portion is generated by applying a second frequency shift to a part of the effective portion, and
   wherein a value of the first frequency shift is equal to that of the second frequency shift, but opposite in sign; and
   transmitting a first broadcast signal through at least one of first and second transmission antennae and transmitting a second broadcast signal through at least one of the first and second transmission antennae, the first broadcast signal including the first frame into which the first symbol and the second symbol are inserted and the second broadcast signal including the second frame into which the first symbol and the second symbol are inserted.

2. The method of claim 1, wherein performing FEC encoding on PLP data comprises:

   Bose-Chaudhuri-Hocquengham, BCH, encoding the PLP data; and
   Low Density Parity Check, LDPC, encoding the BCH-encoded PLP data.

3. The method of claim 1, further comprising:

   demultiplexing bits of the bit-interleaved PLP data.

4. An apparatus for processing a broadcast signal, the apparatus comprising:

   means (210050) configured to perform Forward Error Correction, FEC, encoding on Physical Layer Pipe, PLP, data;
   means (210060) configured to perform bit interleaving on the FEC-encoded PLP data;
   means (210090) configured to perform Multi-input Multi-Output, MIMO, encoding on first data cells and second data cells of the bit-interleaved PLP data;
   means (210100) configured to time interleave the MIMO encoded first data cells and the MIMO encoded second data cells;

means (210020, 133200) configured to build a first frame including the time interleaved first data cells and a second frame including the time interleaved second data cells;
means (210020, 133300) configured to frequency interleave the data cells of the first frame and the data cells of the second frame;
means (210040, 302161, 302171) configured to insert a first symbol and a second symbol at a beginning of the first frame, wherein the first symbol is located before the second symbol in the first frame;
means (210040, 302162, 302172) configured to insert a first symbol and a second symbol at a beginning of the second frame, wherein the first symbol is located before the second symbol in the second frame,
wherein the first symbol of the first frame or the second frame includes a front portion, an effective portion, and an end portion, wherein each of the front portion and the end portion is generated by applying a first frequency shift to a part of the effective portion,
wherein the second symbol of the first frame or the second frame includes a front portion, an effective portion, and an end portion, wherein each of the front portion and the end portion is generated by applying a second frequency shift to a part of the effective portion, and
wherein a value of the first frequency shift is equal to that of the second frequency shift, but opposite in sign; and transmitting a first broadcast signal through at least one of first and second transmission antennae and transmitting a second broadcast signal through at least one of the first and second transmission antennae, the first broadcast signal including the first frame into which the first symbol and the second symbol are inserted and the second broadcast signal including the second frame into which the first symbol and the second symbol are inserted.

**5.** The apparatus of claim 4, wherein the means (210050) performs BCH encoding on the PLP data and performs LDPC encoding on the BCH-encoded PLP data.

**6.** The apparatus of claim 4, further comprising:

means (210070) configured to demultiplex bits of the bit-interleaved PLP data.

## Patentansprüche

**1.** Verfahren zum Verarbeiten eines Rundfunksignals in einem Sender, wobei das Verfahren umfasst:

Durchführen einer FEC-Codierung (FEC = Vorwärtsfehlerkorrektur) an PLP-Daten (PLP = Physical Layer Pipe);
Durchführen einer Bitverschachtelung an den FEC-codierten PLP-Daten;
Durchführen einer MIMO-Codierung (MIMO = Multi-Input Multi-Output) an ersten Datenzellen und zweiten Datenzellen der bitverschachtelten PLP-Daten;
Zeitverschachteln der MIMO-codierten ersten Datenzellen und der MIMO-codierten zweiten Datenzellen;
Bilden eines ersten Frames, der die zeitverschachtelten ersten Datenzellen einschließt, und eines zweiten Frames, der die zeitverschachtelten zweiten Datenzellen einschließt;
Frequenzverschachteln der Datenzellen des ersten Frames und der Datenzellen des zweiten Frames;
Einfügen eines ersten Symbols und eines zweiten Symbols an einem Anfang des ersten Frames, wobei sich das erste Symbol vor dem zweiten Symbol in dem ersten Frame befindet;
Einfügen eines ersten Symbols und eines zweiten Symbols an einem Anfang des zweiten Frames, wobei sich das erste Symbol vor dem zweiten Symbol in dem zweiten Frame befindet,
wobei das erste Symbol des ersten Frames oder des zweiten Frames einen Vorderabschnitt, einen effektiven Abschnitt und einen Endabschnitt einschließt, wobei der Vorderabschnitt und der Endabschnitt jeweils durch Anwenden einer ersten Frequenzverschiebung auf einen Teil des effektiven Abschnitts erzeugt werden,
wobei das zweite Symbol des ersten Frames oder des zweiten Frames einen Vorderabschnitt, einen effektiven Abschnitt und einen Endabschnitt einschließt, wobei der Vorderabschnitt und der Endabschnitt jeweils durch Anwenden einer zweiten Frequenzverschiebung auf einen Teil des effektiven Abschnitts erzeugt werden, und
wobei ein Wert der ersten Frequenzverschiebung gleich dem der zweiten Frequenzverschiebung, aber mit entgegengesetztem Vorzeichen, ist; und
Senden eines ersten Rundfunksignals über eine erste oder/und eine zweite Sendeantenne und Senden eines zweiten Rundfunksignals über die erste oder/und die zweite Sendeantenne, wobei das erste Rundfunksignal den ersten Frame, in den das erste Symbol und das zweite Symbol eingefügt sind, einschließt und das zweite Rundfunksignal den zweiten Frame, in den das erste Symbol und das zweite Symbol eingefügt sind, einschließt.

2. Verfahren nach Anspruch 1, wobei das Durchführen der FEC-Codierung an PLP-Daten umfasst:

BCH-Codieren (BCH = Bose-Chaudhuri-Hocquengham) der PLP-Daten; und
LDPC-Codieren (LDPC = Low Density Parity Check) der BCH-codierten PLP-Daten.

3. Verfahren nach Anspruch 1, ferner umfassend:

Demultiplexen von Bits der bitverschachtelten PLP-Daten.

4. Vorrichtung zum Verarbeiten eines Rundfunksignals, wobei die Vorrichtung umfasst:

Mittel (210050), die so konfiguriert sind, dass sie eine FEC-Codierung (FEC = Vorwärtsfehlerkorrektur) an PLP-Daten (PLP = Physical Layer Pipe) durchführen;
Mittel (210060), die so konfiguriert sind, dass sie eine Bitverschachtelung an den FEC-codierten PLP-Daten durchführen;
Mittel (210090), die so konfiguriert sind, dass sie eine MIMO-Codierung (MIMO = Multi-Input Multi-Output) an ersten Datenzellen und zweiten Datenzellen der bitverschachtelten PLP-Daten durchführen;
Mittel (210100), die so konfiguriert sind, dass sie die MIMO-codierten ersten Datenzellen und die MIMO-codierten zweiten Datenzellen zeitverschachteln;
Mittel (210020, 133200), die so konfiguriert sind, dass sie einen ersten Frame, der die zeitverschachtelten ersten Datenzellen einschließt, und einen zweiten Frame, der die zeitverschachtelten zweiten Datenzellen einschließt, bilden;
Mittel (210020, 133300), die so konfiguriert sind, dass sie die Datenzellen des ersten Frames und die Datenzellen des zweiten Frames frequenzverschachteln;
Mittel (210040, 302161, 302171), die so konfiguriert sind, dass sie ein erstes Symbol und ein zweites Symbol an einem Anfang des ersten Frames einfügen, wobei sich das erste Symbol vor dem zweiten Symbol in dem ersten Frame befindet;
Mittel (210040, 302162, 302172), die so konfiguriert sind, dass sie ein erstes Symbol und ein zweites Symbol an einem Anfang des zweiten Frames einfügen, wobei sich das erste Symbol vor dem zweiten Symbol in dem zweiten Frame befindet;
wobei das erste Symbol des ersten Frames oder des zweiten Frames einen Vorderabschnitt, einen effektiven Abschnitt und einen Endabschnitt einschließt, wobei der Vorderabschnitt und der Endabschnitt jeweils durch Anwenden einer ersten Frequenzverschiebung auf einen Teil des effektiven Abschnitts erzeugt werden,
wobei das zweite Symbol des ersten Frames oder des zweiten Frames einen Vorderabschnitt, einen effektiven Abschnitt und einen Endabschnitt einschließt, wobei der Vorderabschnitt und der Endabschnitt jeweils durch Anwenden einer zweiten Frequenzverschiebung auf einen Teil des effektiven Abschnitts erzeugt werden, und wobei ein Wert der ersten Frequenzverschiebung gleich dem der zweiten Frequenzverschiebung, aber mit entgegengesetztem Vorzeichen, ist; und
Senden eines ersten Rundfunksignals über eine erste oder/und eine zweite Sendeantenne und Senden eines zweiten Rundfunksignals über die erste oder/und die zweite Sendeantenne, wobei das erste Rundfunksignal den ersten Frame, in den das erste Symbol und das zweite Symbol eingefügt sind, einschließt und das zweite Rundfunksignal den zweiten Frame, in den das erste Symbol und das zweite Symbol eingefügt sind, einschließt.

5. Vorrichtung nach Anspruch 4, wobei das Mittel (210050) eine BCH-Codierung an den PLP-Daten durchführt und eine LDPC-Codierung an den BCH-codierten PLP-Daten durchführt.

6. Vorrichtung nach Anspruch 4, ferner umfassend:

Mittel (210070), die so konfiguriert sind, dass sie Bits der bitverschachtelten PLP-Daten demultiplexen.

## Revendications

1. Procédé pour le traitement d’un signal de diffusion dans un émetteur, le procédé comprenant :

l’exécution d’un codage de correction d’erreurs sans voie de retour, FEC, sur des données de pipeline de couche physique, PLP ;
l’exécution d’un entrelacement de bits sur les données PLP codées FEC ;

l'exécution d'un codage à entrées multiples et sorties multiples, MIMO, sur des premières cellules de données et des deuxièmes cellules de données des données PLP à bits entrelacés ;
l'entrelacement temporel des premières cellules de données codées MIMO et des deuxièmes cellules de données codées MIMO ;
la construction d'une première trame comprenant les premières cellules de données entrelacées temporellement et d'une deuxième trame comprenant les deuxièmes cellules de données entrelacées temporellement ;
l'entrelacement fréquentiel des cellules de données de la première trame et des cellules de données de la deuxième trame ;
l'insertion d'un premier symbole et d'un deuxième symbole à un début de la première trame, dans lequel le premier symbole est situé avant le deuxième symbole dans la première trame ;
l'insertion d'un premier symbole et d'un deuxième symbole à un début de la deuxième trame, dans lequel le premier symbole est situé avant le deuxième symbole dans la deuxième trame,
dans lequel le premier symbole de la première trame ou de la deuxième trame comprend une portion frontale, une portion effective et une portion terminale, dans lequel chacune de la portion frontale et de la portion terminale est générée en appliquant un premier décalage de fréquence à une partie de la portion effective,
dans lequel le deuxième symbole de la première trame ou de la deuxième trame comprend une portion frontale, une portion effective et une portion terminale, dans lequel chacune de la portion frontale et de la portion terminale est générée en appliquant un deuxième décalage de fréquence à une partie de la portion effective, et dans lequel une valeur du premier décalage de fréquence est égale à celle du deuxième décalage de fréquence, mais de signe opposé ; et
la transmission d'un premier signal de diffusion par le biais d'au moins une parmi des première et deuxième antennes de transmission et la transmission d'un deuxième signal de diffusion par le biais d'au moins une parmi les première et deuxième antennes de transmission, le premier signal de diffusion comprenant la première trame dans laquelle le premier symbole et le deuxième symbole sont insérés et le deuxième signal de diffusion comprenant la deuxième trame dans laquelle le premier symbole et le deuxième symbole sont insérés.

**2.** Procédé selon la revendication 1, dans lequel l'exécution du codage FEC sur des données PLP comprend :

le codage de Bose-Chaudhuri-Hocquengham, BCH, des données PLP ; et
le codage de contrôle de parité à faible densité, LDPC, des données PLP codées BCH.

**3.** Procédé selon la revendication 1, comprenant en outre :

le démultiplexage de bits des données PLP à bits entrelacées.

**4.** Appareil pour le traitement d'un signal de diffusion, le procédé comprenant :

des moyens (210050) configurés pour effectuer un codage de correction d'erreurs sans voie de retour, FEC, sur des données de pipeline de couche physique, PLP ;
des moyens (210060) configurés pour effectuer un entrelacement de bits sur les données PLP codées FEC ;
des moyens (210090) configurés pour effectuer un codage à entrées multiples et sorties multiples, MIMO, sur des premières cellules de données et des deuxièmes cellules de données des données PLP à bits entrelacés ;
des moyens (210100) configurés pour effectuer l'entrelacement temporel des premières cellules de données codées MIMO et des deuxièmes cellules de données codées MIMO ;
des moyens (210020, 133200) configurés pour construire une première trame comprenant les premières cellules de données entrelacées temporellement et une deuxième trame comprenant les deuxièmes cellules de données entrelacées temporellement ;
des moyens (210020, 133300) configurés pour effectuer l'entrelacement fréquentiel des cellules de données de la première trame et des cellules de données de la deuxième trame ;
des moyens (210040, 302161, 302171) configurés pour insérer un premier symbole et un deuxième symbole à un début de la première trame, dans lequel le premier symbole est situé avant le deuxième symbole dans la première trame ;
des moyens (210040, 302162, 302172) configurés pour insérer un premier symbole et un deuxième symbole à un début de la deuxième trame, dans lequel le premier symbole est situé avant le deuxième symbole dans la deuxième trame,
dans lequel le premier symbole de la première trame ou de la deuxième trame comprend une portion frontale, une portion effective et une portion terminale, dans lequel chacune de la portion frontale et de la portion terminale est générée en appliquant un premier décalage de fréquence à une partie de la portion effective,

dans lequel le deuxième symbole de la première trame ou de la deuxième trame comprend une portion frontale, une portion effective et une portion terminale, dans lequel chacune de la portion frontale et de la portion terminale est générée en appliquant un deuxième décalage de fréquence à une partie de la portion effective, et dans lequel une valeur du premier décalage de fréquence est égale à celle du deuxième décalage de fréquence, mais de signe opposé ; et
la transmission d'un premier signal de diffusion par le biais d'au moins une parmi des première et deuxième antennes de transmission et la transmission d'un deuxième signal de diffusion par le biais d'au moins une parmi les première et deuxième antennes de transmission, le premier signal de diffusion comprenant la première trame dans laquelle le premier symbole et le deuxième symbole sont insérés et le deuxième signal de diffusion comprenant la deuxième trame dans laquelle le premier symbole et le deuxième symbole sont insérés.

**5.** Appareil selon la revendication 4, dans lequel les moyens (210050) effectuent un codage BCH sur les données PLP et effectuent un codage LDPC sur les données PLP codées BCH.

**6.** Appareil selon la revendication 4, comprenant en outre :

des moyens (210070) configurés pour démultiplexer des bits des données PLP à bits entrelacés.

FIG. 1

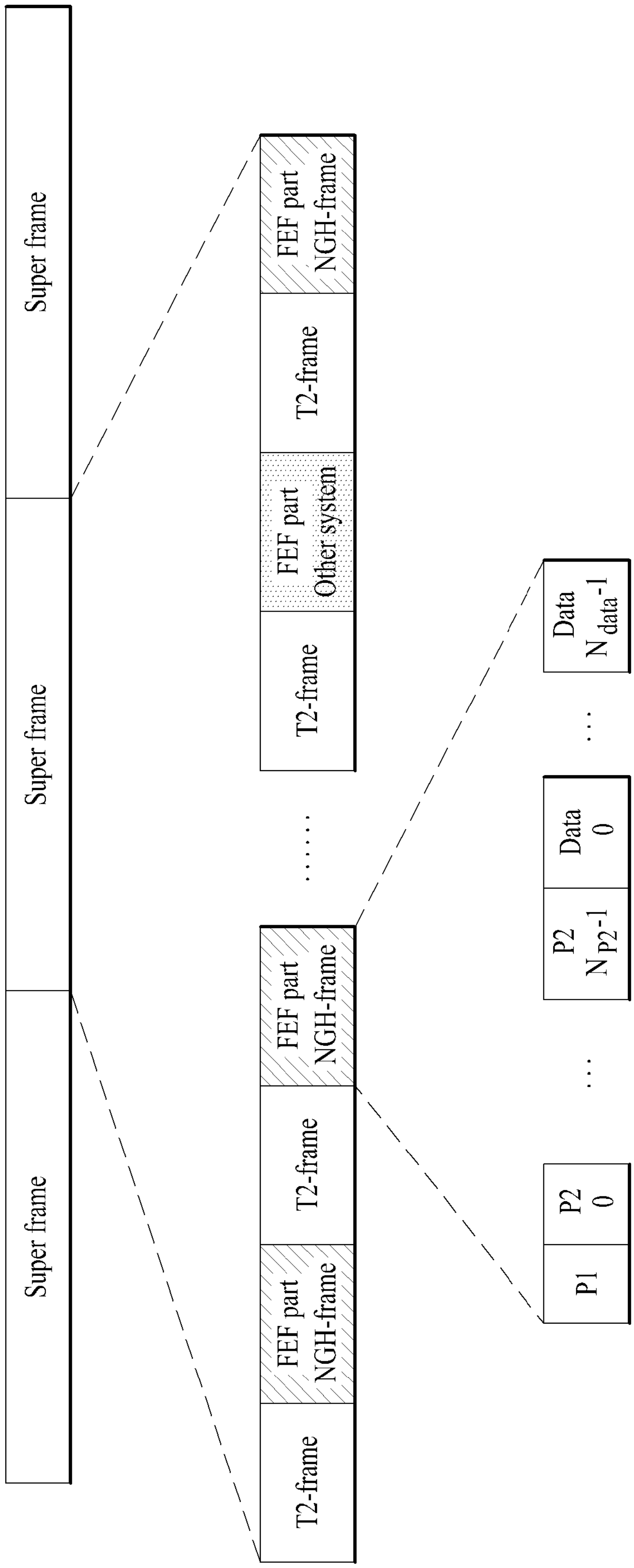
Super frame
Super frame
Super frame
T2-frame
FEF part NGH-frame
T2-frame
FEF part NGH-frame
......
T2-frame
FEF part Other system
T2-frame
FEF part NGH-frame
P1
P2 0
...
P2 $N_{P2}$-1
Data 0
...
Data $N_{data}$-1

FIG. 2

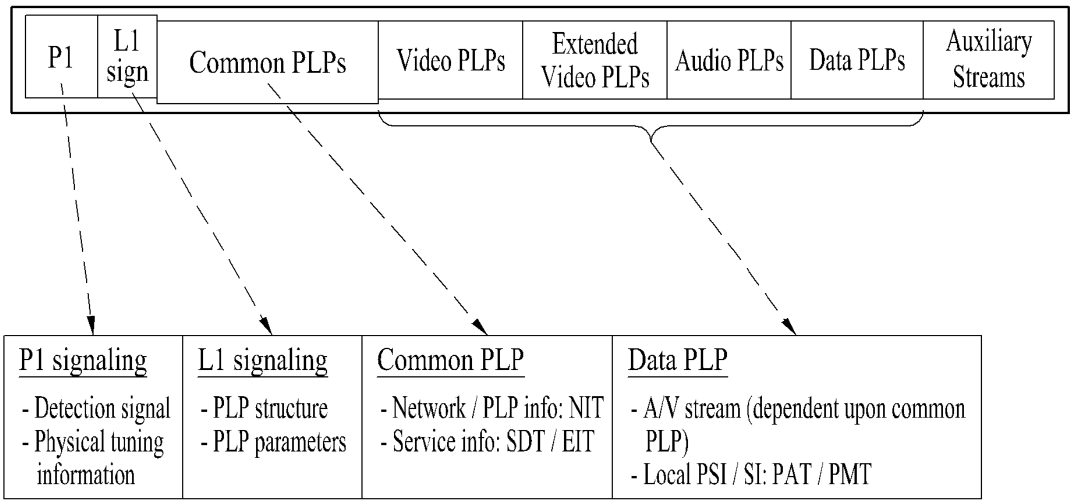


FIG. 3

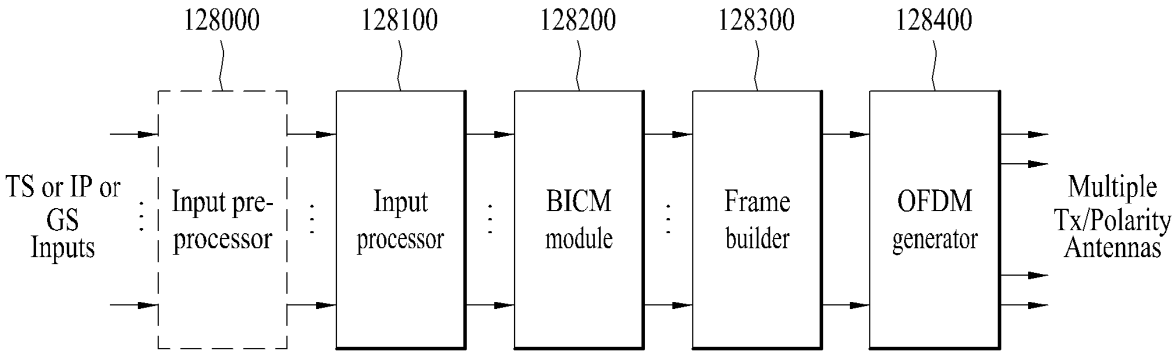


FIG. 4

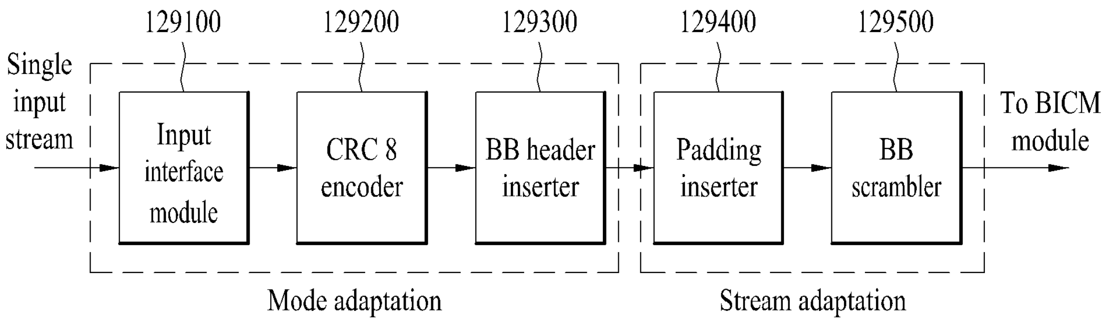

FIG. 5

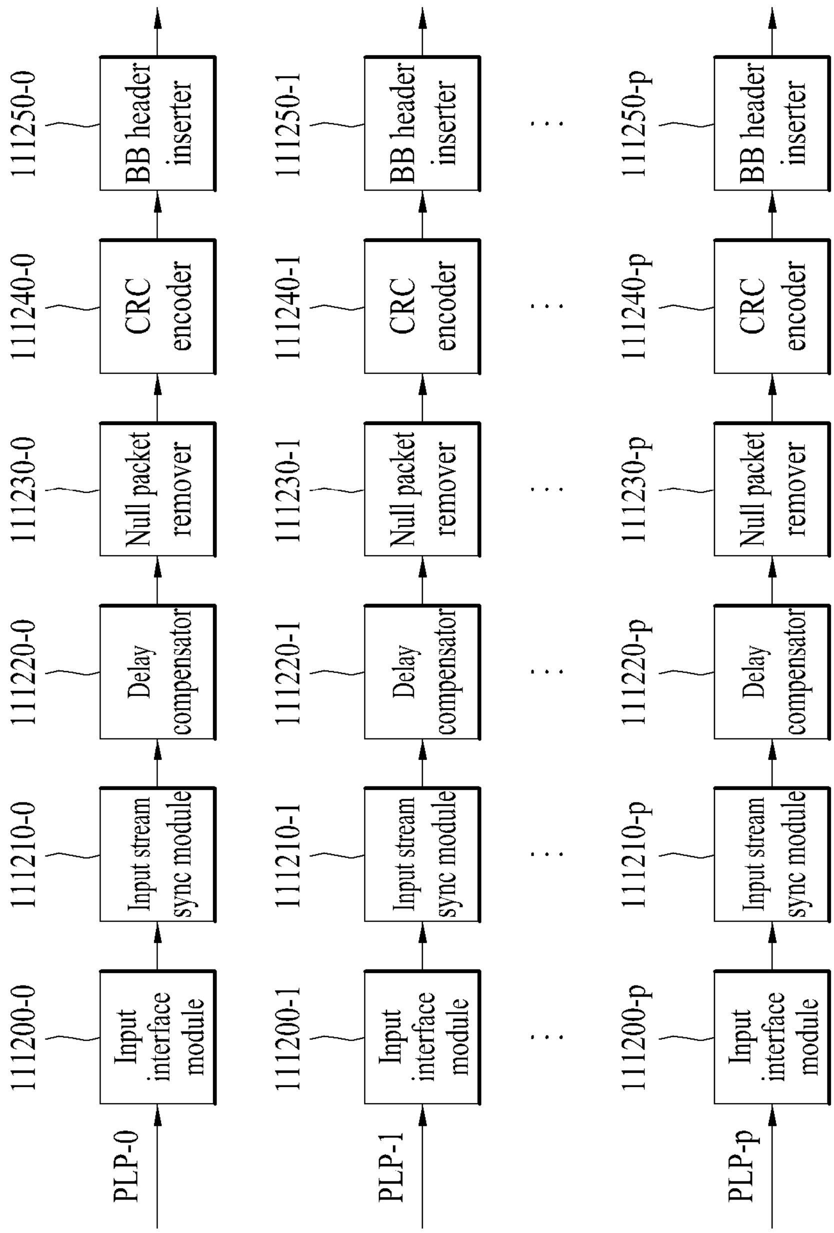

PLP-0
PLP-1
PLP-p
111200-0
111200-1
111200-p
Input interface module
111210-0
111210-1
111210-p
Input stream sync module
111220-0
111220-1
111220-p
Delay compensator
111230-0
111230-1
111230-p
Null packet remover
111240-0
111240-1
111240-p
CRC encoder
111250-0
111250-1
111250-p
BB header inserter

FIG. 6

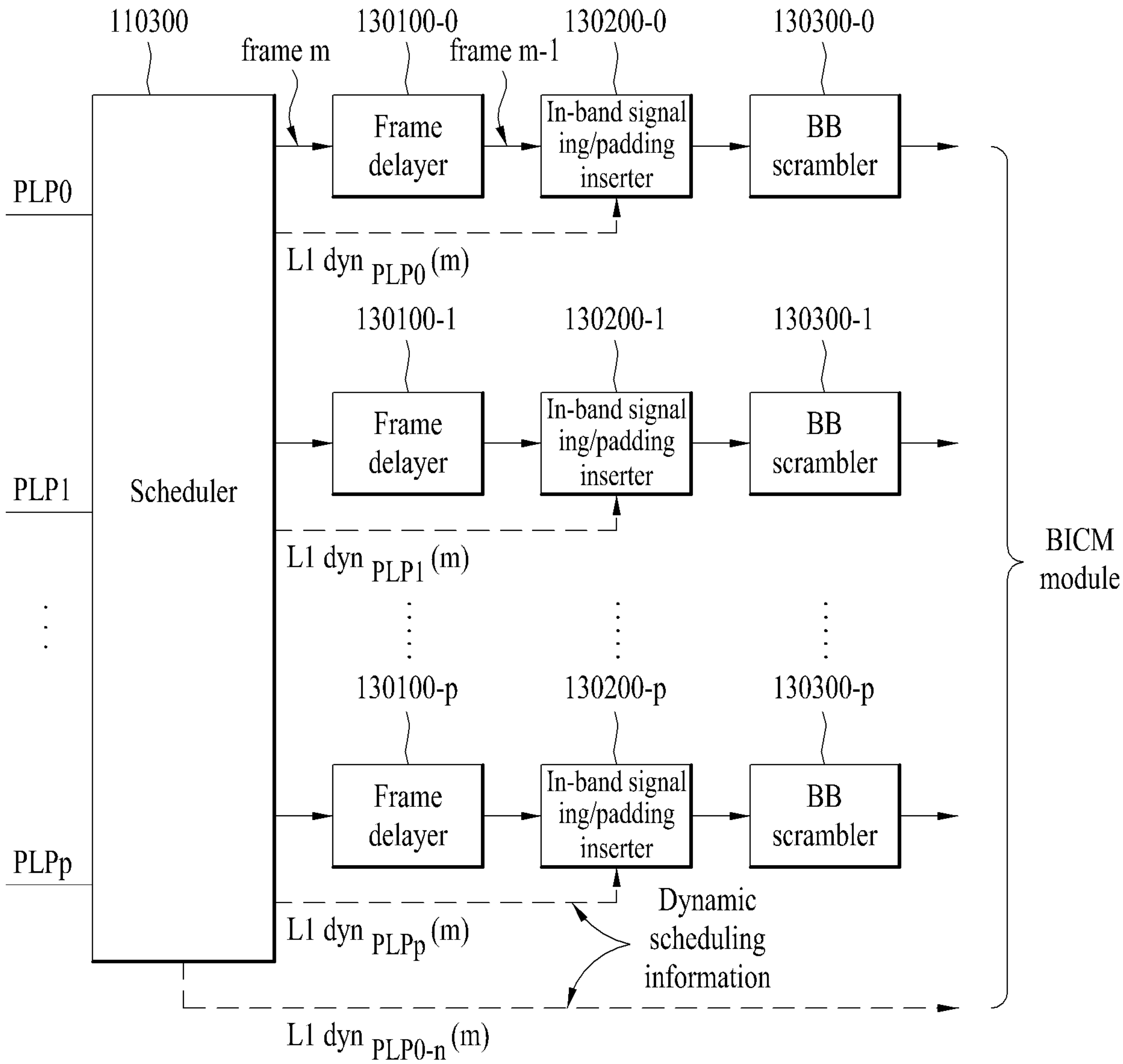
110300
frame m
130100-0
frame m-1
130200-0
130300-0
Frame delayer
In-band signal ing/padding inserter
BB scrambler
PLP0
L1 dyn PLP0 (m)
130100-1
130200-1
130300-1
Frame delayer
In-band signal ing/padding inserter
BB scrambler
PLP1
Scheduler
L1 dyn PLP1 (m)
BICM module
130100-p
130200-p
130300-p
Frame delayer
In-band signal ing/padding inserter
BB scrambler
PLPp
Dynamic scheduling information
L1 dyn PLPp (m)
L1 dyn PLP0-n (m)

FIG. 7

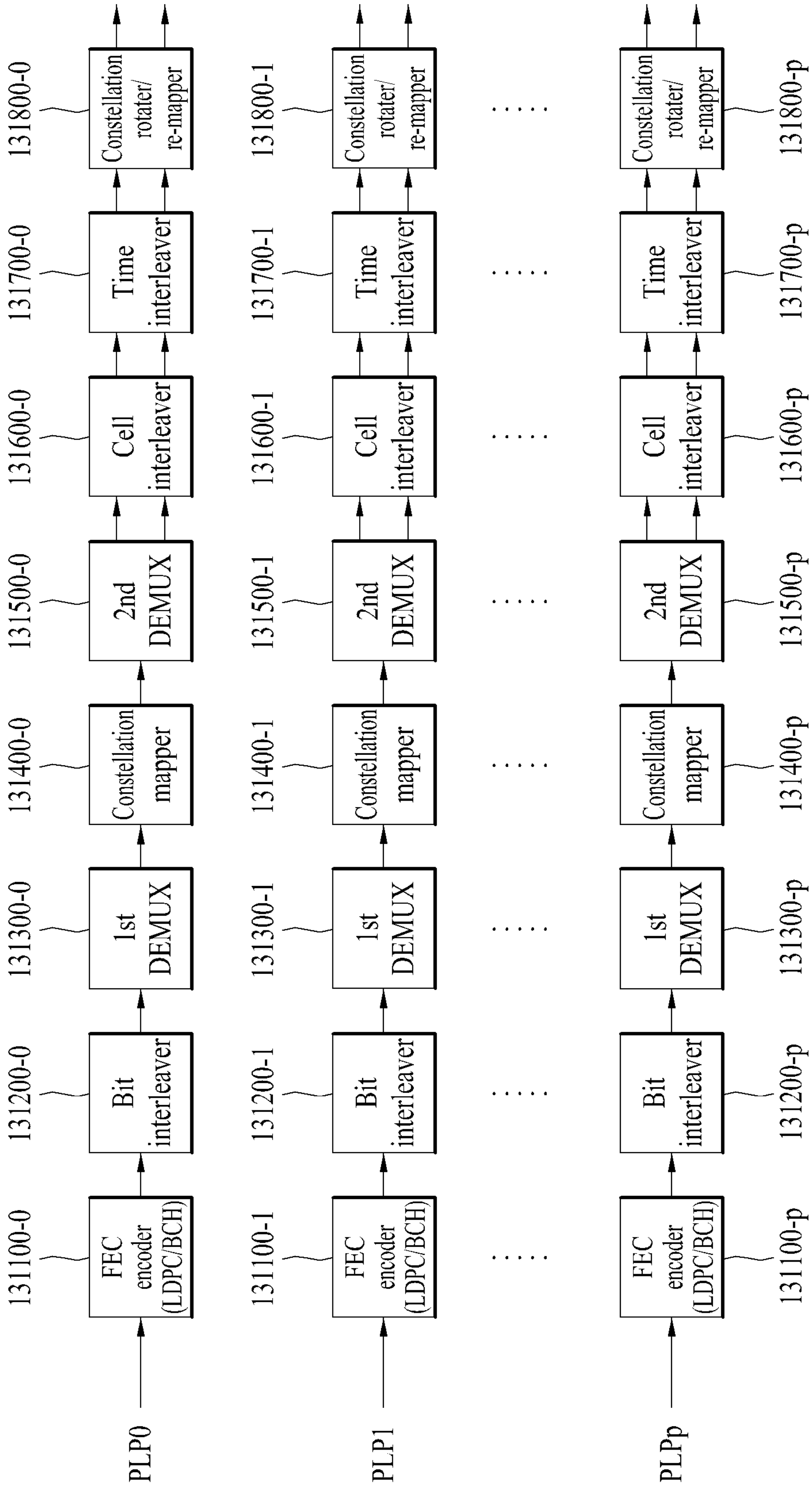
PLP0
PLP1
PLPp
FEC encoder (LDPC/BCH)
Bit interleaver
1st DEMUX
Constellation mapper
2nd DEMUX
Cell interleaver
Time interleaver
Constellation rotater/ re-mapper
131100-0
131200-0
131300-0
131400-0
131500-0
131600-0
131700-0
131800-0
131100-1
131200-1
131300-1
131400-1
131500-1
131600-1
131700-1
131800-1
131100-p
131200-p
131300-p
131400-p
131500-p
131600-p
131700-p
131800-p

FIG. 8

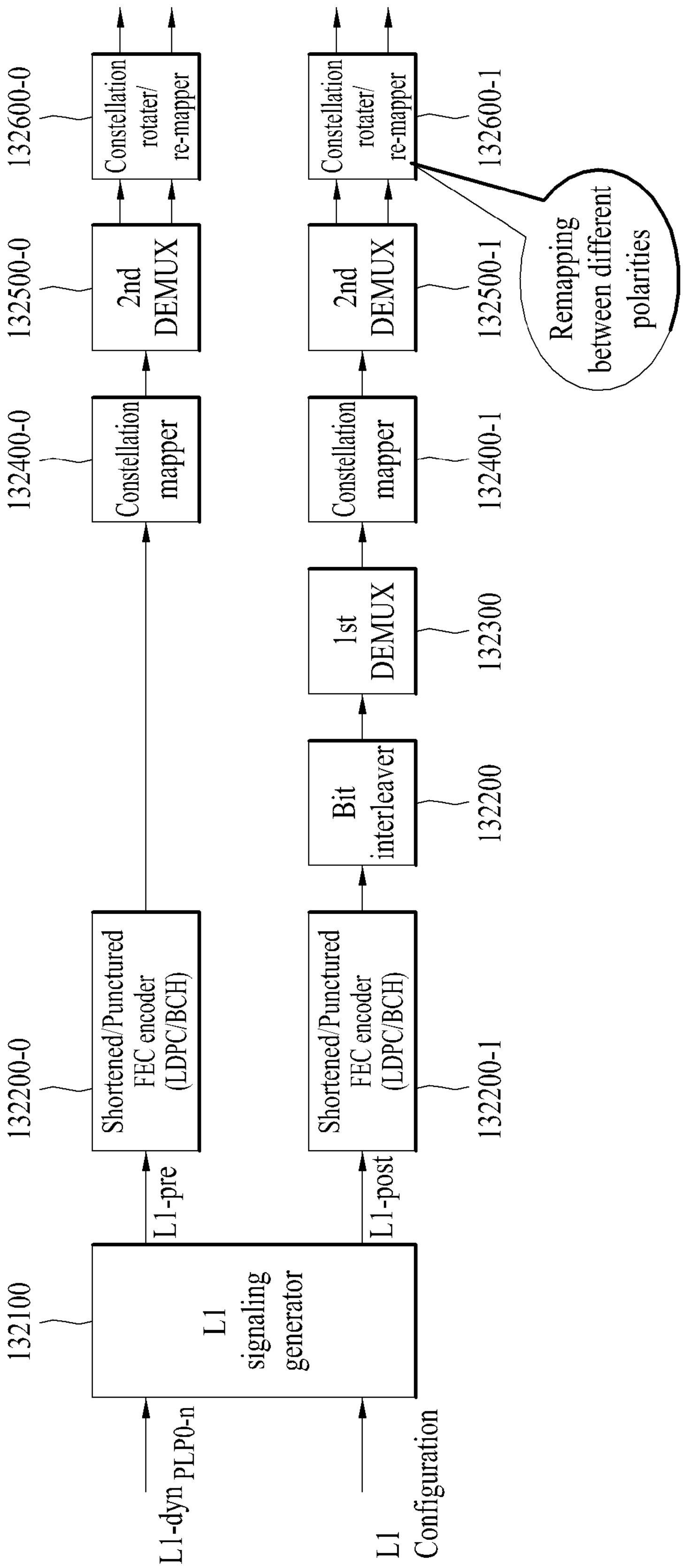
L1-dyn PLP0-n
L1 Configuration
132100
L1 signaling generator
L1-pre
L1-post
132200-0
Shortened/Punctured FEC encoder (LDPC/BCH)
132200-1
Shortened/Punctured FEC encoder (LDPC/BCH)
132200
Bit interleaver
132300
1st DEMUX
132400-0
Constellation mapper
132400-1
Constellation mapper
132500-0
2nd DEMUX
132500-1
2nd DEMUX
132600-0
Constellation rotater/ re-mapper
132600-1
Constellation rotater/ re-mapper
Remapping between different polarities

FIG. 9

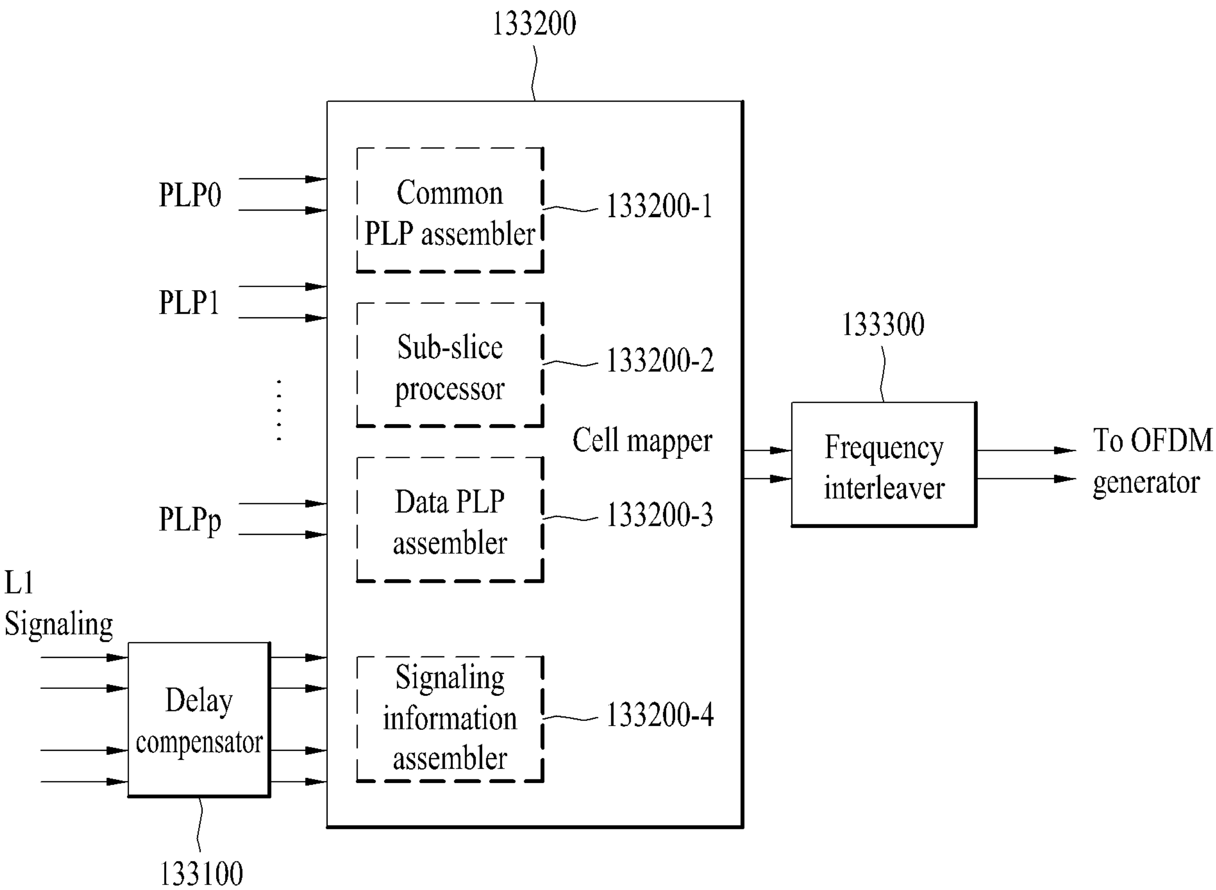
133200
PLP0
Common
PLP assembler
133200-1
PLP1
Sub-slice
processor
133200-2
133300
Cell mapper
Frequency
interleaver
To OFDM
generator
PLPp
Data PLP
assembler
133200-3
L1
Signaling
Delay
compensator
Signaling
information
assembler
133200-4
133100

FIG. 10

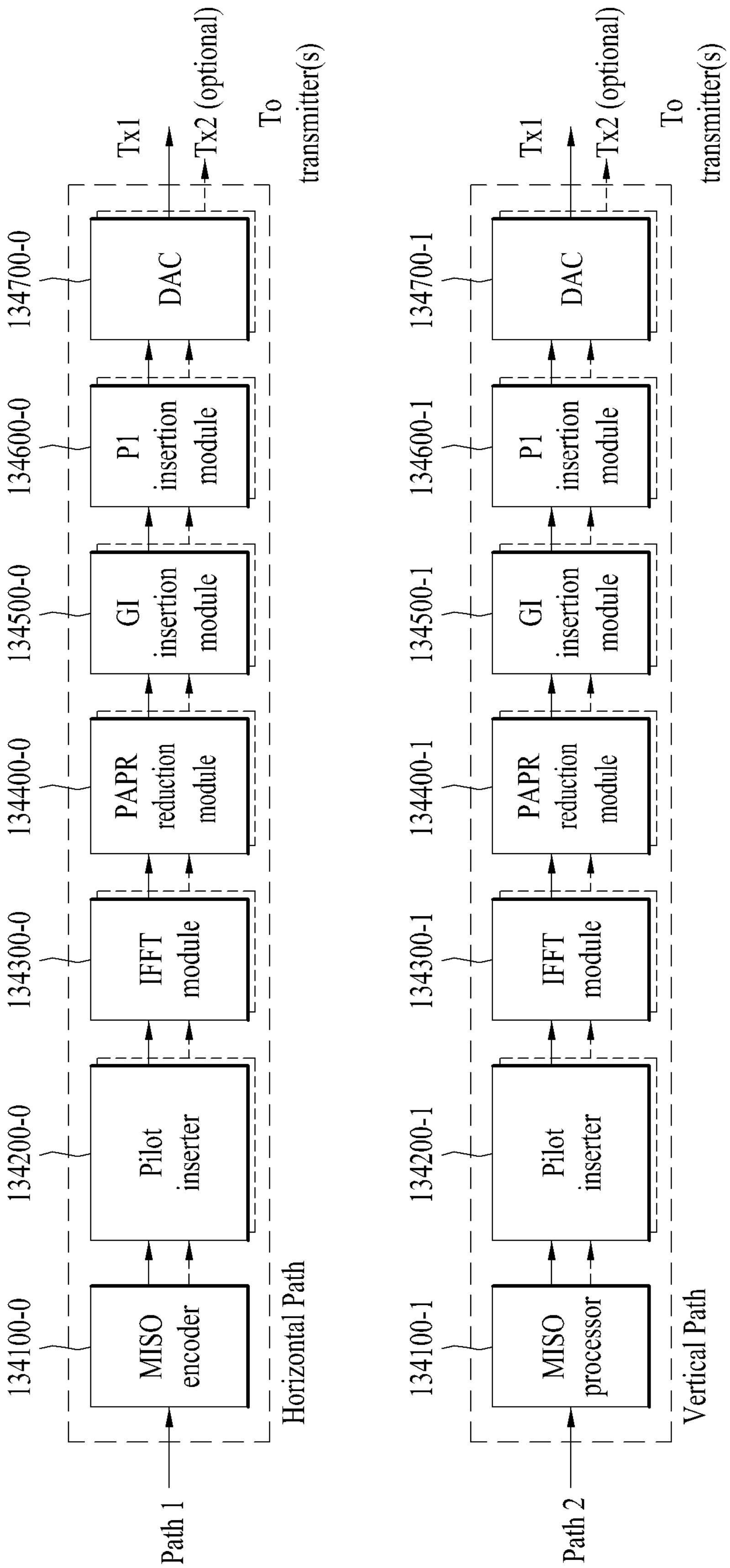
Path 1
134100-0
MISO encoder
134200-0
Pilot inserter
134300-0
IFFT module
134400-0
PAPR reduction module
134500-0
GI insertion module
134600-0
P1 insertion module
134700-0
DAC
Tx1
Tx2 (optional)
To transmitter(s)
Horizontal Path
Path 2
134100-1
MISO processor
134200-1
Pilot inserter
134300-1
IFFT module
134400-1
PAPR reduction module
134500-1
GI insertion module
134600-1
P1 insertion module
134700-1
DAC
Tx1
Tx2 (optional)
To transmitter(s)
Vertical Path

FIG. 11

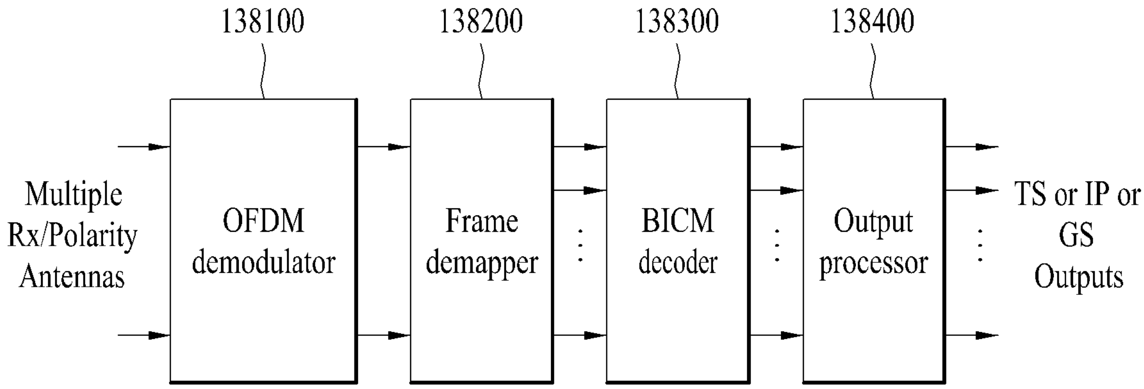
138100
138200
138300
138400
Multiple Rx/Polarity Antennas
OFDM demodulator
Frame demapper
BICM decoder
Output processor
TS or IP or GS Outputs

FIG. 12

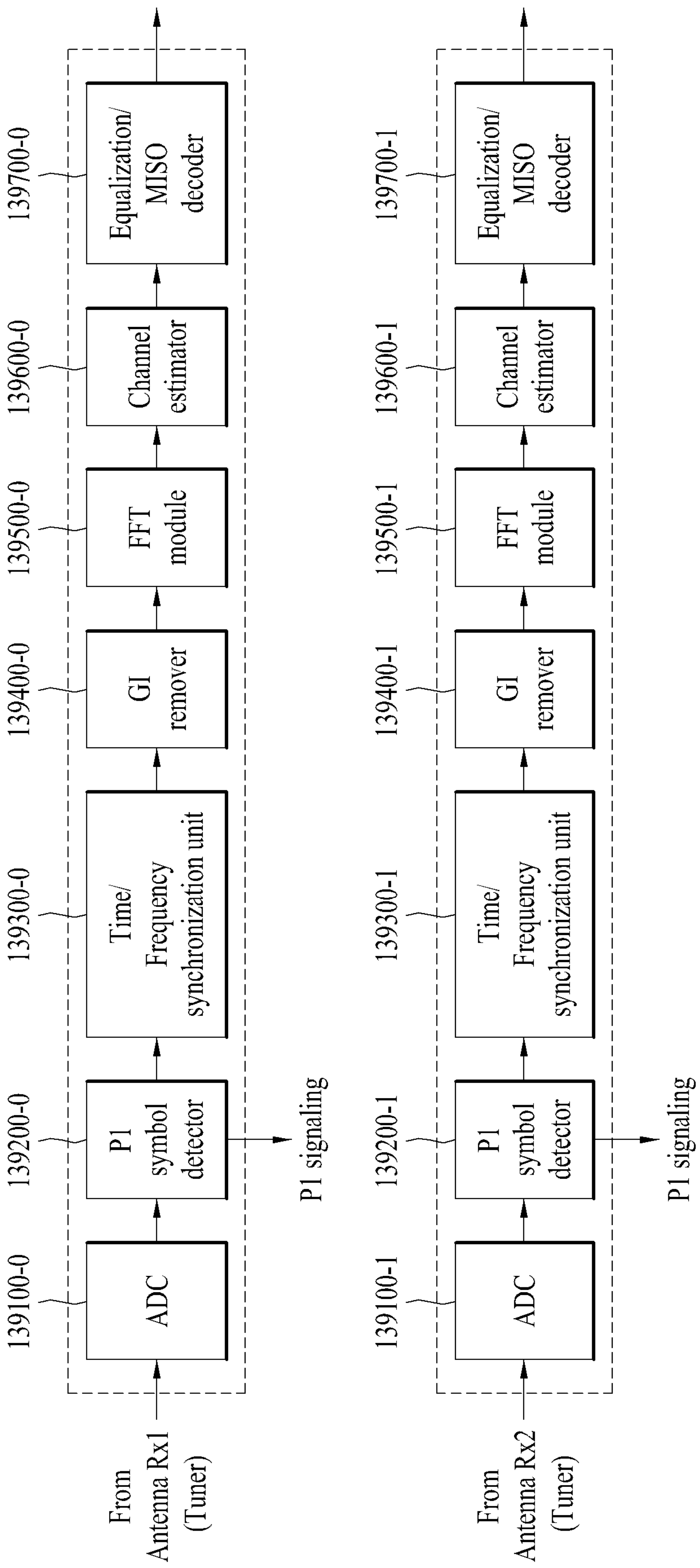
From
Antenna Rx1
(Tuner)
139100-0
ADC
139200-0
P1
symbol
detector
P1 signaling
139300-0
Time/
Frequency
synchronization unit
139400-0
GI
remover
139500-0
FFT
module
139600-0
Channel
estimator
139700-0
Equalization/
MISO
decoder
From
Antenna Rx2
(Tuner)
139100-1
ADC
139200-1
P1
symbol
detector
P1 signaling
139300-1
Time/
Frequency
synchronization unit
139400-1
GI
remover
139500-1
FFT
module
139600-1
Channel
estimator
139700-1
Equalization/
MISO
decoder

FIG. 13

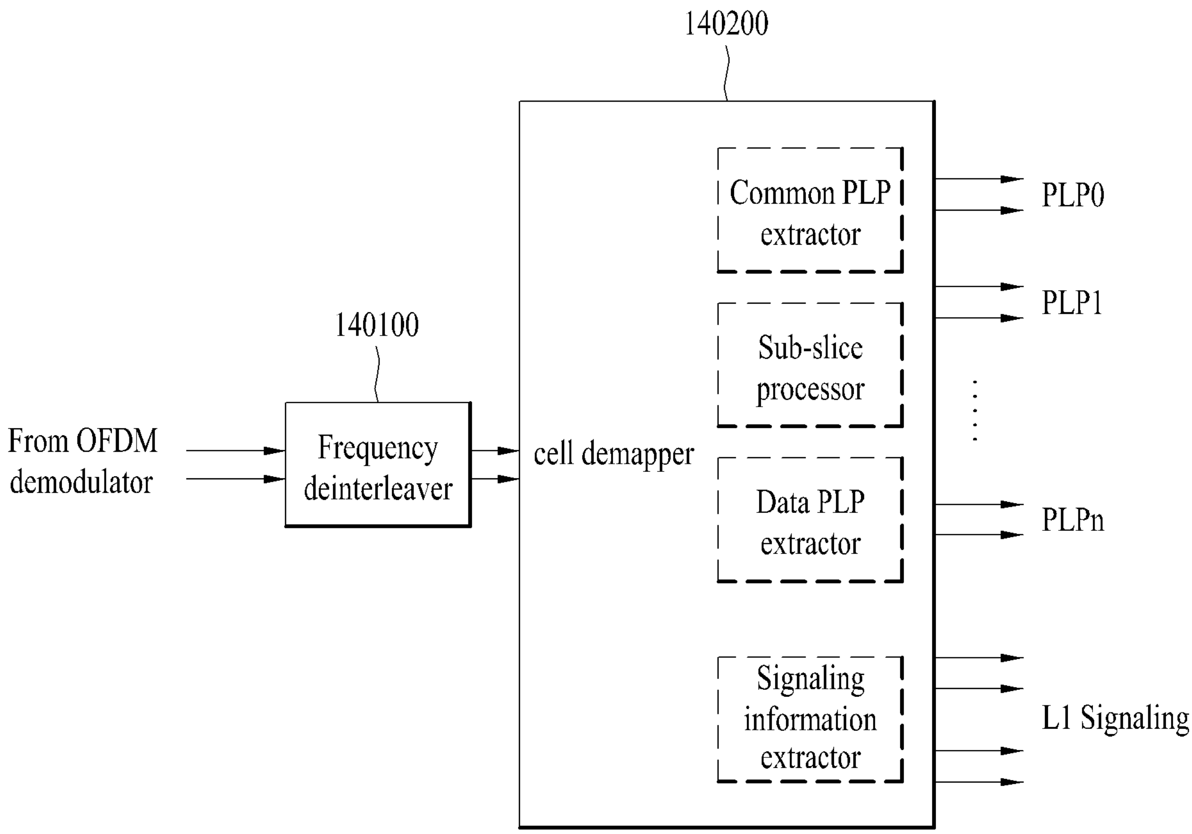
140200
140100
From OFDM demodulator
Frequency deinterleaver
cell demapper
Common PLP extractor
Sub-slice processor
Data PLP extractor
Signaling information extractor
PLP0
PLP1
PLPn
L1 Signaling

FIG. 14

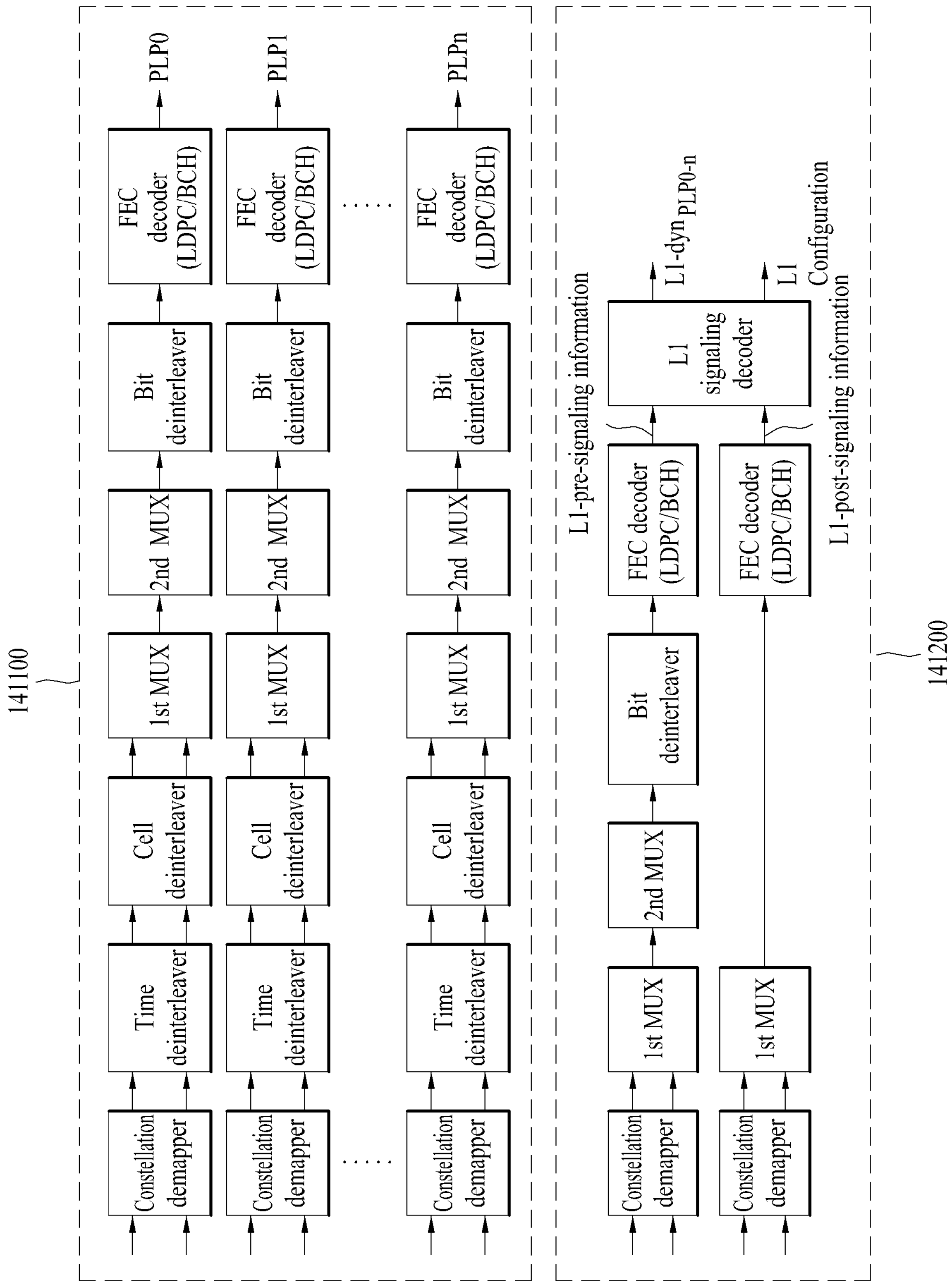
141100
Constellation demapper
Time deinterleaver
Cell deinterleaver
1st MUX
2nd MUX
Bit deinterleaver
FEC decoder (LDPC/BCH)
PLP0
PLP1
PLPn
141200
L1-pre-signaling information
L1-post-signaling information
L1 signaling decoder
L1-dyn PLP0-n
L1 Configuration

FIG. 15

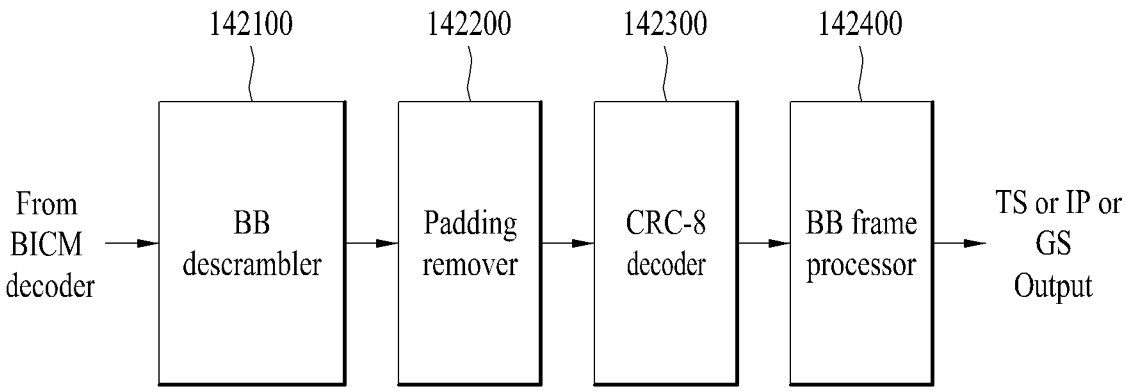
142100
142200
142300
142400
From BICM decoder
BB descrambler
Padding remover
CRC-8 decoder
BB frame processor
TS or IP or GS Output

FIG. 16

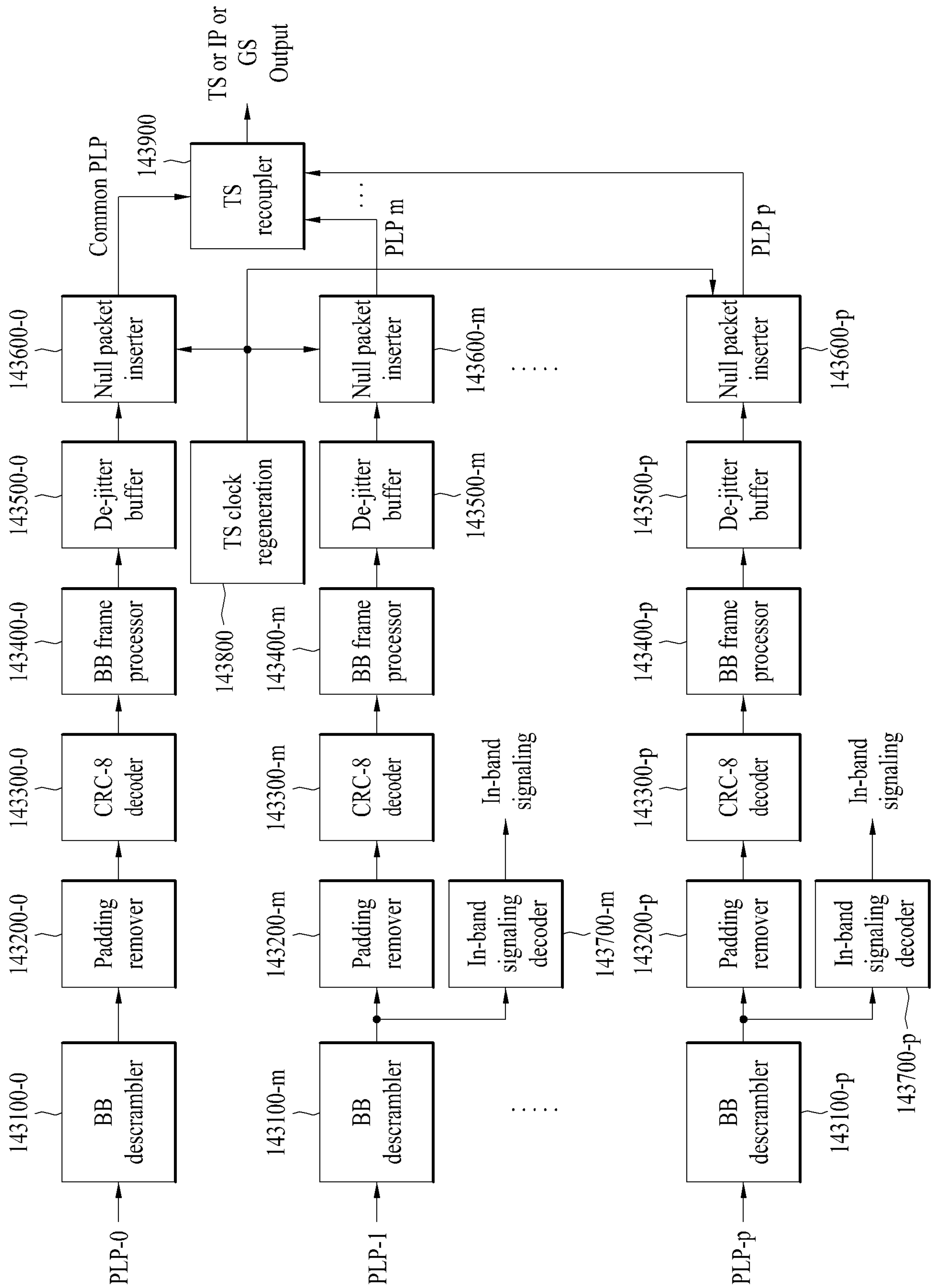
PLP-0
BB descrambler
143100-0
Padding remover
143200-0
CRC-8 decoder
143300-0
BB frame processor
143400-0
De-jitter buffer
143500-0
Null packet inserter
143600-0
Common PLP
TS recoupler
143900
TS or IP or GS Output
TS clock regeneration
143800
PLP-1
BB descrambler
143100-m
Padding remover
143200-m
In-band signaling decoder
143700-m
In-band signaling
CRC-8 decoder
143300-m
BB frame processor
143400-m
De-jitter buffer
143500-m
Null packet inserter
143600-m
PLP m
.....
PLP-p
BB descrambler
143100-p
Padding remover
143200-p
In-band signaling decoder
143700-p
In-band signaling
CRC-8 decoder
143300-p
BB frame processor
143400-p
De-jitter buffer
143500-p
Null packet inserter
143600-p
PLP p

FIG. 17

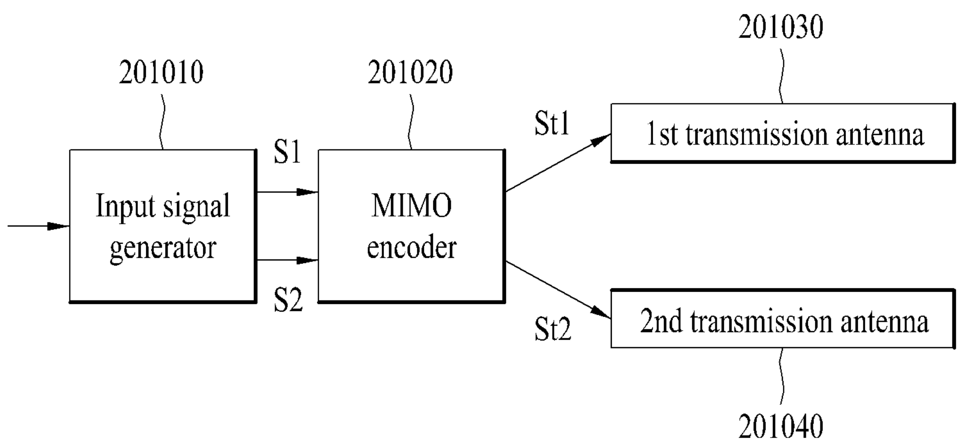
201030
201010
201020
St1
1st transmission antenna
S1
Input signal generator
MIMO encoder
S2
St2
2nd transmission antenna
201040

FIG. 18

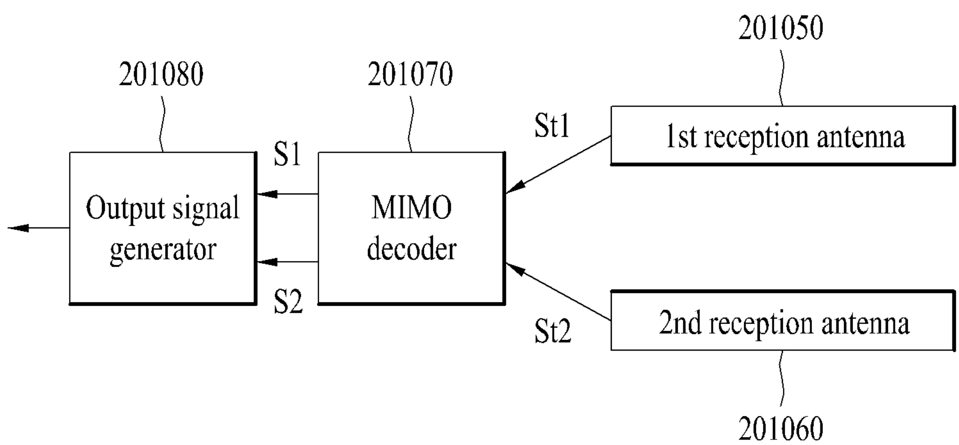
201050
201080
201070
St1
1st reception antenna
S1
Output signal generator
MIMO decoder
S2
St2
2nd reception antenna
201060

FIG. 19

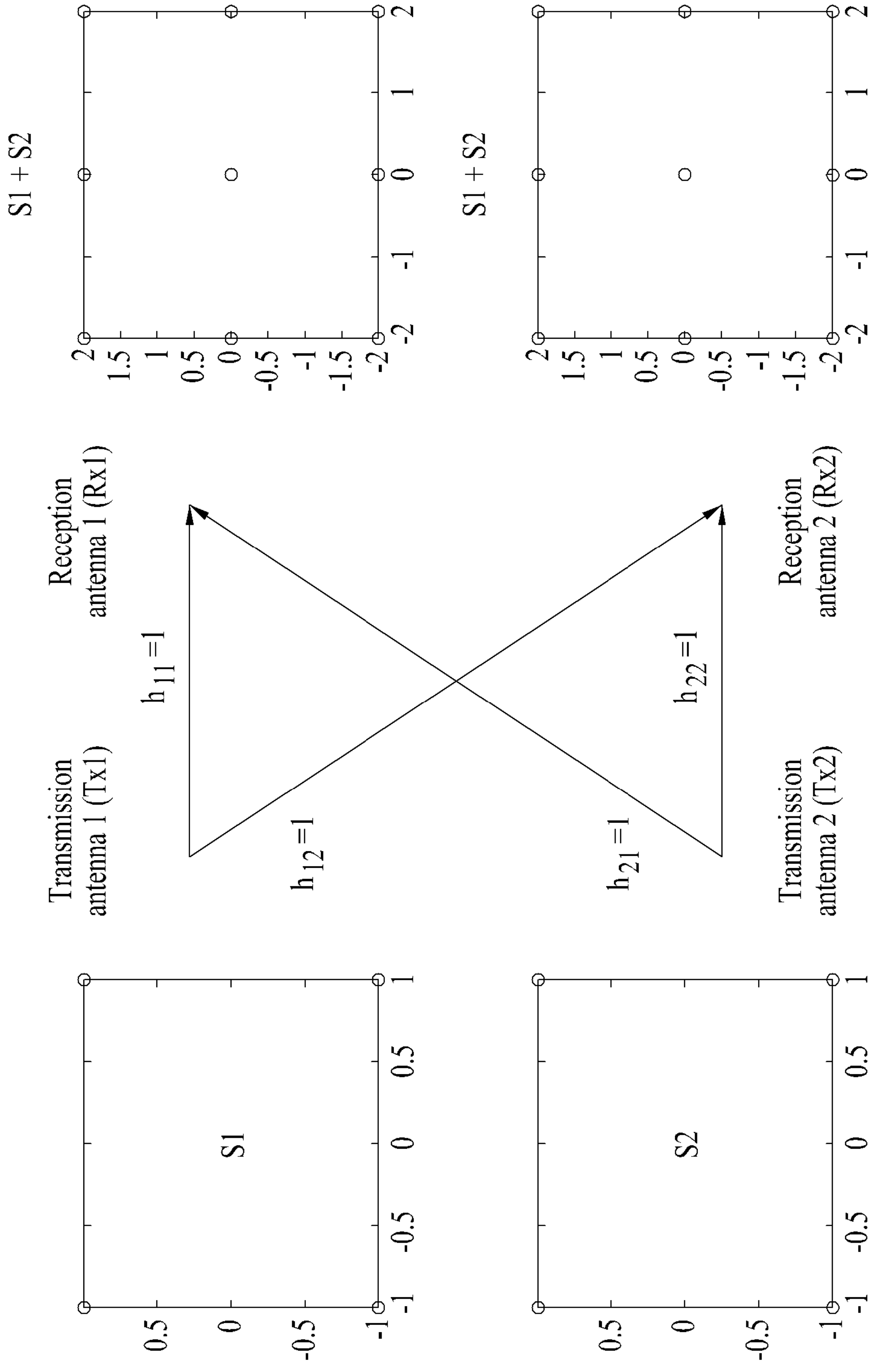
S1
S2
Transmission antenna 1 (Tx1)
Transmission antenna 2 (Tx2)
Reception antenna 1 (Rx1)
Reception antenna 2 (Rx2)
h11=1
h12=1
h21=1
h22=1
S1 + S2
S1 + S2

FIG. 20

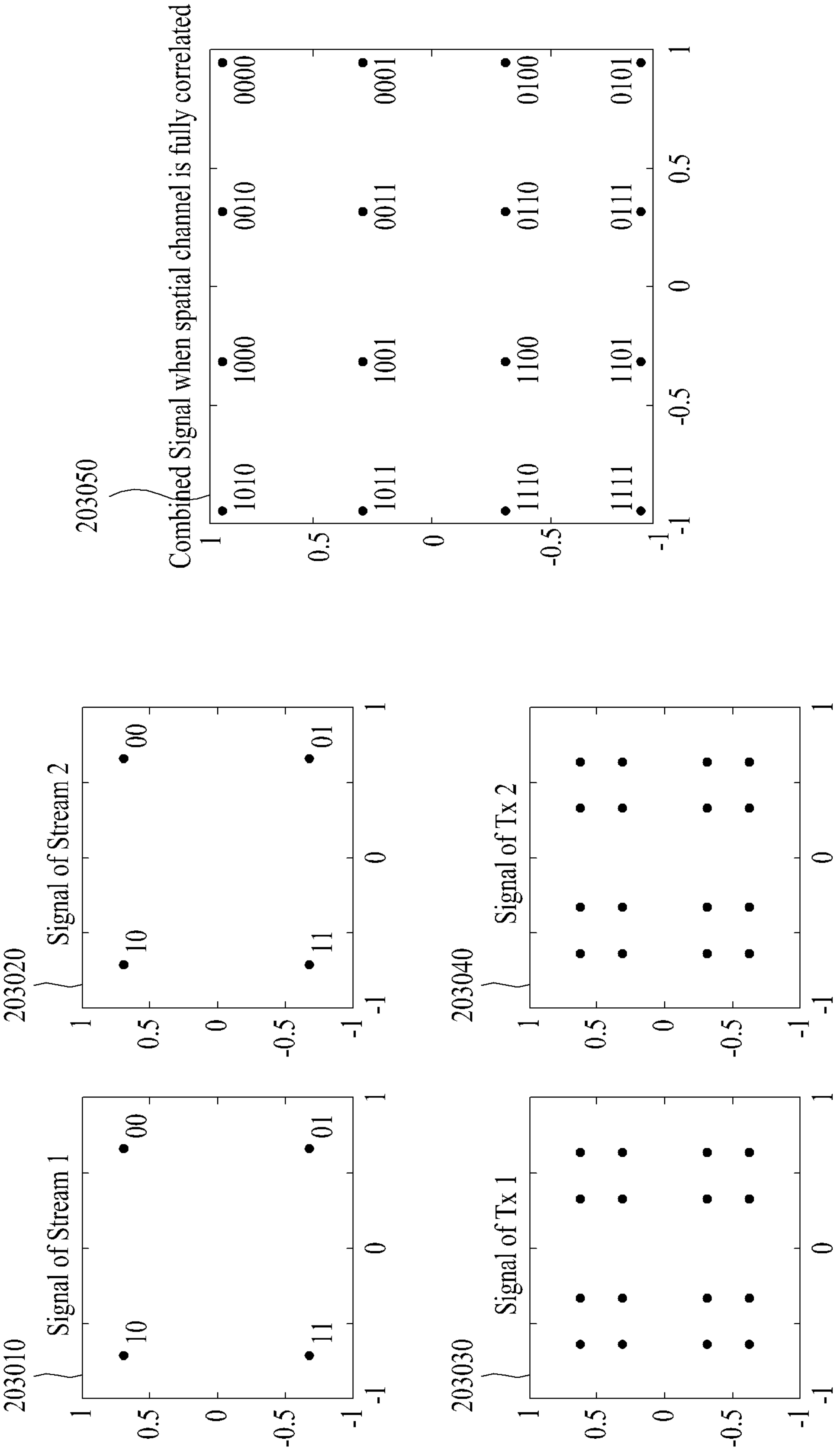
203010
Signal of Stream 1
00
01
10
11
203020
Signal of Stream 2
00
01
10
11
203030
Signal of Tx 1
203040
Signal of Tx 2
203050
Combined Signal when spatial channel is fully correlated
0000
0001
0100
0101
0010
0011
0110
0111
1000
1001
1100
1101
1010
1011
1110
1111
1
0.5
0
-0.5
-1

FIG. 21

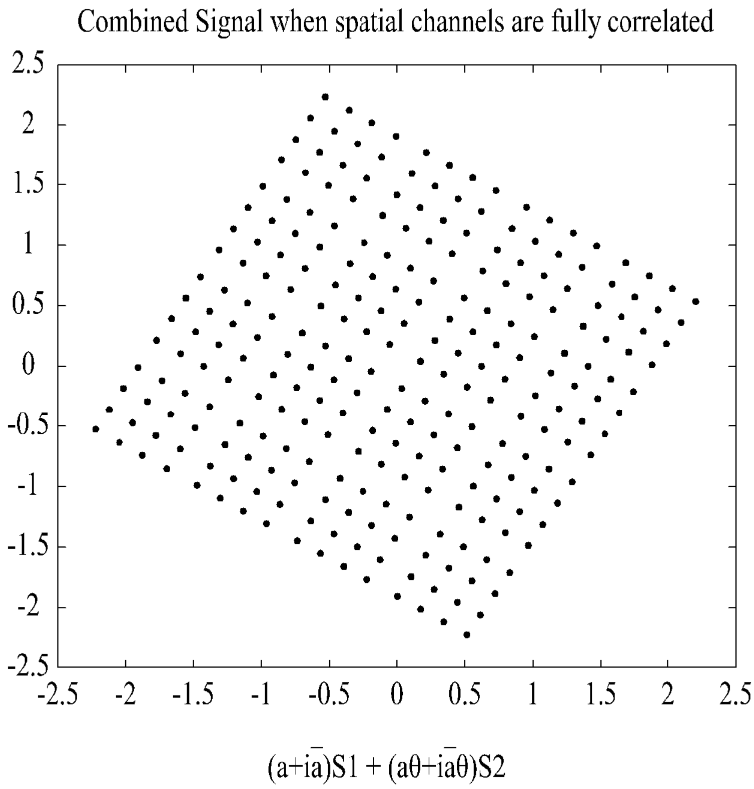
Combined Signal when spatial channels are fully correlated
2.5
2
1.5
1
0.5
0
-0.5
-1
-1.5
-2
-2.5
-2.5 -2 -1.5 -1 -0.5 0 0.5 1 1.5 2 2.5
$(a+i\bar{a})S1 + (a\theta+i\bar{a}\theta)S2$

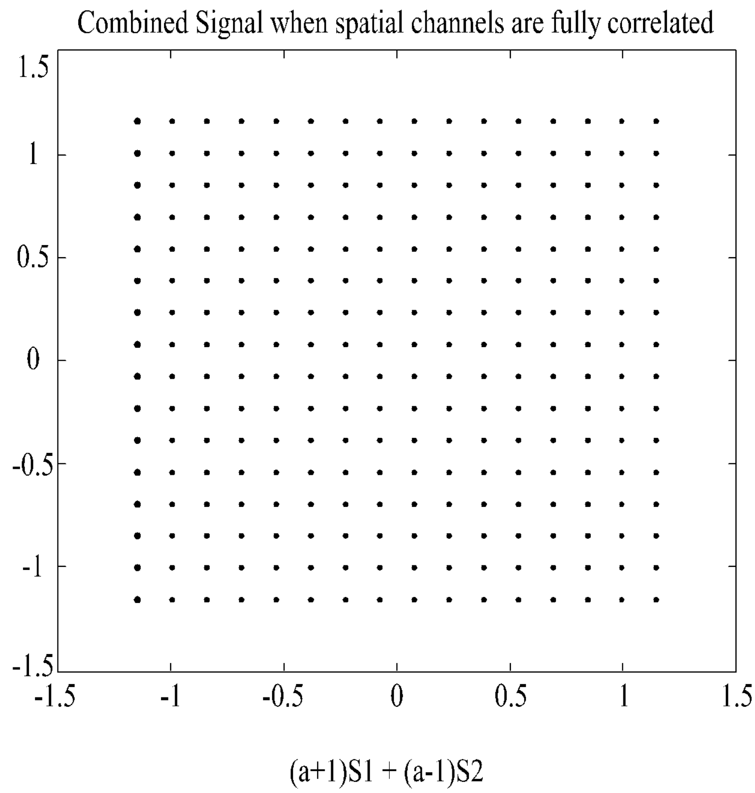
Combined Signal when spatial channels are fully correlated
1.5
1
0.5
0
-0.5
-1
-1.5
-1.5 -1 -0.5 0 0.5 1 1.5
(a+1)S1 + (a-1)S2

FIG. 22

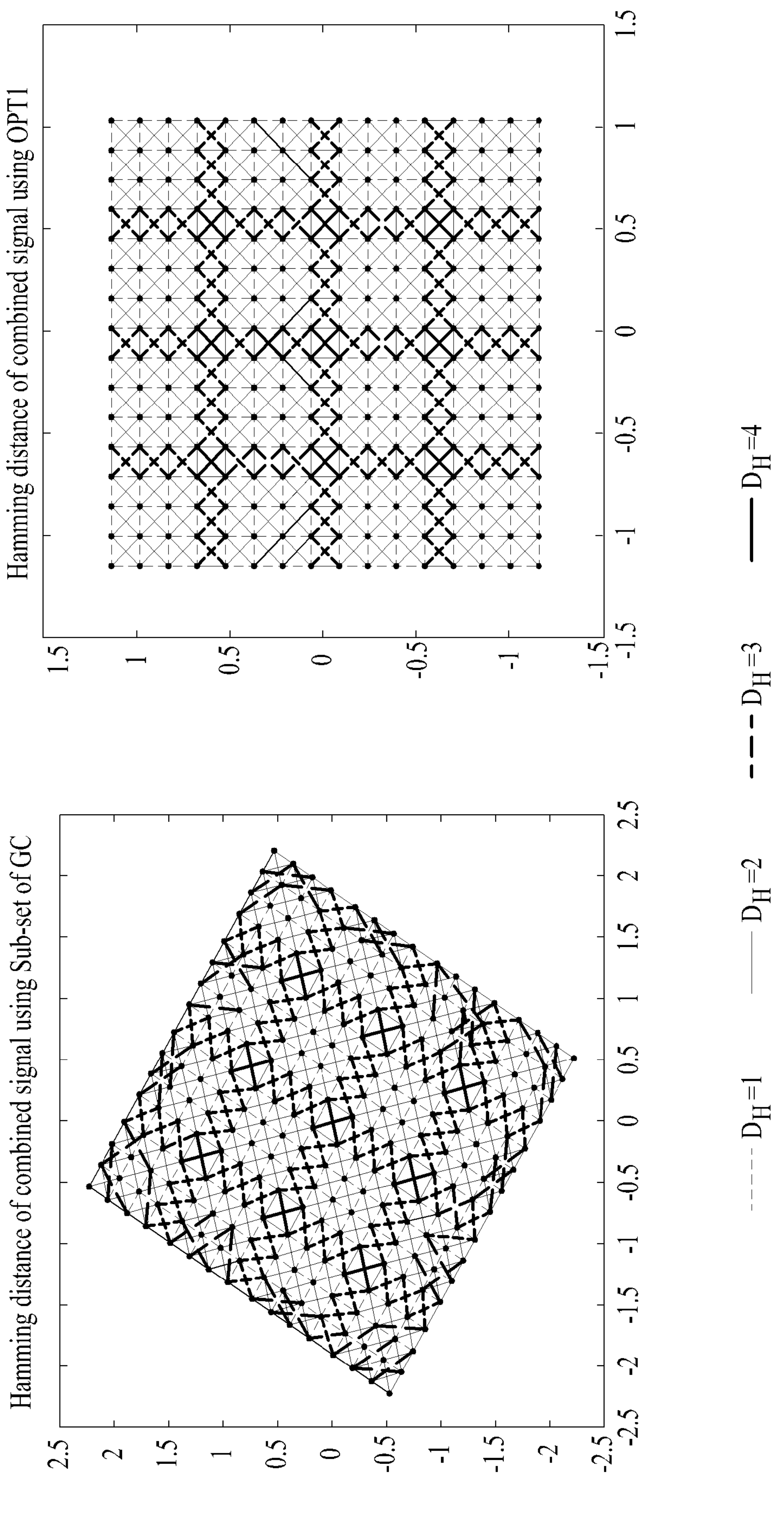
Hamming distance of combined signal using Sub-set of GC
Hamming distance of combined signal using OPT1
$D_H$=1
$D_H$=2
$D_H$=3
$D_H$=4

FIG. 23

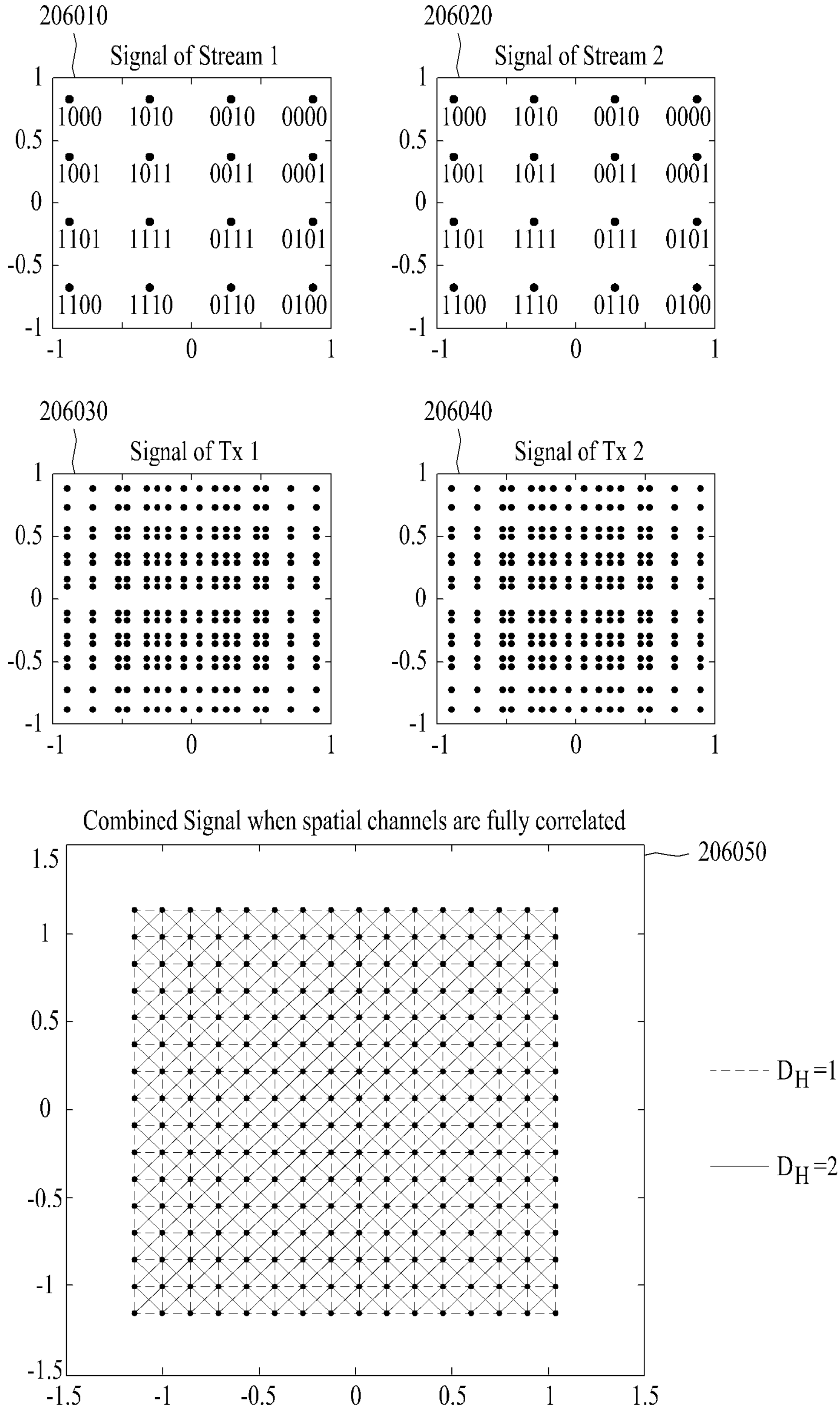
206010
Signal of Stream 1
1000 1010 0010 0000
1001 1011 0011 0001
1101 1111 0111 0101
1100 1110 0110 0100
206020
Signal of Stream 2
1000 1010 0010 0000
1001 1011 0011 0001
1101 1111 0111 0101
1100 1110 0110 0100
206030
Signal of Tx 1
206040
Signal of Tx 2
Combined Signal when spatial channels are fully correlated
206050
$D_H$=1
$D_H$=2

FIG. 24

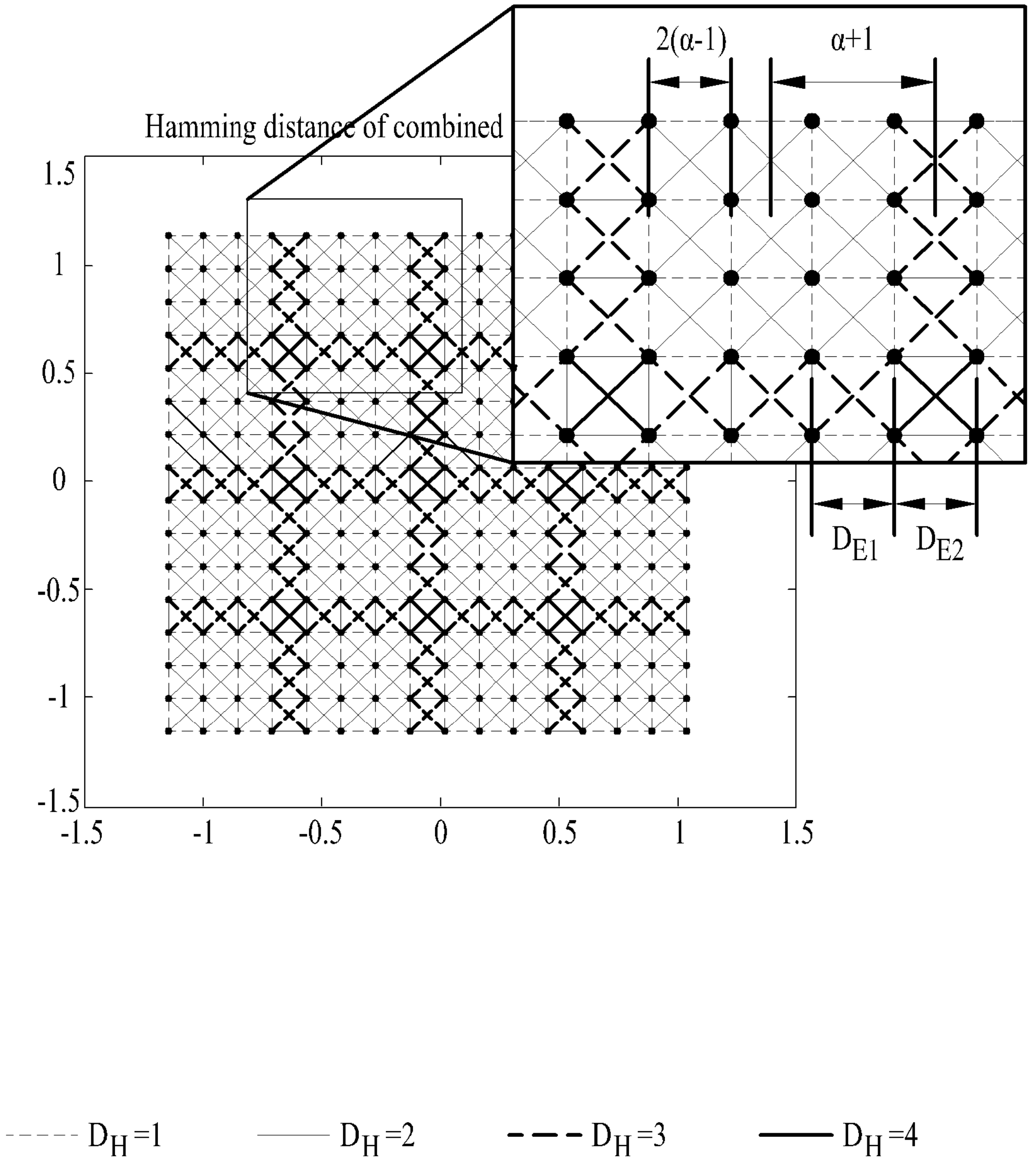
Hamming distance of combined
2(α-1)
α+1
$D_{E1}$
$D_{E2}$
1.5
1
0.5
0
-0.5
-1
-1.5
-1.5
-1
-0.5
0
0.5
1
1.5
$D_H$ =1
$D_H$ =2
$D_H$ =3
$D_H$ =4

FIG. 25

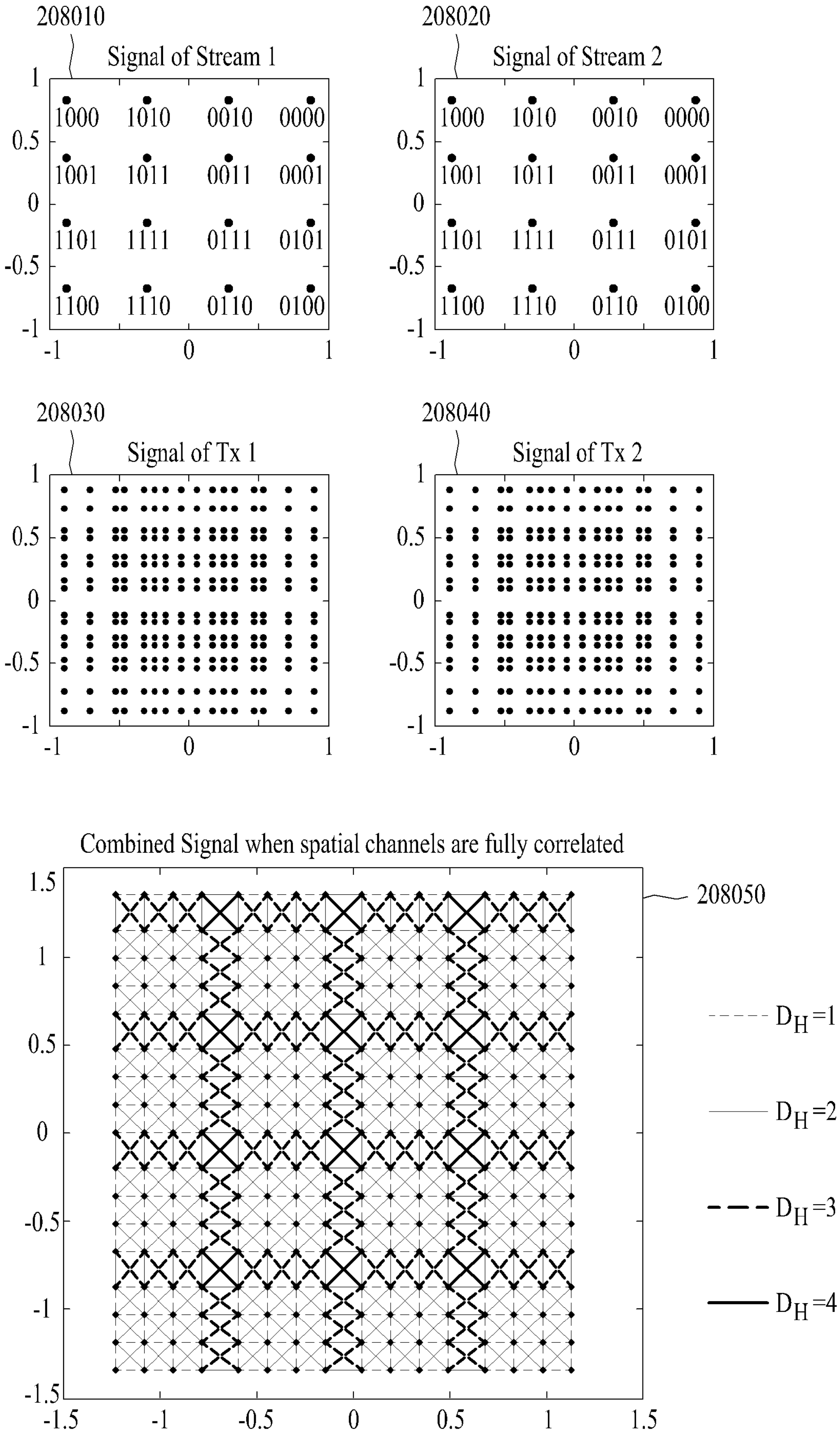
208010
Signal of Stream 1
1000 1010 0010 0000
1001 1011 0011 0001
1101 1111 0111 0101
1100 1110 0110 0100
208020
Signal of Stream 2
1000 1010 0010 0000
1001 1011 0011 0001
1101 1111 0111 0101
1100 1110 0110 0100
208030
Signal of Tx 1
208040
Signal of Tx 2
Combined Signal when spatial channels are fully correlated
208050
$D_H$=1
$D_H$=2
$D_H$=3
$D_H$=4

FIG. 26

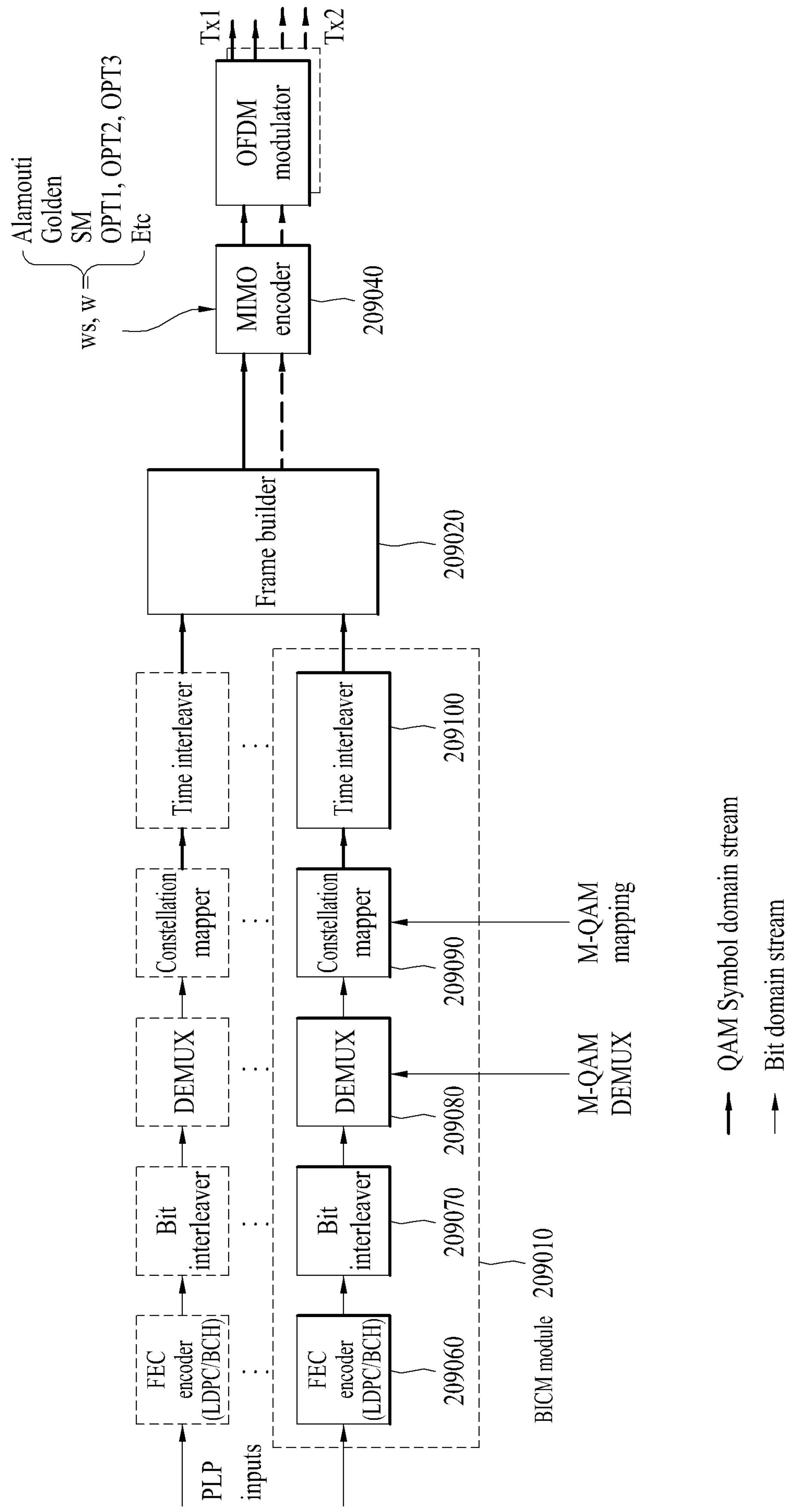
PLP inputs
FEC encoder (LDPC/BCH)
Bit interleaver
DEMUX
Constellation mapper
Time interleaver
Frame builder
MIMO encoder
OFDM modulator
Tx1
Tx2
ws, w =
Alamouti
Golden
SM
OPT1, OPT2, OPT3
Etc
209010
209020
209040
209060
209070
209080
209090
209100
BICM module
M-QAM DEMUX
M-QAM mapping
QAM Symbol domain stream
Bit domain stream

FIG. 27

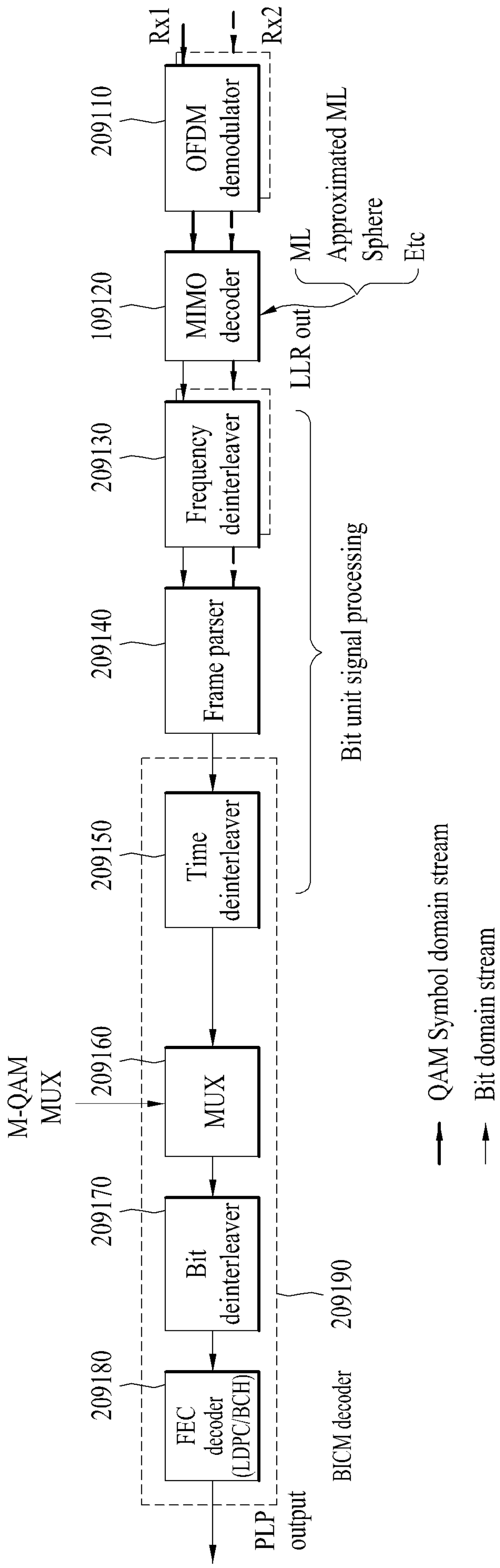
Rx1
Rx2
209110
OFDM demodulator
109120
MIMO decoder
LLR out
ML
Approximated ML
Sphere
Etc
209130
Frequency deinterleaver
209140
Frame parser
Bit unit signal processing
209150
Time deinterleaver
M-QAM MUX
209160
MUX
209170
Bit deinterleaver
209190
209180
FEC decoder (LDPC/BCH)
BICM decoder
PLP output
QAM Symbol domain stream
Bit domain stream

FIG. 28

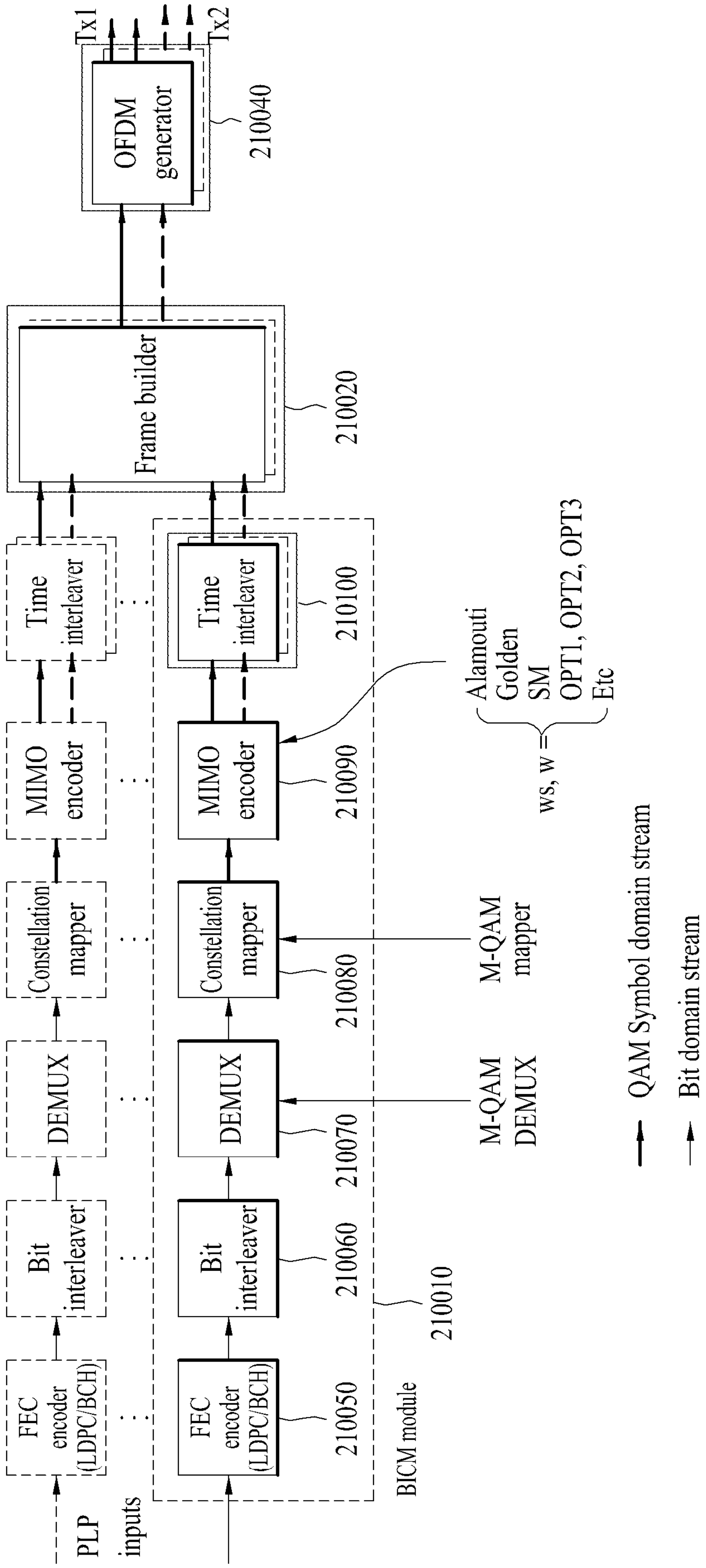

PLP inputs
FEC encoder (LDPC/BCH)
Bit interleaver
DEMUX
Constellation mapper
MIMO encoder
Time interleaver
Frame builder
OFDM generator
Tx1
Tx2
210050
210060
210070
210080
210090
210100
210010
210020
210040
BICM module
M-QAM DEMUX
M-QAM mapper
ws, w =
Alamouti
Golden
SM
OPT1, OPT2, OPT3
Etc
QAM Symbol domain stream
Bit domain stream

FIG. 29

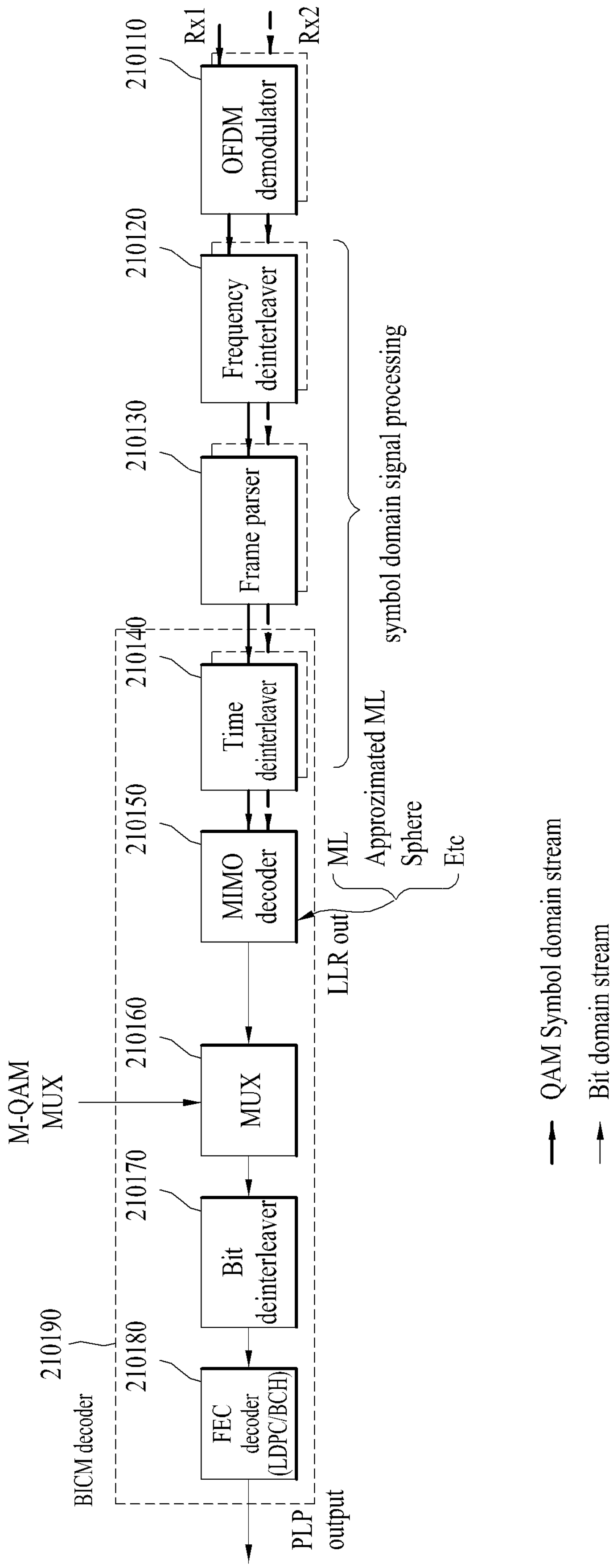
210110
Rx1
Rx2
OFDM demodulator
210120
Frequency deinterleaver
210130
Frame parser
symbol domain signal processing
210140
Time deinterleaver
Approzimated ML
210150
MIMO decoder
ML
Approzimated ML
Sphere
Etc
LLR out
210160
M-QAM MUX
MUX
210170
Bit deinterleaver
210180
FEC decoder (LDPC/BCH)
210190
BICM decoder
PLP output
QAM Symbol domain stream
Bit domain stream

FIG. 30

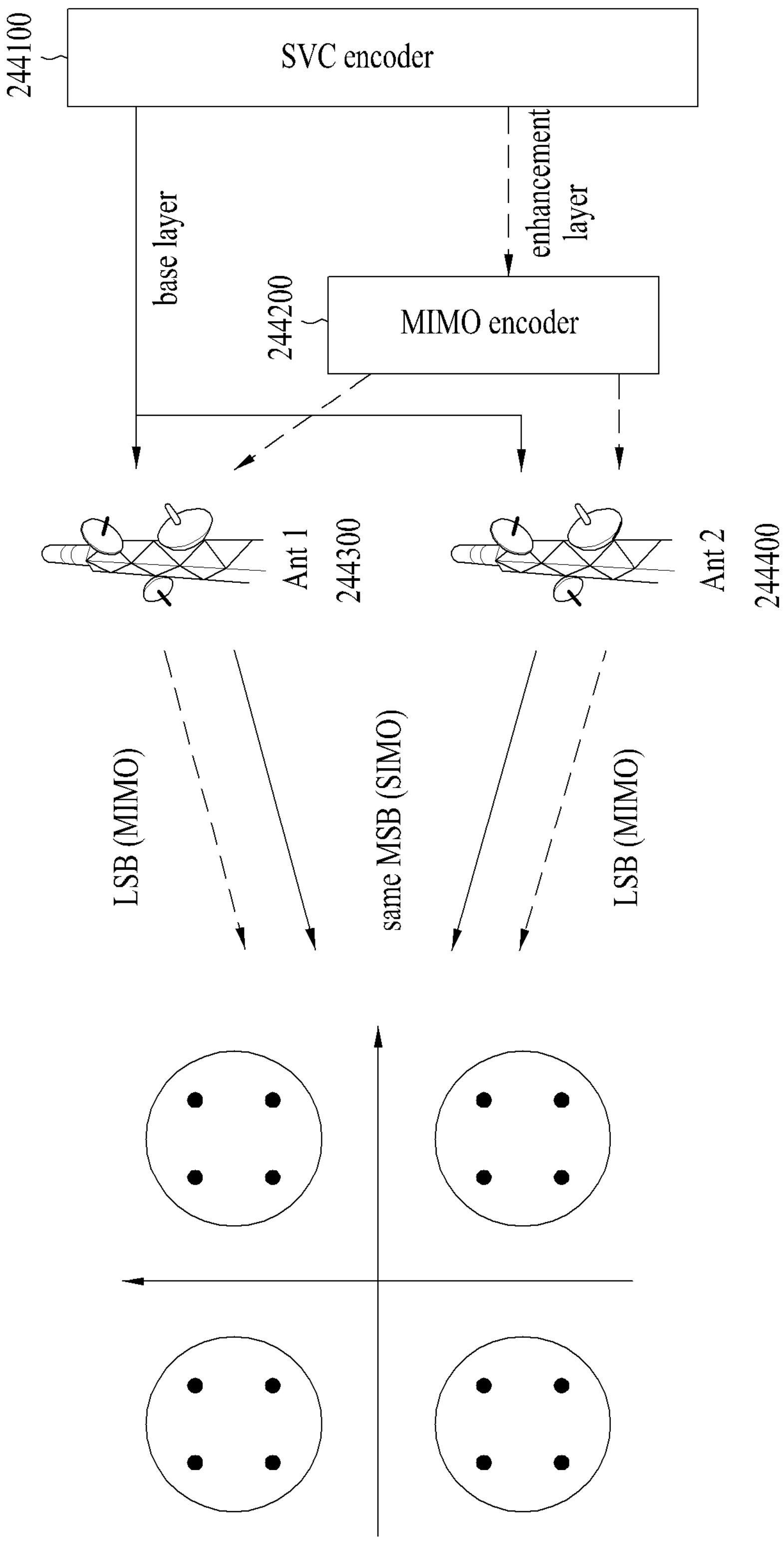
244100
SVC encoder
base layer
enhancement layer
244200
MIMO encoder
Ant 1
244300
Ant 2
244400
LSB (MIMO)
same MSB (SIMO)
LSB (MIMO)

FIG. 31

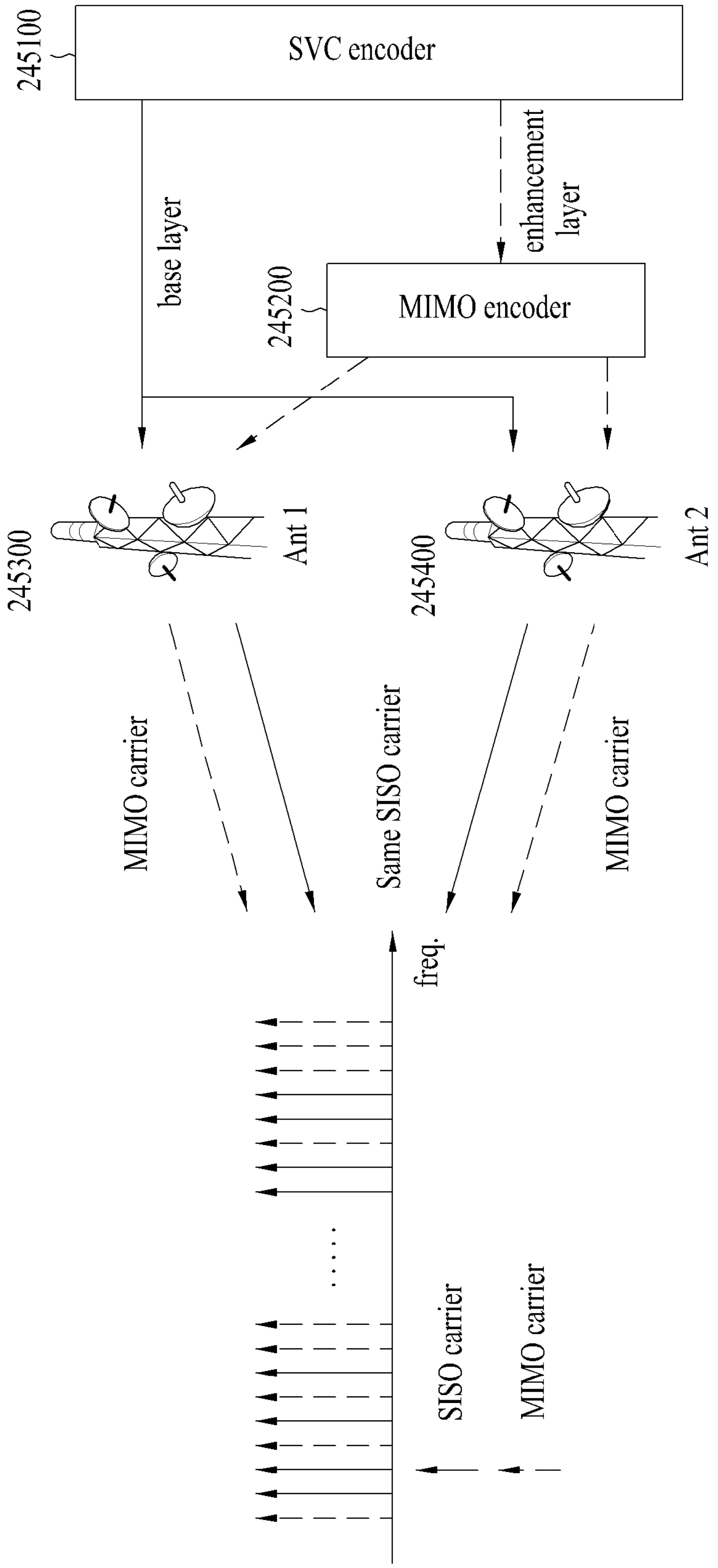
245100
SVC encoder
base layer
enhancement layer
245200
MIMO encoder
245300
Ant 1
245400
Ant 2
MIMO carrier
Same SISO carrier
MIMO carrier
freq.
SISO carrier
MIMO carrier

FIG. 32

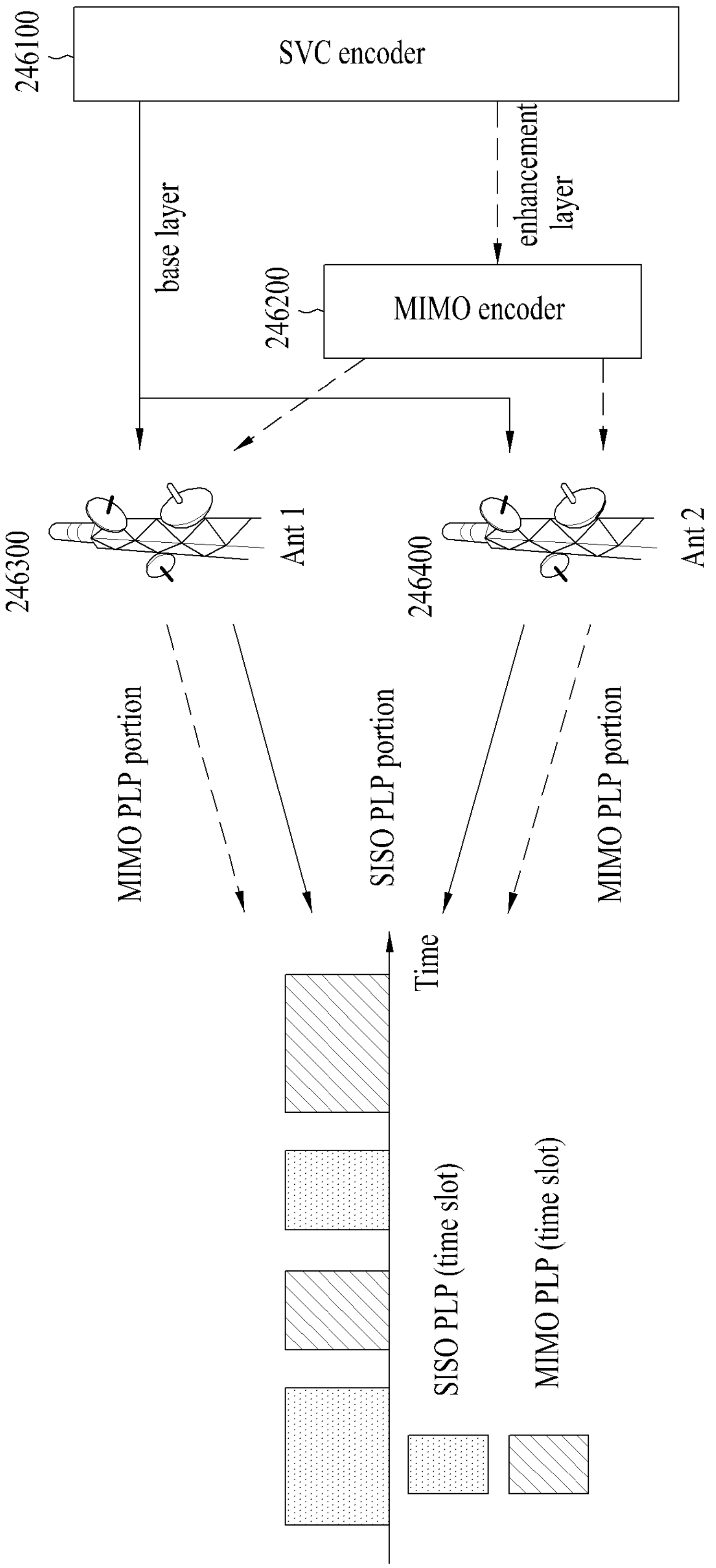
246100
SVC encoder
base layer
enhancement layer
246200
MIMO encoder
246300
Ant 1
246400
Ant 2
MIMO PLP portion
SISO PLP portion
MIMO PLP portion
Time
SISO PLP (time slot)
MIMO PLP (time slot)

FIG. 33

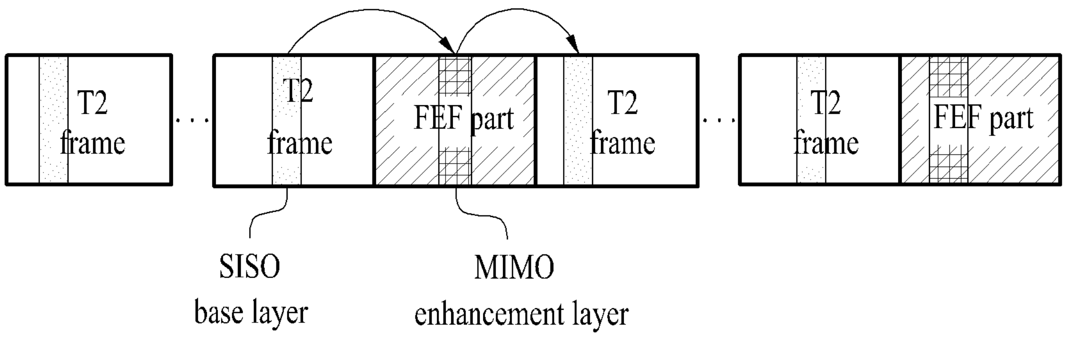


FIG. 34

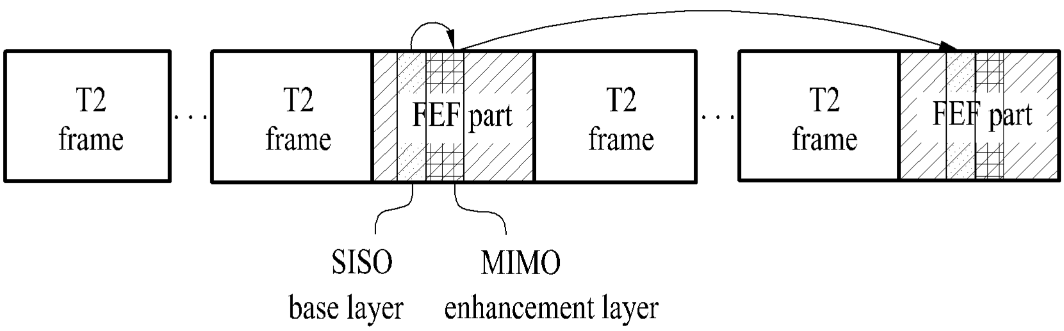


FIG. 35

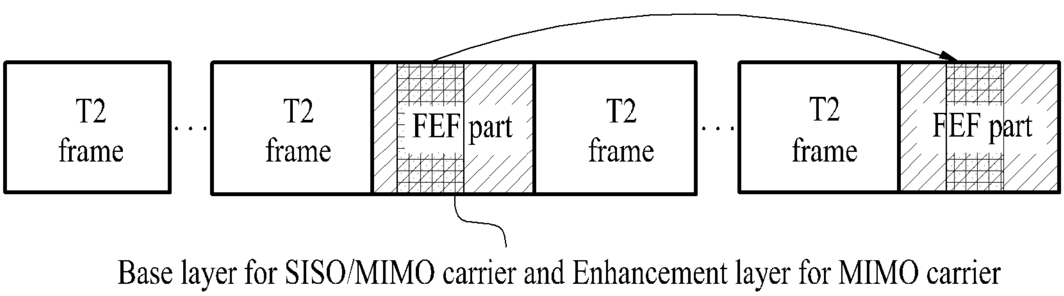

FIG. 36

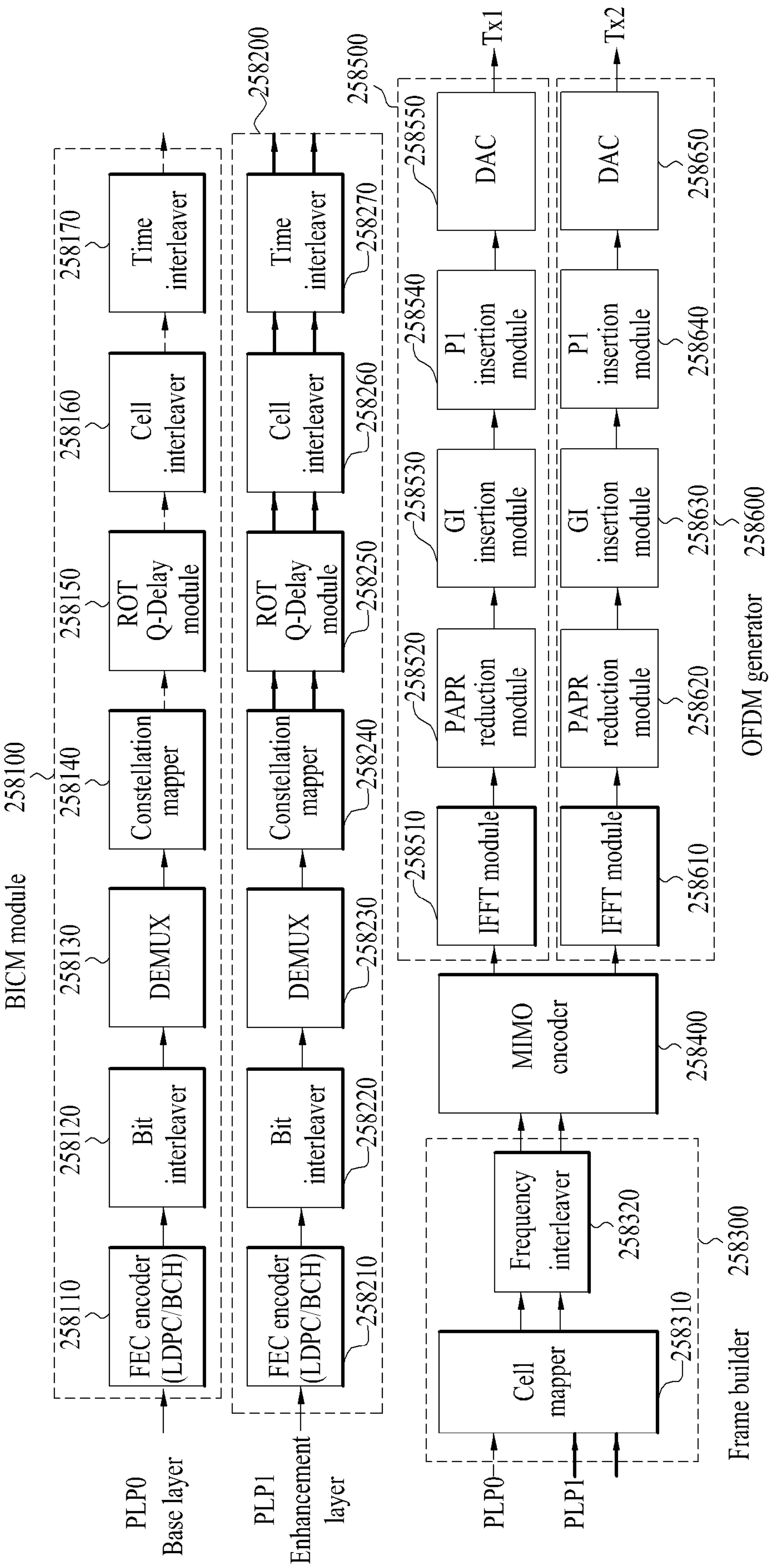
BICM module
258100
PLP0
Base layer
258110
FEC encoder
(LDPC/BCH)
258120
Bit
interleaver
258130
DEMUX
258140
Constellation
mapper
258150
ROT
Q-Delay
module
258160
Cell
interleaver
258170
Time
interleaver
258200
PLP1
Enhancement
layer
258210
FEC encoder
(LDPC/BCH)
258220
Bit
interleaver
258230
DEMUX
258240
Constellation
mapper
258250
ROT
Q-Delay
module
258260
Cell
interleaver
258270
Time
interleaver
PLP0
PLP1
Frame builder
258300
258310
Cell
mapper
258320
Frequency
interleaver
258400
MIMO
encoder
OFDM generator
258500
258510
IFFT module
258520
PAPR
reduction
module
258530
GI
insertion
module
258540
P1
insertion
module
258550
DAC
Tx1
258600
258610
IFFT module
258620
PAPR
reduction
module
258630
GI
insertion
module
258640
P1
insertion
module
258650
DAC
Tx2

FIG. 37

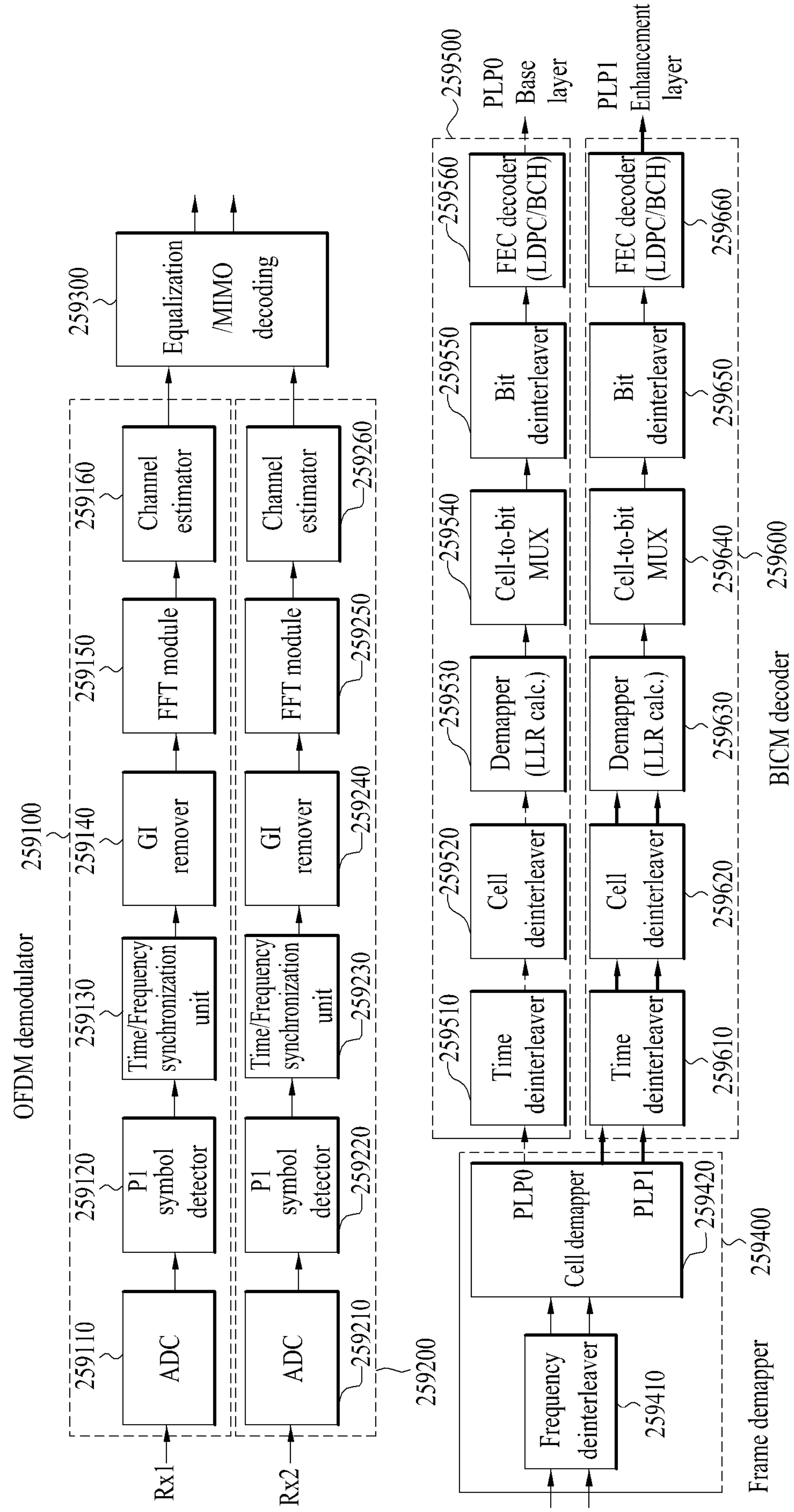
OFDM demodulator
259100
Rx1
Rx2
ADC
259110
259210
P1 symbol detector
259120
259220
Time/Frequency synchronization unit
259130
259230
GI remover
259140
259240
FFT module
259150
259250
Channel estimator
259160
259260
259200
Equalization /MIMO decoding
259300
Frequency deinterleaver
259410
Cell demapper
PLP0
PLP1
259420
259400
Frame demapper
Time deinterleaver
259510
259610
Cell deinterleaver
259520
259620
Demapper (LLR calc.)
259530
259630
Cell-to-bit MUX
259540
259640
Bit deinterleaver
259550
259650
FEC decoder (LDPC/BCH)
259560
259660
259500
259600
BICM decoder
PLP0 Base layer
PLP1 Enhancement layer

FIG. 38

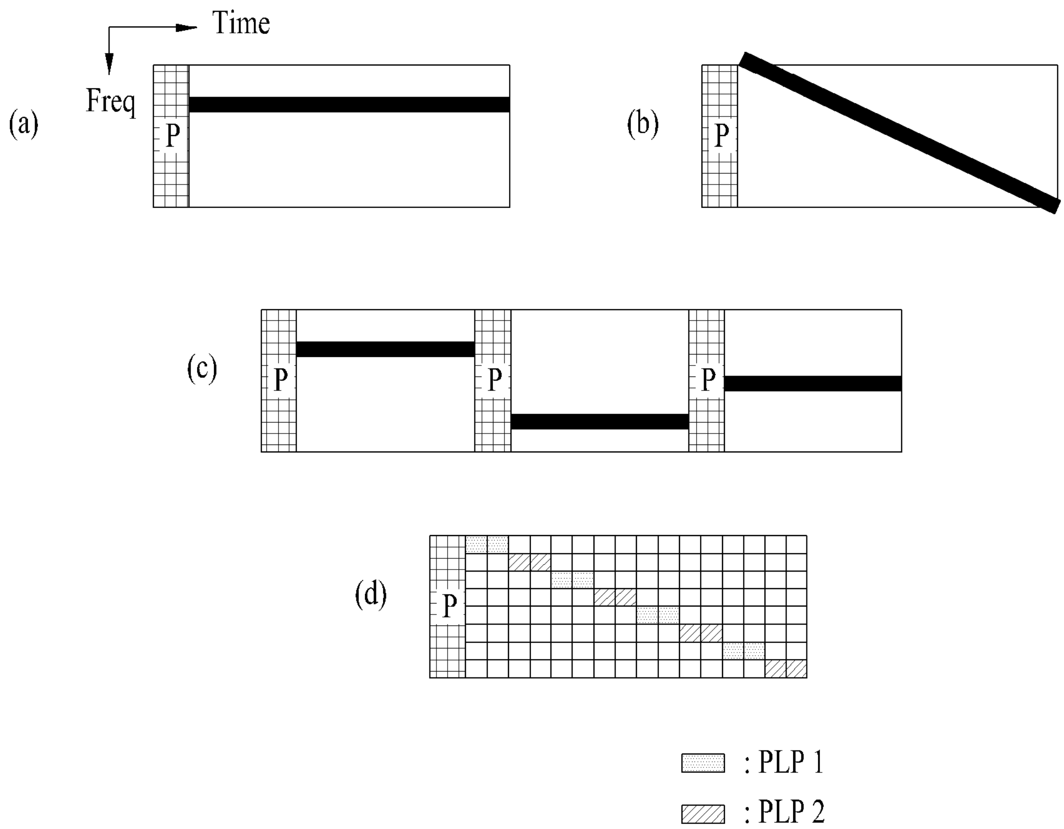


FIG. 39

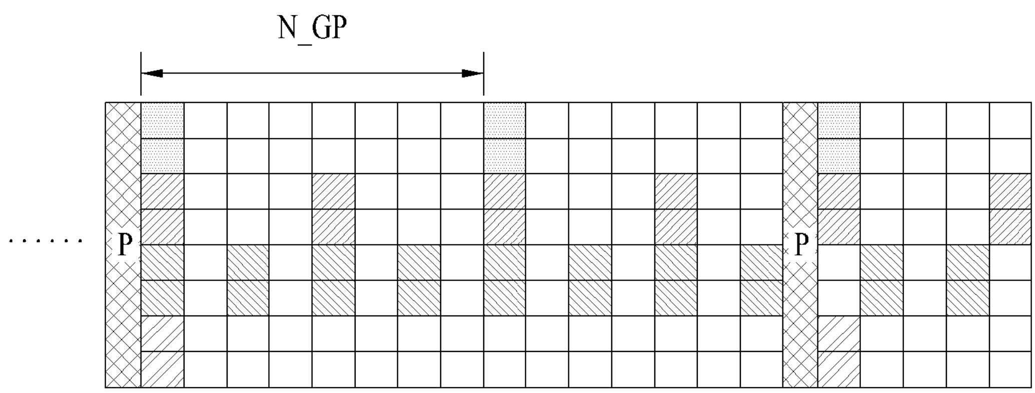

FIG. 40

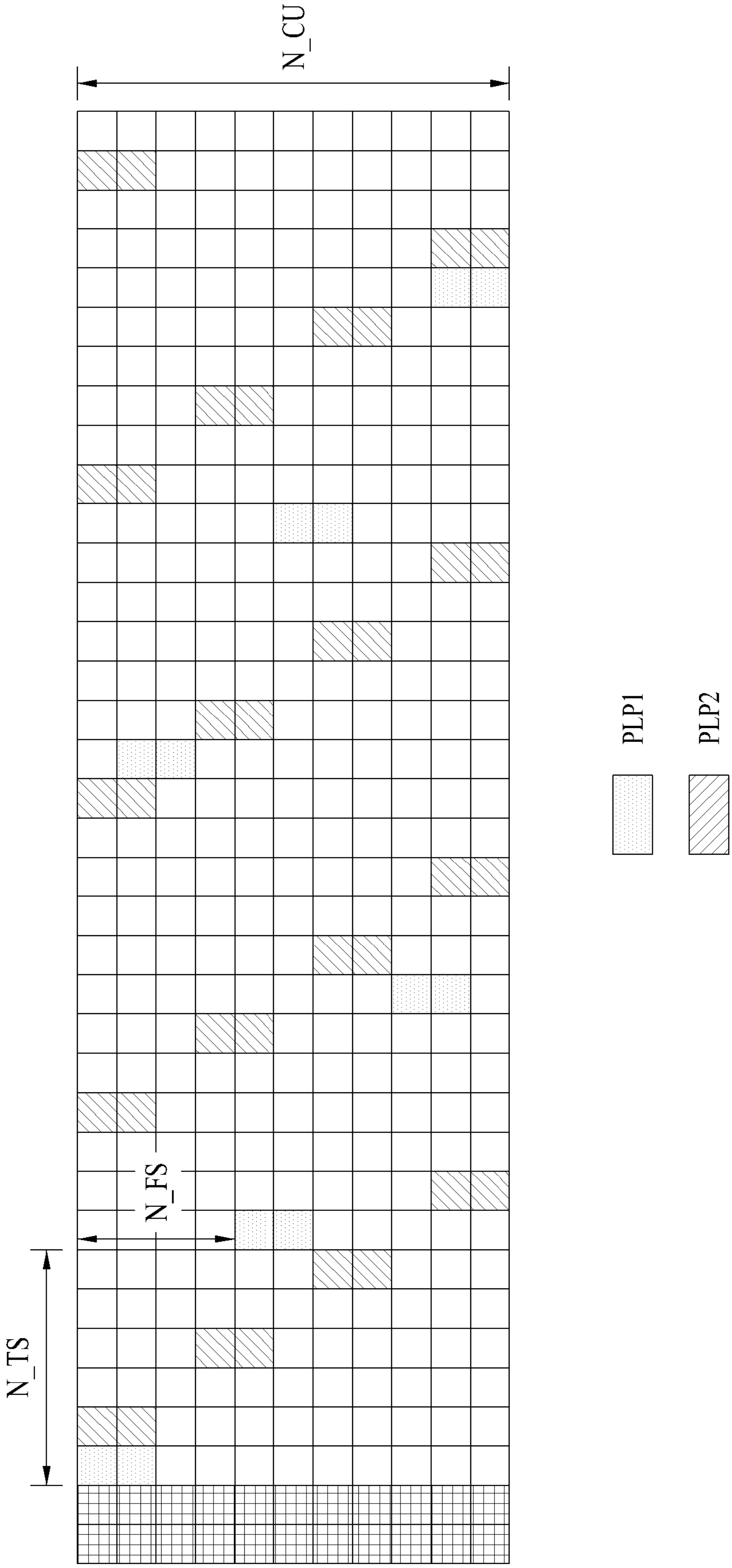

FIG. 41

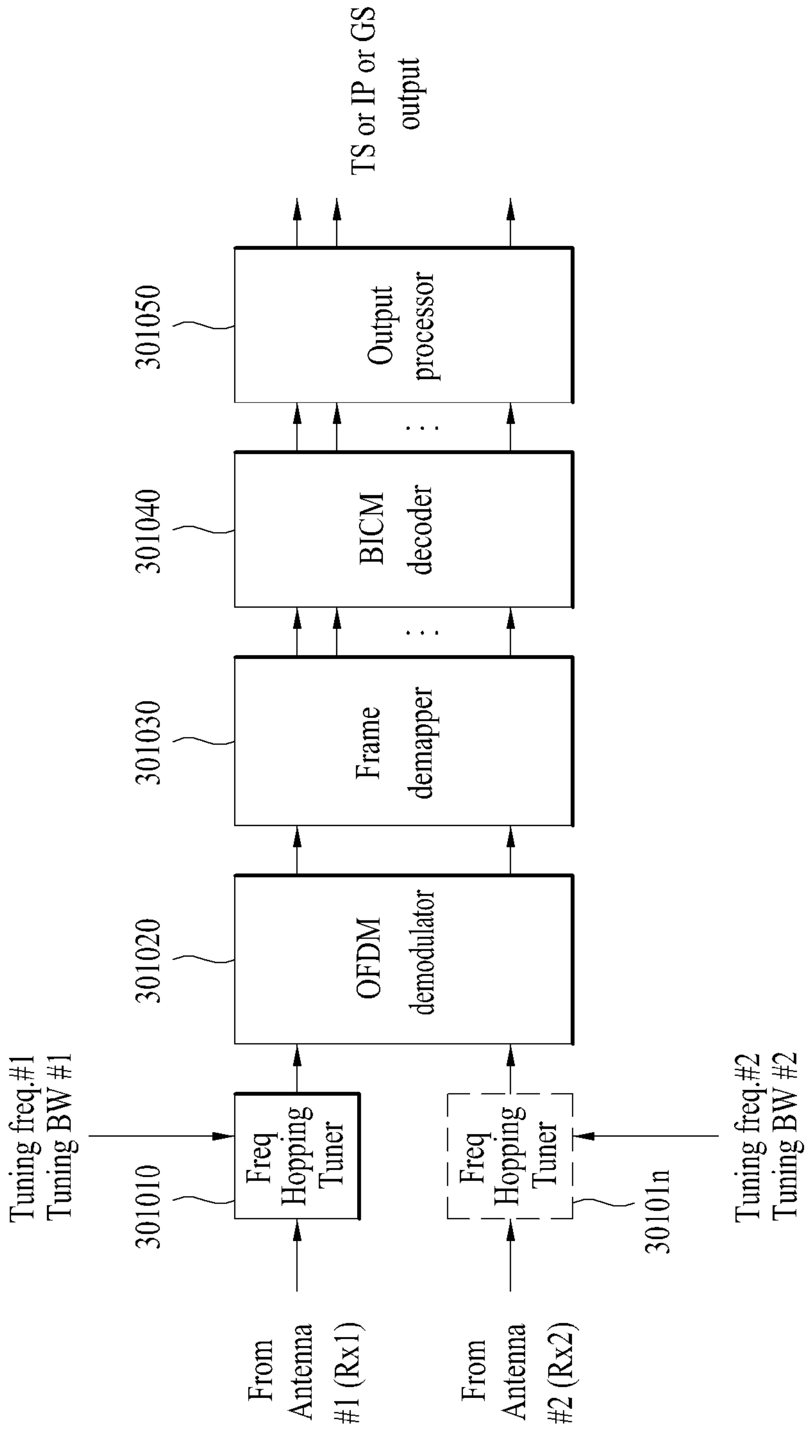
TS or IP or GS output
301050
Output processor
301040
BICM decoder
301030
Frame demapper
301020
OFDM demodulator
Tuning freq.#1
Tuning BW #1
301010
Freq Hopping Tuner
Freq Hopping Tuner
30101n
Tuning freq.#2
Tuning BW #2
From Antenna #1 (Rx1)
From Antenna #2 (Rx2)

FIG. 42

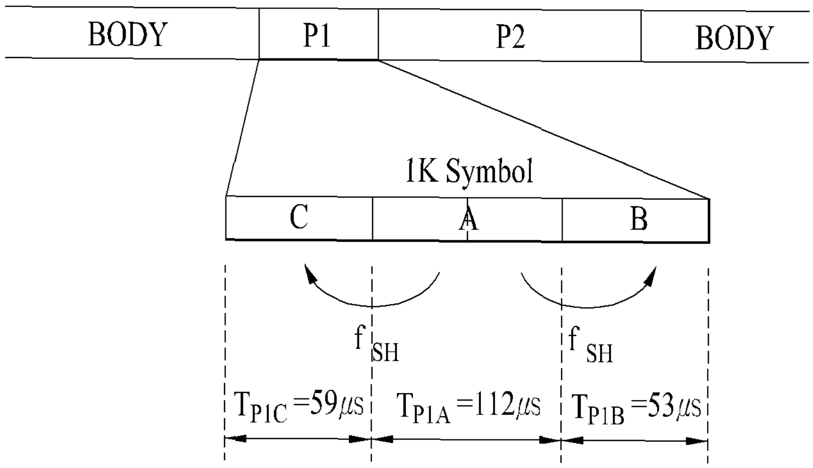
BODY
P1
P2
BODY
1K Symbol
C
A
B
f SH
f SH
TP1C =59μs
TP1A =112μs
TP1B =53μs

(a)

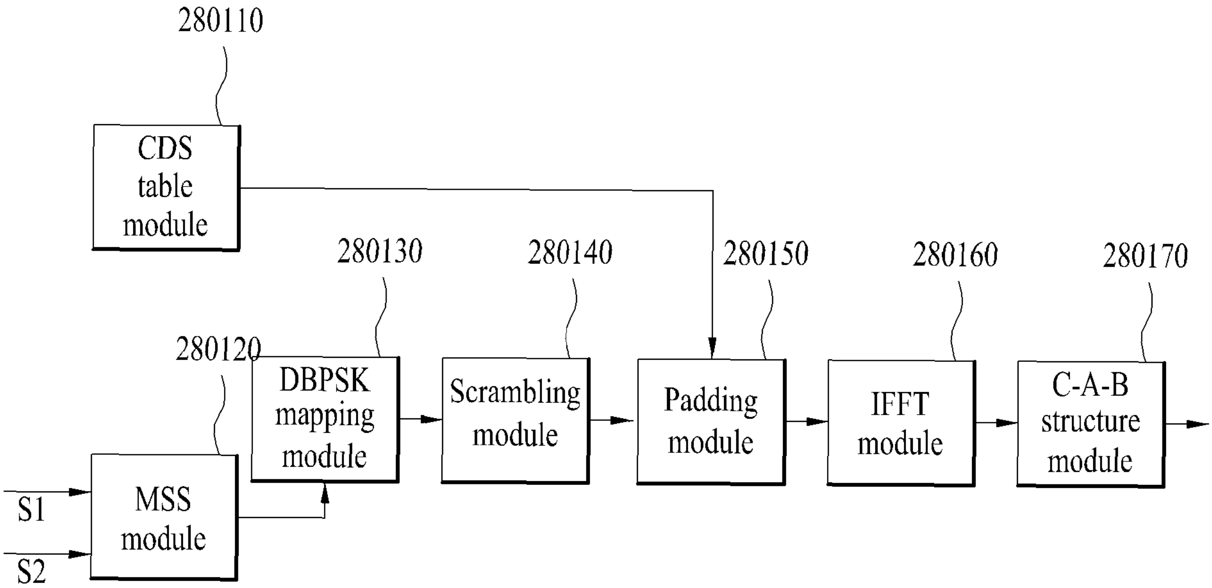
280110
CDS table module
280130
280140
280150
280160
280170
280120
DBPSK mapping module
Scrambling module
Padding module
IFFT module
C-A-B structure module
S1
S2
MSS module

(b)

FIG. 43

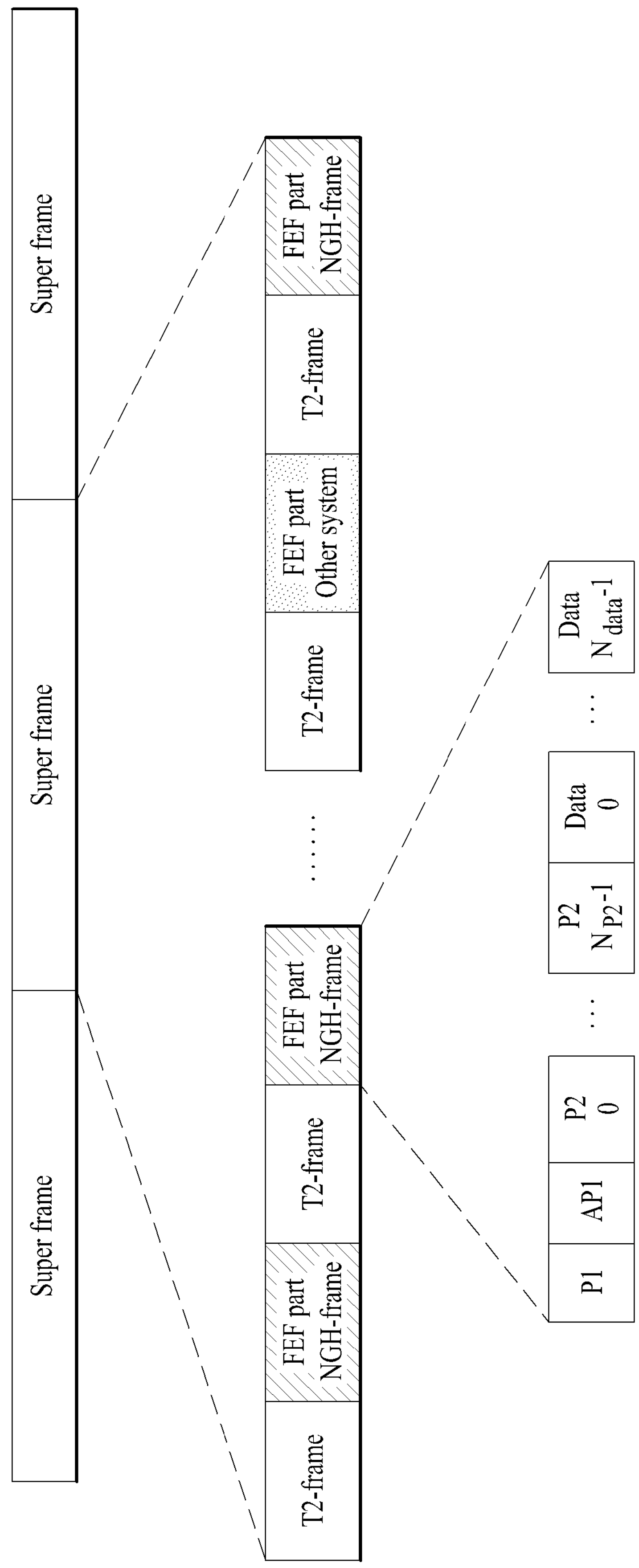
Super frame
Super frame
Super frame
T2-frame
FEF part
NGH-frame
T2-frame
FEF part
NGH-frame
......
T2-frame
FEF part
Other system
T2-frame
FEF part
NGH-frame
P1
AP1
P2
0
...
P2
$N_{P2}$-1
Data
0
...
Data
$N_{data}$-1

FIG. 44

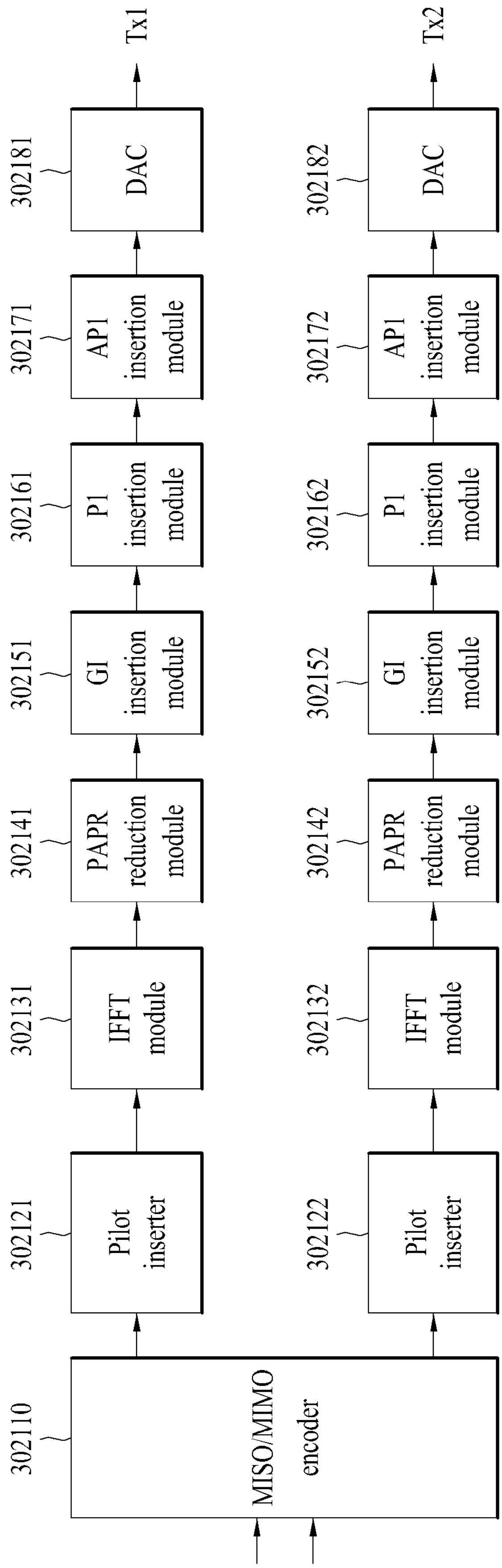
302110
MISO/MIMO encoder
302121
Pilot inserter
302131
IFFT module
302141
PAPR reduction module
302151
GI insertion module
302161
P1 insertion module
302171
AP1 insertion module
302181
DAC
Tx1
302122
Pilot inserter
302132
IFFT module
302142
PAPR reduction module
302152
GI insertion module
302162
P1 insertion module
302172
AP1 insertion module
302182
DAC
Tx2

FIG. 45

| Pilot Pattern | Dx | Dy |
|---|---|---|
| pp1 | 6 | 4 |
| pp2 | 12 | 2 |
| pp3 | 12 | 4 |
| pp4 | 24 | 2 |
| pp5 | 24 | 4 |
| pp6 | 48 | 2 |
| pp7 | 24 | 4 |
| pp8 | 12 | 16 |
| pp9 | 6 | 2 |

FIG. 46

| FFT | 1/128 | Dx | Dy | 1/32 | Dx | Dy | 1/16 | Dx | Dy | 19/256 | Dx | Dy | 1/8 | Dx | Dy | 19/128 | Dx | Dy | 1/4 | Dx | Dy |
|---|---|---|---|---|---|---|---|---|---|---|---|---|---|---|---|---|---|---|---|---|---|
| 32K | PP8 | 12 | 16 | PP8 | 12 | 16 | PP2 | 12 | 2 | PP2 | 12 | 2 | | | | | | | | | |
| | PP4 | 24 | 2 | PP4 | 24 | 2 | PP8 | 12 | 16 | PP8 | 12 | 16 | | | | | | | | | |
| | PP6 | 48 | 2 | | | | | | | | | | | | | | | | | | |
| 16K | PP4 | 24 | 2 | PP2 | 12 | 2 | PP2 | 12 | 2 | PP2 | 12 | 2 | PP1 | 6 | 4 | PP1 | 6 | 4 | | | |
| | PP5 | 24 | 4 | PP4 | 24 | 2 | PP3 | 12 | 4 | PP3 | 12 | 4 | PP9 | 6 | 2 | PP9 | 6 | 2 | | | |
| | | | | PP5 | 24 | 4 | PP9 | 6 | 2 | PP9 | 6 | 2 | | | | | | | | | |
| 8K | PP4 | 24 | 2 | PP2 | 12 | 2 | PP3 | 12 | 4 | PP3 | 12 | 4 | PP1 | 6 | 4 | PP1 | 6 | 4 | | | |
| | PP5 | 24 | 4 | PP4 | 24 | 2 | PP2 | 12 | 2 | PP2 | 12 | 2 | PP9 | 6 | 2 | PP9 | 6 | 2 | | | |
| | | | | PP5 | 24 | 4 | | | | | | | | | | | | | | | |
| 4K | | | | PP2 | 12 | 2 | PP3 | 12 | 4 | | | | PP1 | 6 | 4 | | | | | | |
| | | | | PP4 | 24 | 2 | PP2 | 12 | 2 | | | | PP9 | 6 | 2 | | | | | | |
| | | | | PP5 | 24 | 4 | | | | | | | | | | | | | | | |
| 2K | | | | PP2 | 12 | 2 | PP3 | 12 | 4 | | | | PP1 | 6 | 4 | | | | | | |
| | | | | PP4 | 24 | 2 | PP2 | 12 | 2 | | | | PP9 | 6 | 2 | | | | | | |
| | | | | PP5 | 24 | 4 | | | | | | | | | | | | | | | |
| 1K | | | | | | | PP3 | 12 | 4 | | | | PP1 | 6 | 4 | | | | | | |
| | | | | | | | PP2 | 12 | 2 | | | | PP9 | 6 | 2 | | | | | | |

FIG. 47

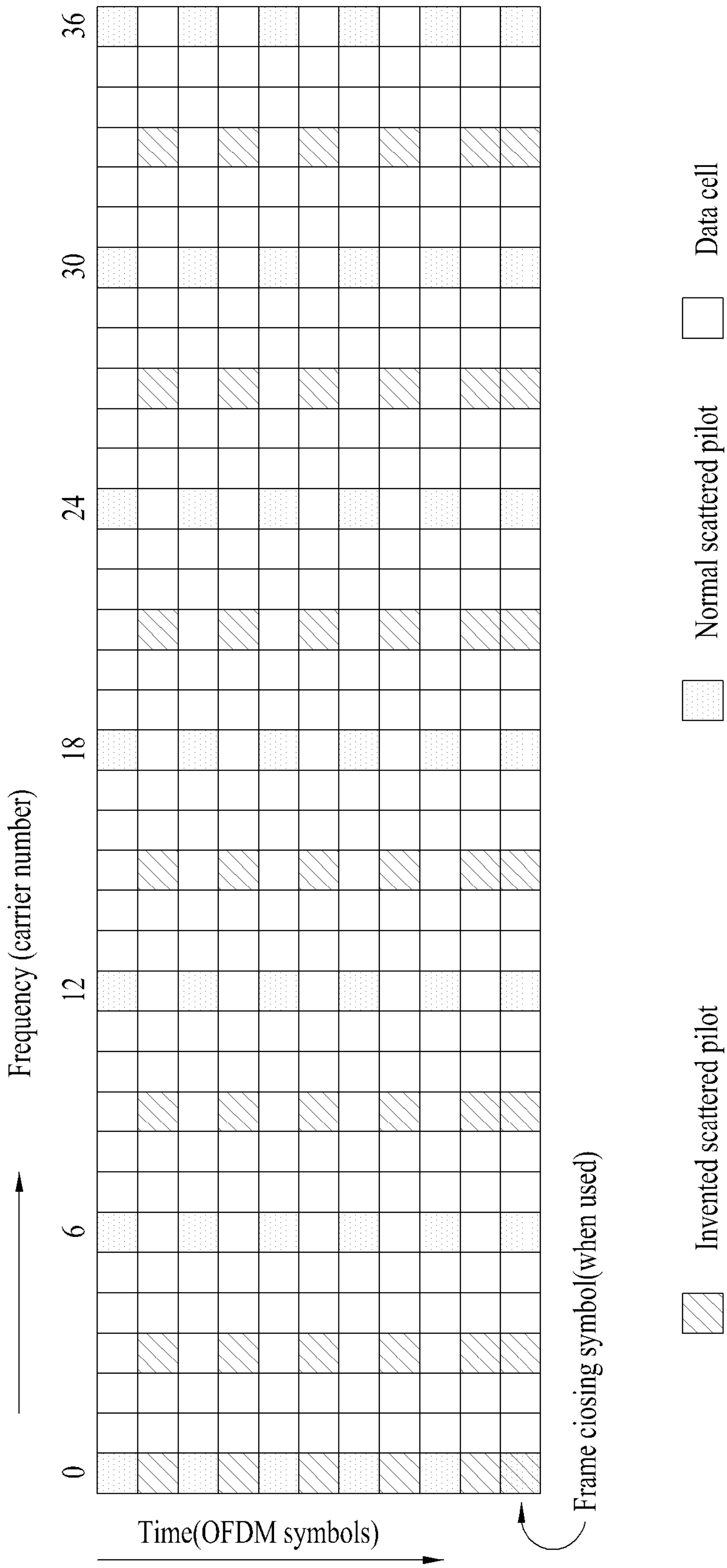
Frequency (carrier number)
0
6
12
18
24
30
36
Time(OFDM symbols)
Frame ciosing symbol(when used)
Invented scattered pilot
Normal scattered pilot
Data cell

FIG. 48

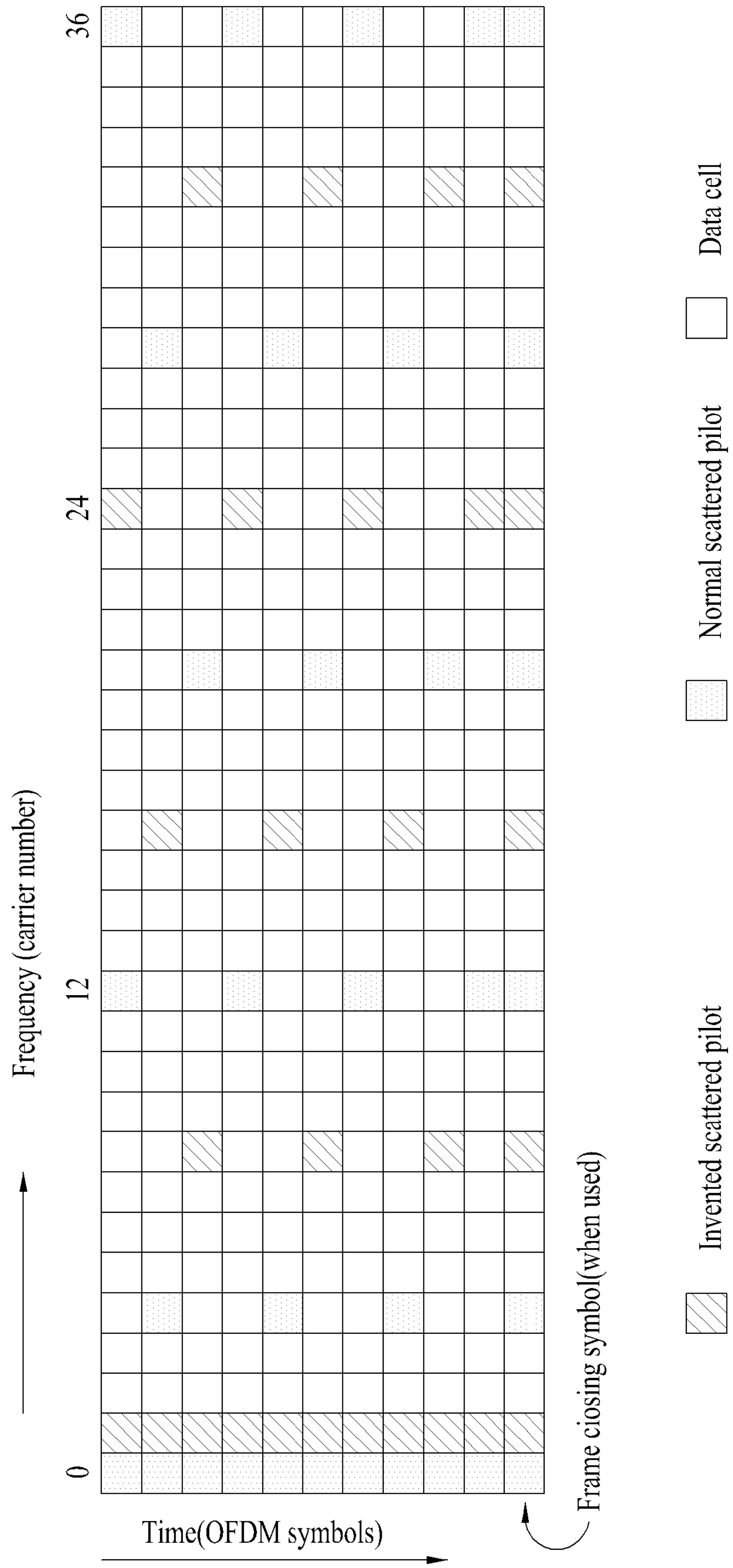
Frequency (carrier number)
0
12
24
36
Time(OFDM symbols)
Frame ciosing symbol(when used)
Invented scattered pilot
Normal scattered pilot
Data cell

FIG. 49

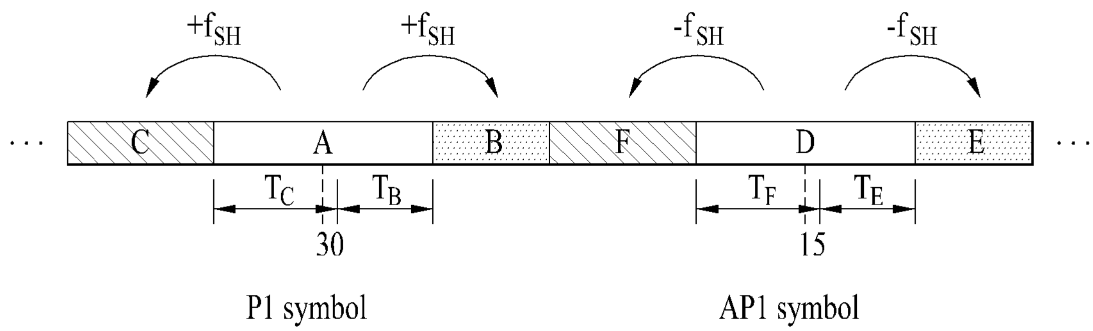

FIG. 50

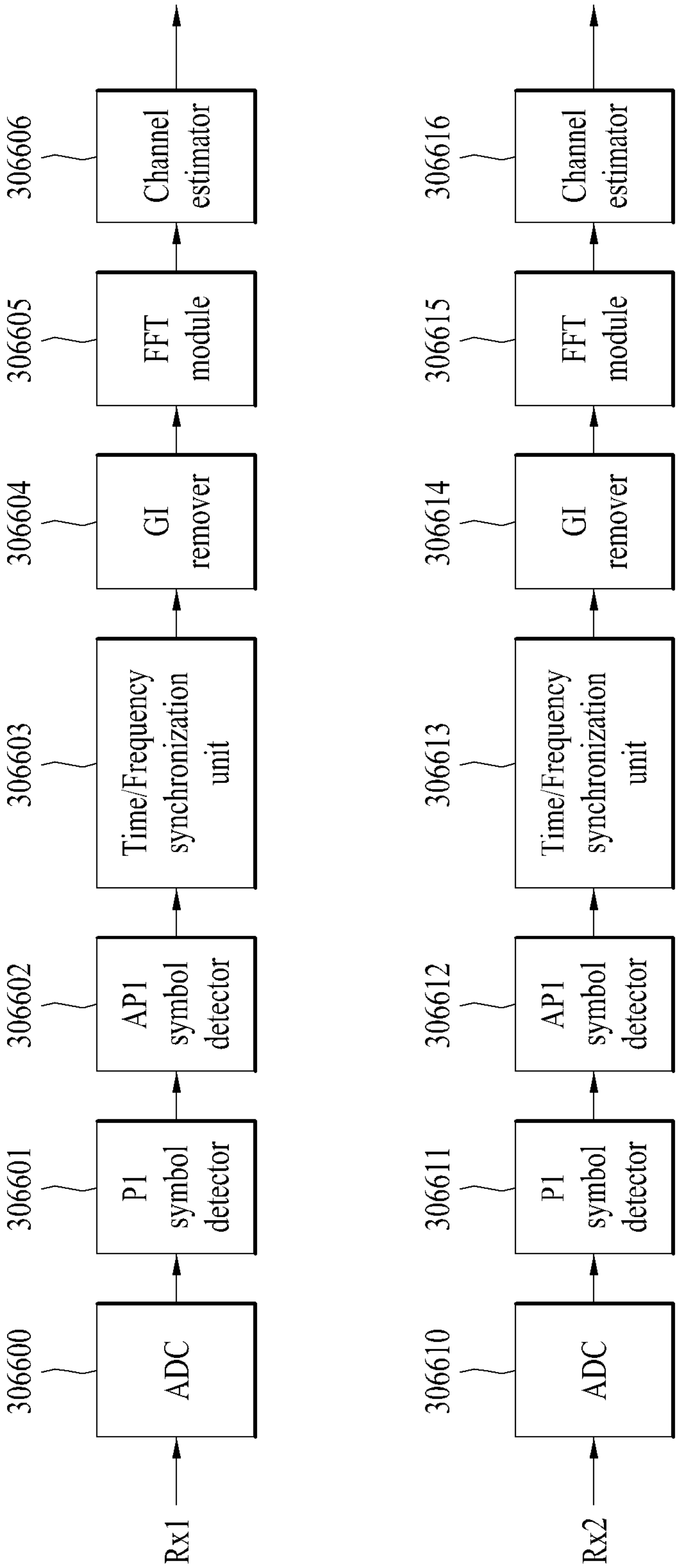
Rx1
306600
ADC
306601
P1 symbol detector
306602
AP1 symbol detector
306603
Time/Frequency synchronization unit
306604
GI remover
306605
FFT module
306606
Channel estimator
Rx2
306610
ADC
306611
P1 symbol detector
306612
AP1 symbol detector
306613
Time/Frequency synchronization unit
306614
GI remover
306615
FFT module
306616
Channel estimator

FIG. 51

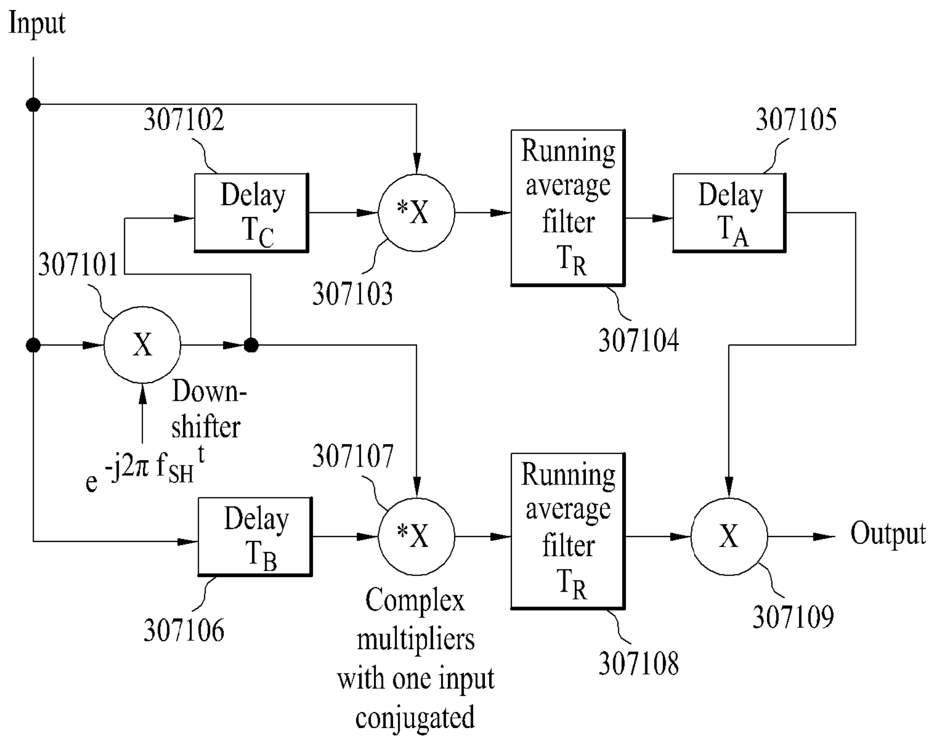
Input
307102
Delay $T_C$
*X
Running average filter $T_R$
307105
Delay $T_A$
307101
307103
307104
X
Down-shifter
$e^{-j2\pi f_{SH} t}$
307107
Delay $T_B$
*X
Running average filter $T_R$
X
Output
307106
Complex multipliers with one input conjugated
307108
307109

FIG. 52

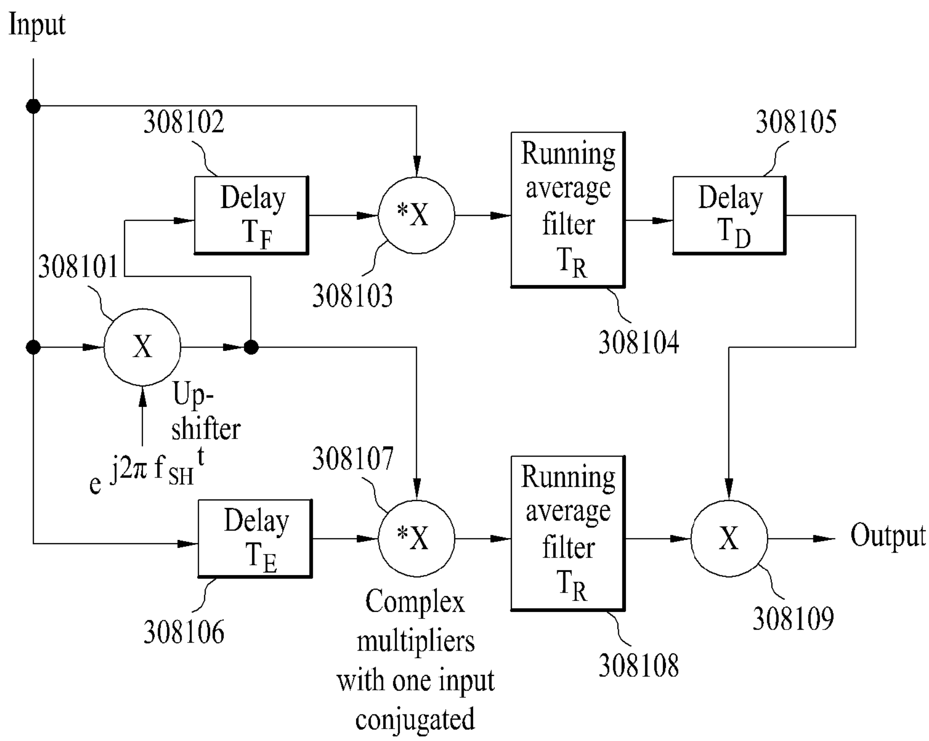
Input
308102
Delay $T_F$
*X
Running average filter $T_R$
308105
Delay $T_D$
308101
308103
308104
X
Up-shifter
$e^{j2\pi f_{SH} t}$
308107
Delay $T_E$
*X
Running average filter $T_R$
X
Output
308106
Complex multipliers with one input conjugated
308108
308109

FIG. 53

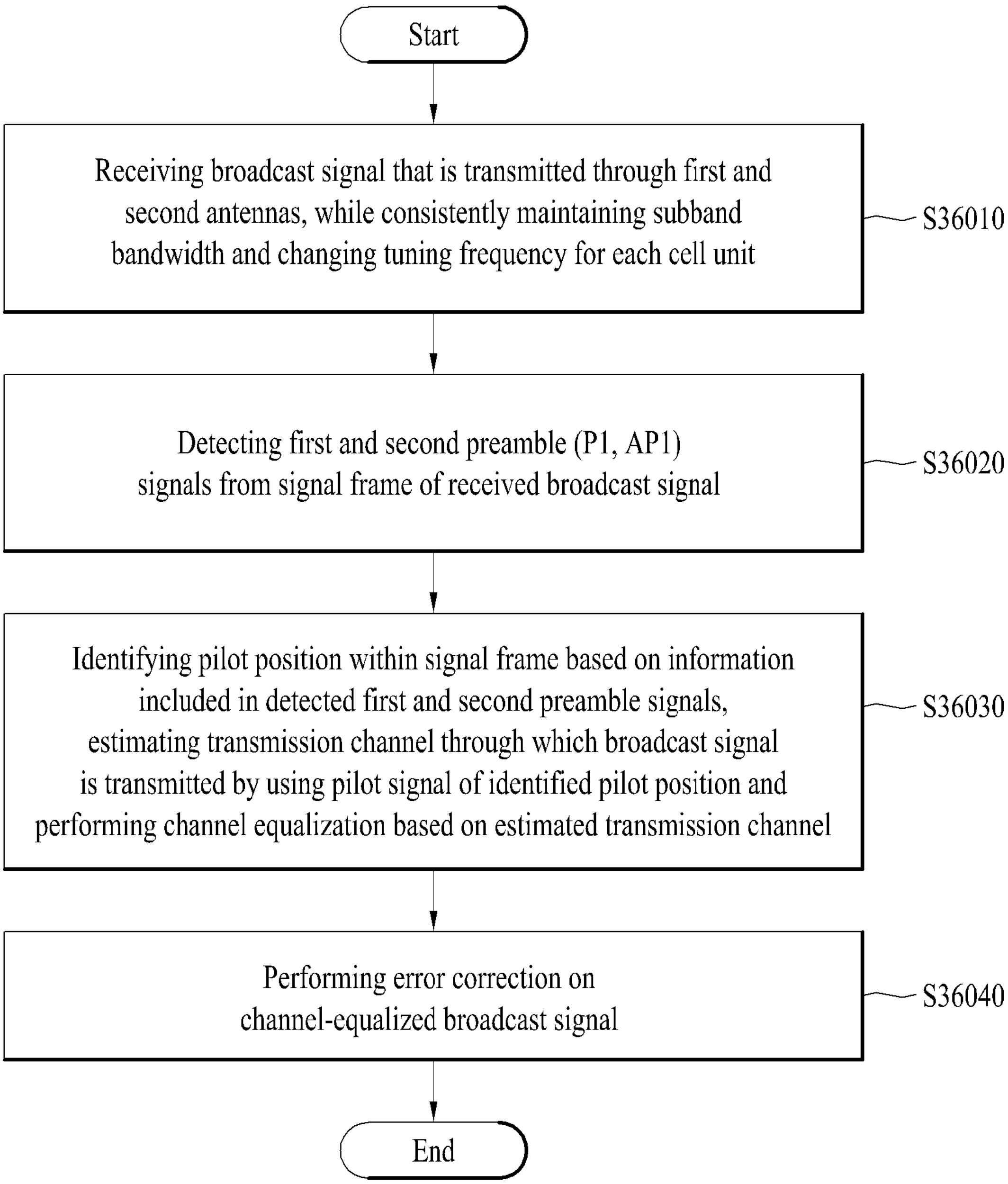
Start
Receiving broadcast signal that is transmitted through first and second antennas, while consistently maintaining subband bandwidth and changing tuning frequency for each cell unit
S36010
Detecting first and second preamble (P1, AP1) signals from signal frame of received broadcast signal
S36020
Identifying pilot position within signal frame based on information included in detected first and second preamble signals, estimating transmission channel through which broadcast signal is transmitted by using pilot signal of identified pilot position and performing channel equalization based on estimated transmission channel
S36030
Performing error correction on channel-equalized broadcast signal
S36040
End

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2487901 A
- EP 2533526 A
- EP 2071791 A
- US 2005068918 A